(19) Europäisches Patentamt
European Patent Office
Office européen des brevets

(11) EP 4 016 992 A2

(12) EUROPEAN PATENT APPLICATION

(43) Date of publication:
**22.06.2022 Bulletin 2022/25**

(21) Application number: **21216849.6**

(22) Date of filing: **11.07.2017**

(51) International Patent Classification (IPC):
***H04N 5/369*** *(2011.01)* ***G02B 5/00*** *(2006.01)*
***H01L 27/146*** *(2006.01)* ***H04N 5/225*** *(2006.01)*
***H04N 5/232*** *(2006.01)* ***H04N 5/374*** *(2011.01)*
***H04N 5/378*** *(2011.01)* ***H04N 9/07*** *(2006.01)*

(52) Cooperative Patent Classification (CPC):
**H04N 5/3696; G02B 5/00; H01L 27/146; H04N 5/225; H04N 5/232**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.07.2016 JP 2016138363**

(62) Document number(s) of the earlier application(s) in accordance with Art. 76 EPC:
**17827619.2 / 3 487 165**

(71) Applicant: **Sony Group Corporation**
**Tokyo 108-0075 (JP)**

(72) Inventor: **MIYATANI, Yoshitaka**
**Tokyo, 108-0075 (JP)**

(74) Representative: **D Young & Co LLP**
**120 Holborn**
**London EC1N 2DY (GB)**

Remarks:
This application was filed on 22-12-2021 as a divisional application to the application mentioned under INID code 62.

# (54) IMAGING APPARATUS, IMAGING DEVICE, AND IMAGE PROCESSING APPARATUS

(57) The present disclosure relates to an imaging apparatus, an imaging device, and an image processing apparatus that make it possible to provide diversity to individual pixels in the case where an imaging lens is not used.

A detection image detected by reception of incident light is imaged by a plurality of pixels having incident angle directivities different from each other in response to incident angles of incident light from an object plane including an object, and a restoration image in which an image of a figure of the object plane is formed by arithmetic operation using the detection image and a coefficient set that is set in response to a distance to the object plane is generated by signal processing. Since a restoration image is generated by arithmetic operation using the same detection image and the coefficient set according to the distance to the object plane, diversity can be provided to individual pixels. The present disclosure can be applied to an imaging apparatus.

FIG.9

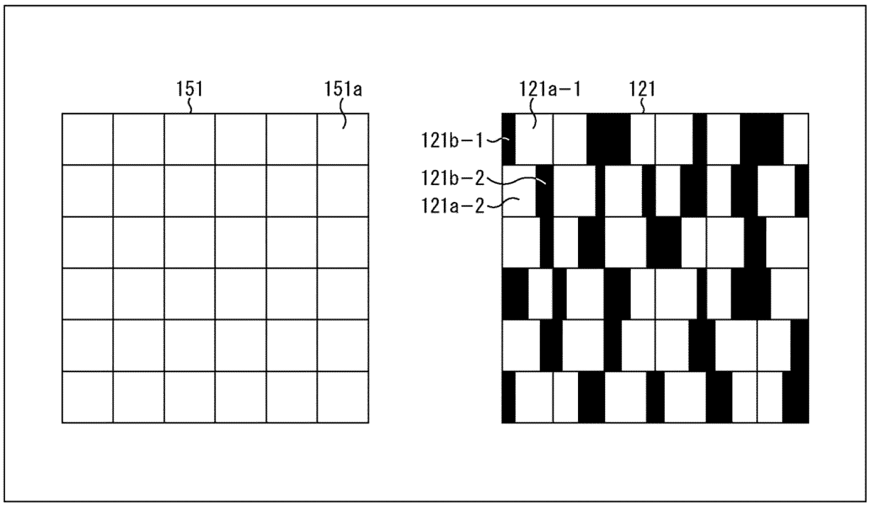




Processed by Luminess, 75001 PARIS (FR)

## Description

[Technical Field]

The present disclosure relates to an imaging apparatus, an imaging device, and an image processing apparatus, and particularly to an imaging apparatus, an imaging device, and an image processing apparatus that make it possible to improve the degree of freedom in design of a configuration for implementing an imaging function.

[Background Art]

As a configuration of an imaging apparatus, a configuration that includes a combination of an imaging lens and an imaging device and another configuration that includes a pinhole and an imaging device are generally well known.

Of the configurations, the configuration of the combination of an imaging lens and an imaging device is adopted in most imaging apparatus at present, and since light from an object is condensed efficiently, an image equivalent to a final picture is formed on an imaging plane of the imaging device and this is imaged by the imaging device.

However, in an imaging apparatus of the configuration of the combination of an imaging lens and an imaging device, since an influence of the aberration of the imaging lens occurs and the imaging lens is an essentially required component, there is a limitation to scaling down of the apparatus configuration.

On the other hand, although the configuration of the combination of a pinhole and an imaging device is a configuration that does not include an imaging lens, since the amount of light that comes to the imaging plane is small, it is necessary to apply such a process as to increase the exposure time period or to increase the gain. Therefore, the configuration is not durable for general use and is not appropriate especially for high speed imaging.

Therefore, an imaging apparatus has been proposed in which, by a configuration of a combination of an optical filter configured from a diffraction grating and an imaging device without using an imaging lens, light from an object is imaged as an image of a pattern obtained through the optical filter configured from a diffraction grating and the image including a figure of the object is reproduced (refer to NPL 1 and PTL 1).

[Citation List]

[Non-Patent Literature]

[NPL 1] FlatCam: Replacing Lenses with Masks and Computation M. Salmon Asif, Ali Ayremlouy, Aswin Sankaranarayanan, Ashok Veeraraghavan, and Richard Baraniuk ECE Department, Rice University, Houston, TX ECE Department, Carnegie Mellon University, Pittsburgh, PA

[Patent Literature]

[PTL 1] PCT Patent Publication No. WO2016/123529

[Summary]

[Technical Problem]

However, in the case of such a configuration as in NPL 1 or PTL 1, since light from the same point light source enters a plurality of neighboring pixels through an optical filter, an arbitrary characteristic cannot be obtained for a unit of a pixel.

The present disclosure has been made in view of such a situation as just described and makes it possible to provide diversity to individual pixels in the case where an imaging lens is not used.

[Solution to Problem]

The imaging apparatus of a first aspect of the present disclosure is an imaging apparatus including an imaging device that has a plurality of pixel output units for receiving incident light incident thereto without intervention of any of an imaging lens and a pinhole and in which characteristics of output pixel values of at least two of the plurality of pixel output units in regard to an incident angle of incident light from an object are different from each other.

The characteristic may be an incident angle directivity indicative of a directivity of the incident light from the object with respect to the incident angle.

Single detection signal may be outputted from each of the plurality of pixel output units.

The imaging apparatus may further include an image restoration section configured to restore a restoration image on which the object is viewable, using a detection image configured from a plurality of detection signals outputted from the plurality of pixel output units.

The image restoration section may restore the restoration image by selectively using detection signals of part of the plurality of pixel output units.

The image restoration section may selectively execute a restoration process for restoring the restoration image by using detection signals of part of the plurality of pixel output units and a restoration process for restoring the restoration image using detection signals of all of the plurality of pixel output units.

The plurality of pixel output units may include a wide angle compatible pixel output unit having the incident angle directivity suitable for a wide angle image and a narrow angle compatible pixel output unit narrower than the wide angle compatible pixel output unit, and the image restoration section may restore the restoration image by selectively using the wide angle compatible pixel output unit and the narrow angle compatible pixel output unit.

The imaging apparatus may not include a condensing mechanism for introducing diffused light rays having different principal ray incident angles from the object to a plurality of pixel output units neighboring with each other.

The plurality of pixel output units may have a structure capable of individually setting characteristics for incident angles of the incident light from the object independently of each other.

In the first aspect of the present disclosure, an imaging device has a plurality of pixel output units for receiving incident light incident thereto without intervention of any of an imaging lens and a pinhole, characteristics of output pixel values of at least two of the plurality of pixel output units in regard to an incident angle of incident light from an object are different from each other.

The imaging device of a second aspect of the present disclosure is an imaging device having a plurality of pixel output units for receiving incident light incident thereto without the intervention of any of an imaging lens and a pinhole and in which characteristics of output pixel values of at least two of the plurality of pixel output units in regard to an incident angle of incident light from an object are different from each other.

At least two of the plurality of pixel output units may be different from each other in incident angle directivity indicative of a directivity of incident light from an object with respect to an incident angle.

Each of the plurality of pixel output units may be configured from one photodiode, and single detection signal may be outputted from each of the plurality of pixel output units.

Each of the at least two pixel output units may include a light shielding film for blocking incidence of object light that is incident light from the object to the photodiode, and ranges in which incidence of the object light to the two pixel output units is blocked by the light shielding film may be different from each other between the at least two pixel output units.

Each of the plurality of pixel output units may be configured from a plurality of photodiodes, and single detection signal may be outputted from each of the plurality of pixel output units.

The at least two pixel output units may be different from each other in one of the plurality of photodiodes, which contributes to the detection signal.

The plurality of pixel output units may include a wide angle compatible pixel output unit having an incident angle directivity suitable for a wide angle image and a narrow angle compatible pixel output unit narrower than the wide angle compatible pixel output unit.

The imaging device may further include a plurality of on-chip lenses individually corresponding to each of the plurality of pixel output units.

The incident angle directivity may have a characteristic according to a curvature of the on-chip lenses.

The incident angle directivity may have a characteristic according to a light shielding region.

The curvature of at least part of the plurality of on-chip lenses may be different from a curvature of other on-chip lenses.

In the second aspect of the present disclosure, the imaging device has a plurality of pixel output units for receiving incident light incident thereto without intervention of any of an imaging lens and a pinhole, characteristics of output pixel values of at least two of the plurality of pixel output units in regard to an incident angle of incident light from an object are different from each other.

The plurality of pixel output units may have a structure capable of individually setting characteristics for incident angles of the incident light from the object independently of each other.

The image processing apparatus of a third aspect of the present disclosure is an image processing apparatus including an image restoration section configured to restore, using a detection image configured from a plurality of detection signals each of which outputted from each of the plurality of pixel output units of an imaging device having a plurality of pixel output units for receiving incident light thereto without intervention of any of an image pickup lens and a pinhole and in which an incident angle directivity of incident light from an object with respect to an incident angle is different between output pixel values of at least two of the plurality of pixel output units, a restoration image on which the object is viewable.

The image restoration section may restore the restoration image by selectively using a detection signal or signals of part of the plurality of pixel output units.

The image restoration section may selectively execute a restoration process for restoring the restoration image by using detection signals of part of the plurality of pixel output units and a restoration process for restoring the restoration image using detection signals of all of the plurality of pixel output units.

The plurality of pixel output units may include a wide angle compatible pixel output unit having the incident angle directivity suitable for a wide angle image and a narrow angle compatible pixel output unit narrower than the wide angle compatible pixel output unit, and the image restoration section may restore the restoration image by selectively using the wide angle compatible pixel output unit and the narrow angle compatible pixel output unit.

In the third aspect of the present disclosure, a plurality of pixel output units for receiving incident light incident thereto without the intervention of any of an imaging lens and a pinhole are had, and a detection image configured from a plurality of detection signals outputted from the plurality of pixel output units of an imaging device in which an incident angle directivity of incident light from an object with respect to an incident angle is different between output pixel values of at least two of the plurality of pixel output units is used to restore a restoration image on which the object is viewable.

[Advantageous Effect of Invention]

According to the one aspect of the present disclosure, it becomes possible to improve the degree of freedom in design of a configuration for imaging an image.

[Brief Description of Drawings]

[FIG. 1]
FIG. 1 is a view illustrating a principle of imaging.
[FIG. 2]
FIG. 2 is a view illustrating a principle of imaging in an imaging apparatus configured from an imaging lens and a conventional imaging device.
[FIG. 3]
FIG. 3 is a view illustrating a principle of imaging in an imaging apparatus configured from a pinhole and a conventional imaging device.
[FIG. 4]
FIG. 4 is a view illustrating a principle of imaging in an imaging apparatus that uses only a conventional imaging device.
[FIG. 5]
FIG. 5 is a view illustrating a principle of imaging in an imaging apparatus to which the technology of the present disclosure is applied.
[FIG. 6]
FIG. 6 is a view illustrating an example of a configuration of a first embodiment of the imaging apparatus to which the technology of the present disclosure is applied.
[FIG. 7]
FIG. 7 is a view illustrating an example of a configuration of a conventional imaging apparatus.
[FIG. 8]
FIG. 8 is a flow chart illustrating a conventional imaging process by the conventional imaging apparatus of FIG. 7.
[FIG. 9]
FIG. 9 is a view illustrating a difference in configuration between a conventional imaging device and a directional imaging device of the present disclosure.
[FIG. 10]
FIG. 10 is a view illustrating a first configuration example of the directional imaging device.
[FIG. 11]
FIG. 11 is a view illustrating the first configuration example of the directional imaging device.
[FIG. 12]
FIG. 12 is a view illustrating a principle of generation of an incident angle directivity.
[FIG. 13]
FIG. 13 is a view illustrating a change of the incident angle directivity utilizing an on-chip lens.
[FIG. 14]
FIG. 14 is a view illustrating design of an incident angle directivity.
[FIG. 15]
FIG. 15 is a view illustrating a difference between an on-chip lens and an imaging lens.

[FIG. 16]
FIG. 16 is a view illustrating another difference between an on-chip lens and an imaging lens.
[FIG. 17]
FIG. 17 is a view illustrating a further difference between an on-chip lens and an imaging lens.
[FIG. 18]
FIG. 18 is a view illustrating a relationship between regions on an object plane and pixels of a directional imaging device.
[FIG. 19]
FIG. 19 is a view illustrating that incident light is parallel light.
[FIG. 20]
FIG. 20 is a view illustrating an incident angle to each pixel of a directional imaging device.
[FIG. 21]
FIG. 21 is a view illustrating a light receiving sensitivity characteristic in a vertical direction.
[FIG. 22]
FIG. 22 is a view illustrating a light receiving sensitivity characteristic in a horizontal direction.
[FIG. 23]
FIG. 23 is a view illustrating a light receiving sensitivity characteristic according to the indent angle to each pixel of a directional imaging device.
[FIG. 24]
FIG. 24 is a view illustrating a light receiving sensitivity of each pixel of the directional imaging device in regard to light from a region O11 of the object plane.
[FIG. 25]
FIG. 25 is a view illustrating a light receiving sensitivity of each pixel of the directional imaging device in regard to light from a region 021 of the object plane.
[FIG. 26]
FIG. 26 is a view illustrating a light receiving sensitivity of each pixel of the directional imaging device in regard to light from a region 031 of the object plane.
[FIG. 27]
FIG. 27 is a view illustrating a light receiving sensitivity of each pixel of the directional imaging device in regard to light from a region O12 of the object plane.
[FIG. 28]
FIG. 28 is a view illustrating a light receiving sensitivity of each pixel of the directional imaging device in regard to light from a region O22 of the object plane.
[FIG. 29]
FIG. 29 is a view illustrating a light receiving sensitivity of each pixel of the directional imaging device in regard to light from a region O32 of the object plane.
[FIG. 30]
FIG. 30 is a view illustrating a light receiving sensitivity of each pixel of the directional imaging device in regard to light from a region O13 of the object plane.
[FIG. 31]
FIG. 31 is a view illustrating a light receiving sensitivity of each pixel of the directional imaging device in regard to light from a region O23 of the object plane.
[FIG. 32]
FIG. 32 is a view illustrating a light receiving sensitivity of each pixel of the directional imaging device in regard to light from a region O33 of the object plane.
[FIG. 33]
FIG. 33 is a view illustrating a relationship between an object distance and a coefficient for representing an incident angle directivity;
[FIG. 34]
FIG. 34 is a view illustrating a relationship between a narrow field angle pixel and a wide field angle pixel.
[FIG. 35]
FIG. 35 is a view illustrating another relationship between a narrow field angle pixel and a wide field angle pixel.
[FIG. 36]
FIG. 36 is a view illustrating a further relationship between a narrow field angle pixel and a wide field angle pixel.
[FIG. 37]
FIG. 37 is a flow chart illustrating an imaging process by the imaging apparatus of the present disclosure of FIG. 6.
[FIG. 38]
FIG. 38 is a view illustrating a first modification.

[FIG. 39]
FIG. 39 is a view illustrating a second modification.
[FIG. 40]
FIG. 40 is a view illustrating the second modification.
[FIG. 41]
FIG. 41 is a view illustrating an example in which the angle of view is changed by applying the second modification.
[FIG. 42]
FIG. 42 is a view illustrating an example in which, when the angle of view is changed by applying the second modification, a plurality of pixels of different angles of view are combined.
[FIG. 43]
FIG. 43 is a view illustrating a third modification.
[FIG. 44]
FIG. 44 is a view illustrating a reason why the calculation amount and the capacity of a memory are reduced by providing rules for a horizontal direction and a vertical direction of a light shielding range.
[FIG. 45]
FIG. 45 is a view illustrating another reason why the calculation amount and the capacity of a memory are reduced by providing rules for a horizontal direction and a vertical direction of a light shielding range.
[FIG. 46]
FIG. 46 is a view illustrating a further reason why the calculation amount and the capacity of a memory are reduced by providing rules for a horizontal direction and a vertical direction of a light shielding range.
[FIG. 47]
FIG. 47 is a view illustrating a still further reason why the calculation amount and the capacity of a memory are reduced by providing rules for a horizontal direction and a vertical direction of a light shielding range.
[FIG. 48]
FIG. 48 is a view illustrating a fourth modification.
[FIG. 49]
FIG. 49 is a view illustrating a fifth modification.
[FIG. 50]
FIG. 58 is a view illustrating a sixth modification.
[FIG. 51]
FIG. 51 is a view illustrating a seventh modification.
[FIG. 52]
FIG. 52 is a view illustrating an eighth modification.
[FIG. 53]
FIG. 53 is a view illustrating a configuration example of a second embodiment of an imaging apparatus to which the technology of the present disclosure.

[Description of Embodiments]

In the following, preferred embodiments of the present disclosure are described with reference to the accompanying drawings. It is to be noted that components having substantially same functional configurations in the present specification and the drawings are denoted by like reference signs and overlapping description of them is omitted.
Further, the description is given in the following order.

1. Overview of Imaging Apparatus of Present Disclosure
2. First Embodiment
3. Second Embodiment

«1. Overview of Imaging Apparatus of Present Disclosure»

In describing the imaging apparatus of the present disclosure, an overview of the imaging apparatus is described.

<Principle of Imaging>

All objects can be considered a set of point light sources, and light is emitted in an every direction. Accordingly, a principle of imaging can be described by thinking of in what manner an image of light emitted from a point light source is to be imaged. Here, it is assumed that, as indicated at an upper stage of FIG. 1, light rays L1 to L5 are emitted from a point light source P and that the light rays L1 to L5 individually have a light intensity a.

In the case where the configuration of an imaging apparatus includes an imaging lens 11 and an imaging device D for one pixel and an image of the point light source P is imaged by the imaging device D, as indicated at a middle stage of FIG. 1, the imaging lens 11 condenses the light rays L1 to L5 emitted from the point light source P as indicated by light rays L1' to L5' and an image of the point light source P is formed on the imaging device D and this is imaged by the imaging device D.

In this case, in the imaging device D, a figure configured from light having a light intensity 5a that is the total of the light intensities of all of the light rays L1 to L5 emitted from the point light source P is formed and enters the imaging device D such that it is imaged as an image having a sufficient light amount.

Incidentally, as described above, a set of such point light sources P configures an object. Accordingly, in imaging of an object, an image of the object formed from light rays emitted from a plurality of point light sources P on an object plane and condensed is imaged.

In particular, for example, as indicated in a left portion of FIG. 2, in the case where an object on an object plane 31 is configured from point light sources PA, PB and PC and five light rays having light intensities a, b and c are outputted from the point light sources PA, PB and PC, respectively, similarly as in the case indicated at the upper stage in FIG. 1, the total of the light intensities are light intensities 5a, 5b and 5c.

In this case, in accordance with the principle of the imaging indicated at the middle stage of FIG. 1, light rays from the point light sources PA, PB and PC are condensed, by the imaging lens 11, to positions Pa, Pb and Pc on an imaging plane of an imaging device 32 configured from a plurality of pixels to form a figure of an object to image the image.

Here, when the detection signal levels of the light rays are a, b and c, the detection signal levels of pixels at the positions Pa, Pb and Pc on the imaging device 32 are detection signal levels 5a, 5b and 5c at the positions Pa, Pb and Pc as indicated in a right portion of FIG. 2, respectively.

It is to be noted that, in the right portion of FIG. 2, the axis of ordinate represents a position on the imaging device 32 and the axis of abscissa represents a detection signal level of the imaging device at each position. In particular, an image including a figure of an object is imaged in which the positions Pa, Pb and Pc on the imaging device 32 have an inverted positional relationship to the point light sources PA, PB and PC on the object plane 31 and besides the detection signal levels at the positions Pa, Pb and Pc have light intensities of the light rays emitted from the point light sources PA, PB and PC.

On the other hand, in the case where the configuration of the imaging apparatus is a configuration including a pinhole 12a provided as a hole portion in a light shielding film 12 and an imaging device D, as indicated at a lower stage of FIG. 1, only the light ray L3 that passes through the pinhole 12a from among the light rays L1 to L5 emitted from the point light source P is formed and imaged as an image on the imaging device D.

In this case, in the imaging device D, an image of the point light source P is formed only from the light ray L3 emitted from the point light source P and having the light intensity a and enters the imaging device D and, as a result, as indicated at the middle stage of FIG. 1, a dark image whose light amount is 1/5 is imaged in comparison with that in which the imaging lens 11 is used.

In particular, a case is considered in which, for example, as indicated in a left portion of FIG. 3, an object on the object plane 31 is configured from the point light sources PA, PB and PC and light rays emitted from the point light sources have light intensities a, b and c, respectively. At this time, in accordance with the principle of the imaging indicated at the lower stage of FIG. 1, at the positions Pa, Pb and Pc on the imaging plane of the imaging device 32, an image of an object is formed and imaged by the detection signal levels a, b and c equivalent to that of one light ray from each of the point light sources PA, PB and PC.

Here, when the detection signal levels at the positions Pa, Pb and Pc are a, b and c (for example, $b > a > c$), respectively, as indicated in the right portion of FIG. 3, the detection signal levels at the positions Pa, Pb and Pc are a, b and c, respectively. It is to be noted that, in the right portion of FIG. 3, the axis of ordinate represents a position on the imaging device 32 and the axis of abscissa represents a detection signal level in the imaging device at each position, respectively. It is to be noted that, since the detection signal level indicated in the right portion of FIG. 3 also is a detection signal level corresponding to an image including a figure of an object, the detection signal level also is a pixel value.

In particular, the essence of imaging of an object resides in that the luminance of each point light source on the object plane 31 is measured by photoelectric conversion and that the light intensities a, b and c of the point light sources PA, PB and PC in the right portion of FIG. 3 are detected.

As described hereinabove with reference to FIG. 1, the role of the imaging lens 11 is that light rays emitted from the point light sources PA, PB and PC, namely, diffused light, are introduced to the imaging device 32. Therefore, a figure corresponding to a final picture is formed on the imaging device 32, and an image formed from a detection signal is an imaged image including the figure. However, since the size of an imaging apparatus is determined in accordance with the size of an imaging lens, there is a limitation in the downsizing.

Further, since an imaging apparatus configured from a pinhole and an imaging device need not have an imaging lens provided therein, there is the possibility that the apparatus configuration may possibly be reduced in comparison with that of an imaging apparatus configured from an imaging lens and an imaging device. However, since the brightness of an imaged image is not sufficient, it is essentially required to increase the exposure time period, to increase the gain or the like such that an image having some degrees of brightness can be imaged, and there is the possibility that a blur may be likely to appear in imaging of a high-speed object or natural color representation may not be implemented.

Therefore, as indicated in a left portion of FIG. 4, it is considered to image an object on the object plane 31 only using the imaging device 32 without providing an imaging lens or a pinhole.

For example, if it is assumed that rays of light intensities a, b and c enter positions Pa, Pb and Pc on the imaging device 32 from the point light sources PA, PB and PC, respectively, as depicted in a left portion in FIG. 4, then the rays from the point light sources PA, PB and PC directly enter the positions Pa, Pb and Pc on the imaging device 32.

As a result, as depicted in a right portion in FIG. 4, since there is no incident angle directivity at the positions Pa, Pb and Pc on the imaging device 32, imaging is performed with the rays of a same light intensity a + b + c, and a detection signal of an equal detection signal level is obtained over the overall imaging device 32 irrespective of the position. It is to be noted that, since the detection signal level indicated in the right portion in FIG. 4 is not a detection signal level corresponding to an image including a figure of an object, it does not indicate a restored pixel value.

In particular, it is not possible to form an image of a figure of an object on the object plane 31 using only the imaging device 32 that does not have any of an imaging lens and a pinhole nor has a special configuration. Therefore, with the configuration that uses only the imaging device 32, an image including a figure of an object cannot be imaged.

Therefore, in the imaging apparatus of the present disclosure, an imaging device 51 in which the detection sensitivity of each pixel has an incident angle directivity as depicted in a left portion at an upper stage in FIG. 5 is provided. That the detection sensitivity of each pixel has an incident angle directivity here signifies to provide a light receiving sensitivity characteristic according to an incident angle of incident light to a pixel such that the light receiving sensitivity is different for each pixel. However, there is no necessity that the light receiving sensitivity characteristics of all pixels are fully different from each other, and some pixels may have a same light receiving sensitivity characteristic or some pixels may have different incident angle directivities.

In particular, in the case where it is assumed that a light source configuring the object plane 31 is a point light source, although rays of an equal light intensity emitted from the same point light source enter all pixels of the imaging device 51, they enter at incident angles different for each pixel. Thus, since the pixels have light receiving sensitivity characteristics different according to the incident angles of incident light, namely, have different incident angle directivities, even if the rays have an equal light intensity, they are detected with different sensitivities by the pixels, and detection signals of detection signal levels different for each pixel are detected.

More particularly, it is assumed that the sensitivity characteristic according to an incident angle of incident light received by each pixel of the imaging device 51, namely, the incident angle directivity according to an incident angle by each pixel, is expressed by a coefficient representative of a light receiving sensitivity according to the incident angle, and the detection signal level according to incident light to each pixel is calculated by multiplication by a coefficient set corresponding to a light receiving sensitivity according to the incident angle of incident light.

More particularly, as indicated in a right portion at an upper stage in FIG. 5, the detection signal levels DA, DB and DC at the positions Pa, Pb and Pc are represented by the following expressions (1) to (3), respectively.

$$DA = \alpha 1 \times a + \beta 1 \times b + \gamma 1 \times c \quad \dots (1)$$

$$DB = \alpha 2 \times a + \beta 2 \times b + \gamma 2 \times c \quad \dots (2)$$

$$DC = \alpha 3 \times a + \beta 3 \times b + \gamma 3 \times c \quad \dots (3)$$

Here, $\alpha 1$ is a coefficient for a detection signal level a set in response to the incident angle of a ray from the point light source PA on the object plane 31 to be restored at the position Pa on the imaging device 51 and, in other words, is a coefficient for the detection signal level for representing an incident angle directivity according to the incident angle of a ray from the point light source PA at the position Pa.

Meanwhile, $\beta 1$ is a coefficient for a detection signal level b set in response to the incident angle of a ray from the point light source PB on the object plane 31 to be restored at the position Pa on the imaging device 51.

Further, $\gamma 1$ is a coefficient for a detection signal level c set in response to the incident angle of a ray from the point light source PC on the object plane 31 to be restored at the position Pa on the imaging device 51.

Accordingly, ($\alpha 1 \times a$) in the detection signal level DA indicates a detection signal level by a ray from the point light source PA at the position Pc and is obtained by multiplying the light intensity a of a ray from the point light source PA at the position Pc by the coefficient $\alpha 1$ indicative of the incident angle directivity according to the incident angle.

Further, ($\beta 1 \times a$) in the detection signal level DA indicates a detection signal level by a ray from the point light source PB at the position Pc and is obtained by multiplying the light intensity b of a ray from the point light source PB at the position Pc by the coefficient $\beta 1$ indicative of the incident angle directivity according to the incident angle.

Furthermore, ($\gamma 1 \times a$) in the detection signal level DA indicates a detection signal level by a ray from the point light source PC at the position Pc and is obtained by multiplying the light intensity c of a ray from the point light source PC at the position Pc by the coefficient $\gamma 1$ indicative of the incident angle directivity according to the incident angle.

Accordingly, the detection signal level DA is represented as a composite value of the products when the components of the point light sources PA, PB and PC at the position Pa are multiplied by the coefficients $\alpha 1$, $\beta 1$ and $\gamma 1$ indicative of the incident angle directivities according to the respective incident angles, respectively. The coefficients $\alpha 1$, $\beta 1$ and $\gamma 1$ are hereinafter referred to collectively as coefficient set.

Similarly, regarding the detection signal level DB by the point light source PB, the coefficient set $\alpha 2$, $\beta 2$ and $\gamma 2$ correspond to the coefficient set $\alpha 1$, $\beta 1$ and $\gamma 1$ regarding the detection signal level DA by the point light source PA, respectively. Further, regarding the detection signal level DC by the point light source PC, the coefficient set $\alpha 3$, $\beta 3$ and $\gamma 3$ correspond to the coefficient set $\alpha 1$, $\beta 1$ and $\gamma 1$ regarding the detection signal level DA by the point light source PA, respectively.

However, the detection signal levels of the pixels at the positions Pa, Pb and Pc are values represented by product sums of the light intensities a, b and c of rays emitted from the point light sources PA, PB and PC and the coefficients. Therefore, since the detection signal levels are mixtures of the light intensities a, b and c of rays emitted from the point light sources PA, PB and PC, they are different from those of images including a figure of the object.

In particular, by configuring simultaneous equations using the coefficient set $\alpha 1$, $\beta 1$ and $\gamma 1$, coefficient set $\alpha 2$, $\beta 2$ and $\gamma 2$, coefficient set $\alpha 3$, $\beta 3$ and $\gamma 3$ and detection signal levels DA, DB and DC and solving the light intensities a, b and c, pixel values at the positions Pa, Pb and Pc are calculated as indicated in a right portion at a lower stage in FIG. 5. A restoration image that is a set of pixel values is restored from the pixel values.

It is to be noted that, since the detection signal level indicated in the right portion at an upper stage in FIG. 5 is not the detection signal level corresponding to an image including a figure of an object, it is not a pixel value. Further, since the detection signal level indicated in the right portion at the lower stage in FIG. 5 is a signal value for each pixel corresponding to an image including a figure of an object, namely, a value of each pixel of a restoration image, it is a pixel value.

By such a configuration as described above, an imaging apparatus that includes, as a component thereof, an imaging device 51 having an incident angle directivity at each pixel without the necessity for an imaging lens, an optical filter configured from a diffraction grating or the like or a pinhole. As a result, since an imaging lens, an optical filter configured from a diffraction grating or the like, a pinhole or the like does not become an essentially required component, reduction in height of the imaging apparatus, namely, reduction in thickness of components for implementing an imaging function in the incident direction of light, can be achieved.

«2. First Embodiment»

Now, a configuration example of a first embodiment to which the imaging apparatus of the present disclosure is applied is described with reference to a block diagram of FIG. 6.

The imaging apparatus 101 is configured from a directional imaging device 121, a signal processing section 122, a demosaic processing section 123, a $\gamma$ correction section 124, a white balance adjustment section 125, an image outputting section 126, a storage section 127, a display section 128, an imaging distance determination section 129, an operation section 130 and a coefficient set selection section 131 and does not include an imaging lens.

The directional imaging device 121 corresponds to the imaging device 51 described hereinabove with reference to FIG. 5 and is an imaging device that includes pixels having an incident angle directivity and outputs a detection image formed from signals of a detection signal level according to a light amount of incident light.

More particularly, although the directional imaging device 121 may be similar in basic structure to a general device including an imaging device such as, for example, a CMOS (Complementary Metal Oxide Semiconductor) image sensor or the like, it is different in configuration of images configuring a pixel array from a general device. In particular, in each pixel, a light shielding film is provided in a range that is part of a light receiving region (light receiving face) of each photodiode and is mutually different for each pixel. Consequently, the light receiving sensitivity differs (changes) in response to the incident angle of incident light for each pixel, and as a result, an imaging device having an incident angle directivity of incident light with respect to an incident angle in a unit of a pixel. It is to be noted that the directional imaging device 121 may not be configured as a pixel array and may be configured, for example, as a line sensor. Further, as regard the light shielding films, the configuration is not limited to that in a case in which all of them are different in a unit of a pixel, but may be a configuration in which part of them are same or may be a configuration in which part of them are different.

The signal processing section 122 configures simultaneous equations using detection signal levels of the pixels supplied from the directional imaging device 121 and coefficient sets stored in the coefficient set selection section 131, solves the configured simultaneous equations to find pixel values of the pixels configuring a restoration image and outputs the pixel values to the demosaic processing section 123. It is to be noted that the pixel number of the directional imaging device 121 and the pixel number of pixels that configure a restoration image need not necessarily be equal to each other. Further, since a case in which a color filter has a Bayer array is described as an example here, the demosaic processing section 123 is provided as a component that performs a color separation process. However, in the case where the color filter is, for example, a stripe color filter or the like, the demosaic processing section 123 is replaced with a configuration for carrying out a corresponding color separation process, and further, in the case of a monochromatic imaging device or a multi-plate imaging apparatus having an imaging device for each color, the demosaic processing section 123 is omitted.

Further, the color filter may be of the type that passes colors other than RGB (red, green and blue) that are used in a Bayer array, and, for example, may be of the type that passes yellow, white or the like or may be of the type that passes ultraviolet rays, infrared rays or the like, and may be of the type that passes colors of various wavelengths.

Further, since the detection image formed from a signal outputted from the directional imaging device 121 of FIG. 6 is an image configured from a detection signal in which an image of a figure of an object is not formed as indicated on the right side at the upper stage in FIG. 5 described hereinabove, it is an image on which the object cannot be recognized visually. In particular, although the detection image formed from a detection signal outputted from the directional imaging device 121 of FIG. 6 is a set of pixel signals, it is an image that cannot be recognized as an image even if the user views the detection image. An image formed from a figure of the object, namely, a restoration image that can be recognized as an image when the user views, is an image that is determined by solving simultaneous equations in which a detection signal indicated on the right side at the upper stage in FIG. 5 and coefficient set groups are used and is configured from pixel values depicted on the right side at the lower stage in FIG. 5, in the imaging apparatus 101 of FIG. 6.

Therefore, an image configured from a detection signal and not including a figure of an object as depicted on the right side at the upper stage of FIG. 5, namely, an image imaged by the directional imaging device 121, is hereinafter referred to as detection image.

Further, an image including a figure of an object depicted on the right side at the lower stage in FIG. 5, namely, an image that is configured from pixel values of an image including a figure of an object calculated from simultaneous equations in which detection signal levels of the pixels configuring a detection image and coefficient sets by the signal processing section 122 are used and can be recognized as an image when the user views is hereinafter referred to as restoration image. However, in the case where the directional imaging device 121 has a sensitivity only to light other than that in a visible wavelength band such as ultraviolet rays, although the restoration image does not become an image on which an object can be identified like an ordinary image, also in this case, the image is referred to as restoration image.

Further, a restoration image that is an image in a state in which an image of a figure of an object is formed and is an image before a demosaic process is performed is referred to as Raw image, and although a detection image imaged by the directional imaging device 121 is an image according to an array of a color filter, it is distinguished not as a Raw image.

The demosaic processing section 123 performs a demosaic process, according to an array of a color filter such as a Bayer array, for generating a pixel signal of a missing color to generate a plain image for each of RGB and supplies the image to the $\gamma$ correction section 124.

The $\gamma$ correction section 124 performs $\gamma$ correction for the image after the demosaic process and supplies a resulting image to the white balance adjustment section 125.

The white balance adjustment section 125 adjusts the white balance of the image for which the $\gamma$ correction has been performed and outputs a resulting image to the image outputting section 126.

The image outputting section 126 converts the image for which the white balance has been adjusted into an image of a predetermined compression format such as, for example, JPEG (Joint Photographic Experts Group), TIFF (Tag Image File Format), GIF (Graphics Interchange Format) or the like. Then, the image outputting section 126 executes one of processes for storing the image signal after the conversion into an image of the predetermined format into the storage section 127 configured from one of a HDD (Hard Disk Drive), a SSD (Solid State Drive), a semiconductor memory and so forth, a combination of them or the like, for causing the image signal to be displayed on the display section 128 configured from an LCD (Liquid Crystal Display) or the like and for outputting the image signal to the imaging distance determination section 129.

The imaging distance determination section 129 determines an object distance that is a distance from the imaging position to the object on the basis of an operation signal from the operation section 130 including an operation dial, an operation button, an external remote controller configured as a separate member from the imaging apparatus 101, and supplies information of the determined object distance to the coefficient set selection section 131. In particular, since a restoration image is displayed on the display section 128, the user not depicted would operate the operation section 130 while viewing a through image that is a restoration image displayed on the display section 128 to adjust the object distance.

The coefficient set selection section 131 has stored therein coefficient sets that correspond to the coefficients α1 to α3, β1 to β3 and γ1 to γ3 described hereinabove in an associated relationship with various object distances that correspond to distances from the imaging device 51 to the object plane 31 (object plane corresponding to a restoration image) in FIG. 5. Therefore, the coefficient set selection section 131 selects a coefficient set on the basis of the information of the object distance supplied thereto from the imaging distance determination section 129. Consequently, the signal processing section 122 restores a restoration image from the detection image using the selected coefficient set.

It is to be noted that, in such a case that a restoration image at only one object distance is to be obtained, the imaging distance determination section 129 may not be provided.

Also it is possible to implement an auto focus function as in an imaging apparatus that uses an imaging lens.

In this case, the imaging distance determination section 129 can implement the auto focus function by determining an optimum object distance by a mountain climbing method similar to a contrast AF (Auto Focus) method on the basis of a restoration image supplied from the image outputting section 126.

It is to be noted that the object distance may be determined not on the basis of a restoration image supplied from the image outputting section 126 but on the basis of outputs of the demosaic processing section 123, γ correction section 124 and white balance adjustment section 125.

Further, the imaging distance determination section 129 may determine an object distance on the basis of an output of a distance measurement sensor provided separately.

Alternatively, a detection image outputted from the directional imaging device 121 may be stored into the storage section 127 without restoring the same. In this case, the detection image stored in the storage section 127 is supplied to the signal processing section 122, by which a restoration image is generated. Furthermore, the detection image may be stored or saved into a recording medium without restoring the same or may be outputted to a different apparatus by communication or the like such that the detection image is restored by the different apparatus such as, for example, a PC (personal computer), a reproduction apparatus or the like different from the imaging apparatus.

Thereupon, the coefficient set selection section 131 may select one of a plurality of coefficient sets associated with a plurality of object distances on the basis of user selection or the like such that a restoration image of a different object distance may be switched with the coefficient set selected by the signal processing section 122. By this, refocus may be implemented.

It is to be noted that, while the configuration in FIG. 6 is a configuration example in which all of the demosaic processing section 123, γ correction section 124 and white balance adjustment section 125 are provided, since any of them is not an essentially required component, they may be omitted or a configuration order other than the configuration of FIG. 6 may be applied. Further, the image outputting section 126 may not perform compression, format conversion or the like and output a Raw image as it is. Furthermore, in the case where the demosaic processing section 123, γ correction section 124 and white balance adjustment section 125 are omitted and the image outputting section 126 does not perform compression, white balance adjustment or the like, a Raw image may be outputted as it is by an HDMI (registered trademark) (High Definition Multimedia Interface) or the like.

<Configuration Example of Imaging Apparatus Including Optical Block>

Here, before a configuration example of the imaging apparatus of the present application is described, for the object of comparison, a configuration example of an imaging apparatus including an optical block configured from a plurality of imaging lenses is described with reference to a block diagram of FIG. 7. It is to be noted that, in the configuration of the imaging apparatus 141 including the optical block of FIG. 7, like components to those of the imaging apparatus 101 of FIG. 1 are denoted by like reference signs and like names, and description of them is suitably omitted.

In particular, the imaging apparatus 141 of FIG. 7 is different in configuration from the imaging apparatus 101 of FIG. 1 in that an imaging device 151, an optical block 152 and a focus adjustment section 153 are provided in place of the directional imaging device 121, signal processing section 122 and coefficient set selection section 131.

In particular, the imaging device 151 is an imaging device configured from pixels having no incident angle directivity, and the optical block 152 configured from a plurality of imaging lenses is adjusted by the focus adjustment section 153 in response to an object distance, namely, a focal distance, supplied thereto from the imaging distance determination section 129 such that incident light is condensed to form an image on the imaging plane of the imaging device 151. The imaging device 151 images a restoration image including a figure of the object in this manner and outputs the restoration image to the demosaic processing section 123.

<Imaging Process by Imaging Apparatus Including Optical Block of FIG. 7>

Now, an imaging process by the imaging apparatus 141 including the optical block of FIG. 7 is described with reference to a flow chart of FIG. 8.

At step S11, the imaging distance determination section 129 determines a distance from an object on the basis of an optical signal supplied thereto from the operation section 130 or a plurality of images imaged till then and supplies information of the determined object distance to the focus adjustment section 153. The focus adjustment section 153 adjusts the optical block 152 on the basis of the object distance, namely, the focal distance.

At step S12, the optical block 152 condenses incident light such that an image of a figure of an object on the object plane at a position corresponding to the corresponding object distance is formed on the imaging plane of the imaging device 151.

At step S13, the imaging device 151 images up an image including the figure of the object by the optical block 152 and supplies a Raw image that becomes a restoration image to the demosaic processing section 123.

At step S14, the demosaic processing section 123 performs a demosaic process for the Raw image that configures a restoration image and supplies a resulting image to the $\gamma$ correction section 124.

At step S15, the $\gamma$ correction section 124 performs $\gamma$ correction for the restoration image for which the demosaic process has been performed and supplies a resulting image to the white balance adjustment section 125.

At step S16, the white balance adjustment section 125 adjusts the white balance of the restoration image for which the $\gamma$ correction has been performed and outputs a resulting image to the white balance adjustment section 125.

At step S17, the image outputting section 126 converts the formed image for which the white balance has been adjusted into an image of a predetermined compression format.

At step S18, the image outputting section 126 performs at least one of such processes as to cause the restoration image after the conversion into the image of the predetermined compression format to be stored into the storage section 127, to be displayed on the display section 128 and to be supplied to the imaging distance determination section 129.

A restoration image is imaged by the processes described above. In particular, in the imaging process by the imaging apparatus including an optical block, light incident to the imaging device 151 is condensed by the optical block 152 to image a restoration image including a figure of the object.

<First Configuration Example of Directional Imaging Device>

(Difference between Imaging Apparatus that Uses Directional Imaging Device and Imaging Apparatus Including Optical Block)

In contrast, in the imaging apparatus 101 of FIG. 6, a detection image is imaged by the directional imaging device 121 that receives incident light entering without the intervention of any of the imaging lens 152 (FIG. 7) and the pinhole 12 (FIG. 3), and a restoration image is found by using solutions of simultaneous equations obtained from the detection image and a coefficient set group by the signal processing section 122.

This difference arises from a difference in structure between the directional imaging device 121 and the imaging device 151.

A left portion of FIG. 9 depicts a front elevational view of part of the pixel array section of the imaging device 151 of the imaging apparatus 141 including the optical block of FIG. 7, and a right portion of FIG. 9 depicts a front elevational view of part of the pixel array section of the directional imaging device 121 of the imaging apparatus 101 of the present disclosure illustrated in FIG. 6. It is to be noted that, while FIG. 9 depicts an example of a case in which the pixel array section is configured such that the pixel numbers in the horizontal direction $\times$ vertical direction are 6 pixels $\times$ 6 pixels, the configuration of the pixel numbers is not limited to this.

In particular, as depicted in FIG. 9, the imaging device 151 used in the imaging apparatus 141 including the optical block of FIG. 7 is depicted such that the imaging devices 151a having no incident angle directivity are disposed in an array. In contrast, the directional imaging device 121 is configured such that, for each pixel 121a, a light shielding film 121b is provided at part of the light reception region of its photodiode, which is a range different for each pixel 121a, and by making the light receiving sensitivity of incident light with respect to an incident angle different for each pixel 121a, an incident angle directivity with respect to an incident angle is provided.

More particularly, for example, the pixel 121a-1 and the pixel 121a-2 are different in range in which the pixels are shielded by the light shielding film 121b-1 and the light shielding film 121b-2 provided thereon (different at least one of a shielded region (position) and a shielded area). In particular, in the pixel 121a-1, the light shielding film 121b-1 is provided such that it shields part of the left side in the light reception region of the photodiode only with a predetermined width, and in the pixel 121a-2, the light shielding film 121b-2 is provided such that it shields part of the right side in the light reception region with a width greater in the horizontal direction than that of the light shielding film 121b-1. Also in the other pixels 121a, the light shielding film 121b is provided such that it shields a different range in the light receiving region for each pixel similarly, and they are disposed at random in the pixel array.

It is to be noted that the range of the light shielding film 121b preferably has an area of such a degree that a desired light amount can be secured because, as the ratio at which the light shielding film 121b covers the light receiving region of each pixel, the amount of light that can be received decreases, and the light shielding film 121b may be configured by applying such a restriction that, for example, the upper limit to the area thereof is approximately 3/4 that of the overall range in which light can be received. This makes it possible to secure an amount of light equal to or greater than a desired amount. However, if a range that is not shielded with a width corresponding to a wavelength of light to be received is provided for each pixel, then it is possible to receive a minimum amount of light. In particular, for example, in the case of a B pixel (blue pixel), although the wavelength is approximately 500 nm, if light is not blocked over a width corresponding to the wavelength or more, then it is possible to receive a minimum amount of light.

(Side Elevational Section, Top Face and Circuit Configuration in First Configuration Example of Directional Imaging Device)

Now, a side elevational section, a top plan and a circuit configuration in the first configuration example of the directional imaging device 121 is described with reference to FIG. 10. In particular, an upper stage in FIG. 10 is a side elevational sectional view in the first configuration example of the directional imaging device 121, and a middle stage in FIG. 10 is a top plan view in the first configuration example of the directional imaging device 121. Further, the side elevational sectional view at the upper stage in FIG. 10 becomes an AB section at the middle stage in FIG. 10. Further, a lower stage in FIG. 10 depicts a circuit configuration example of the directional imaging device 121.

In the directional imaging device 121 at the upper stage of FIG. 10, incident light enters downwardly from above in the figure. The pixels 121a-15 and 121a-16 neighboring with each other are of the so-called back side illumination type having a wiring line layer Z12 as the lowermost layer in the figure and having a photoelectric conversion layer Z11 provided on the wiring line layer Z12.

It is to be noted that, in the case where there is no necessity to distinguish the pixels 121a-15 and 121a-16 from each other, each of them is referred to simply as pixel 121a, and this similarly applies also to the other components. Further, although FIG. 10 depicts a side elevational view and a top plan view for two pixels that configure a pixel array of the directional imaging device 121, needless to say, a greater number of pixels 121a are disposed. However, illustration of them is omitted.

Further, the pixels 121a-15 and 121a-16 include photodiodes 121e-15 and 121e-16 provided in the photoelectric conversion layer Z11 thereof. Further, on-chip lenses 121c-15 and 121c-16 and color filters 121d-15 and 121d-16 are configured from above on the photodiodes 121e-15 and 121e-16, respectively.

The on-chip lenses 121c-15 and 121c-16 condense incident light to the photodiodes 121e-15 and 121e-16.

The color filters 121d-15 and 121d-16 are optical filters that pass light of a specific wavelength such as, for example, red, green, blue, infrared, white or the like. It is to be noted that, in the case of white, the color filters 121d-15 and 121d-16 may be transparent filters or may not be provided.

On the boundary between pixels in the photoelectric conversion layer Z11 of the pixels 121a-15 and 121a-16, light shielding films 121p-15 to 121p-17 are formed and suppress crosstalk between neighboring pixels.

Meanwhile, the light shielding films 121b-15 and 121b-16 shield a light receiving face S at part thereof as viewed from above as indicated at an upper stage and a lower stage in FIG. 10. On the light receiving face S of the photodiodes 121e-15 and 121e-16 of the pixels 121a-15 and 121a-16, different ranges are shielded by the light shielding films 121b-15 and 121b-16, respectively, and incident angle directivities different from each other are set for each pixel thereby. However, the shielded range is not limited to a case in which it is different among all pixels 121a of the directional imaging device 121, but some pixels 121a that are shielded over a same range may exist in all pixels 121a. By such a configuration as depicted at the upper stage in FIG. 10, a right end portion of the light shielding film 121p-15 and an upper end portion of the light shielding film 121b-15 are connected to each other and a left end portion of the light shielding film 121b-16 and an upper end portion of the light shielding film 121p-16 are connected to each other such that an L shape is formed as viewed in side elevation.

Furthermore, the light shielding films 121b-15 to 121b-17 and the light shielding films 121p-15 to 121p-17 are configured from metal and are configured, for example, from tungsten (W), aluminum (Al) or an alloy of Al and copper (Cu). Further, the light shielding films 121b-15 to 121b-17 and the light shielding films 121p-15 to 121p-17 may be formed simultaneously from metal same as that of wiring lines by a process same as a process by which the wiring lines are formed by a semiconductor process. It is to be noted that the film thickness of the light shielding films 121b-15 to 121b-17 and the light shielding films 121p-15 to 121p-17 may not be equal according to the position.

Further, as indicated at the lower stage in FIG. 10, the pixel 121a is configured including a photodiode 161 (corresponding to the photodiode 121e), a transfer transistor 162, a FD (Floating Diffusion: floating diffusion) section 163, a selection transistor 164, an amplification transistor 165 and a reset transistor 166 and is connected to a current source 168 through a vertical signal line 167.

The photodiode 161 is configured such that it is grounded at the anode electrode thereof and is connected at the cathode electrode thereof to the gate electrode of the amplification transistor 165 through the transfer transistor 162.

The transfer transistor 162 is driven in accordance with a transfer signal TG. For example, if the transfer signal TG supplied to the gate electrode of the transfer transistor 162 becomes the high level, then the transfer transistor 162 is turned on. Consequently, charge accumulated in the photodiode 161 is transferred to the FD section 163 through the transfer transistor 162.

The amplification transistor 165 serves as an inputting portion of a source follower that is a reading out circuit for reading out a signal obtained by photoelectric conversion by the photodiode 161 and outputs a pixel signal of a level according to the charge accumulated in the FD section 163 to a vertical signal line 23. In particular, the amplification transistor 165 is connected at the drain terminal thereof to a power supply voltage VDD and connected at the source terminal thereof to the vertical signal line 167 through the selection transistor 164 such that it cooperates with the current source 168 connected to one end of the vertical signal line 167 to configure a source follower.

The FD (Floating Diffusion: floating diffusion) section 163 is a floating diffusion region provided between the transfer transistor 162 and the amplification transistor 165 and having a capacitance C1 and temporarily accumulates charge transferred thereto from the photodiode 161 through the transfer transistor 162. The FD section 163 is a charge detection section for converting charge into a voltage, and charge accumulated in the FD section 163 is converted into a voltage by the amplification transistor 165.

The selection transistor 164 is driven in accordance with a selection signal SEL and is turned on if the selection signal SEL supplied to the gate electrode thereof changes to the high level to connect the amplification transistor 165 and the vertical signal line 167 to each other.

The reset transistor 166 is driven in accordance with a reset signal RST. For example, if the reset signal RST supplied to the gate electrode of the reset transistor 166 becomes the high level, the reset transistor 166 is turned on to discharge the charge accumulated in the FD section 163 to the power supply voltage VDD to reset the FD section 163.

By such a circuit configuration as described above, the pixel circuit depicted at the lower stage in FIG. 10 operates in the following manner.

In particular, as first operation, the reset transistor 166 and the transfer transistor 162 are turned on to discharge the charge accumulated in the FD section 163 to the power supply voltage VDD to reset the FD section 163.

As second operation, the reset transistor 166 and the transfer transistor 162 are turned off and enter an exposure period, within which charge according to the light amount of incident light is accumulated by the photodiode 161.

As third operation, the reset transistor 166 is turned on to reset the FD section 163, and then the reset transistor 166 is turned off. By this operation, the FD section 163 is reset to a reference potential.

As fourth operation, the potential of the FD section 163 in the reset state is outputted as a reference potential from the amplification transistor 165.

As fifth operation, the transfer transistor 162 is turned on and the charge accumulated in the photodiode 161 is transferred to the FD section 163.

As sixth operation, the potential of the FD section 163 to which the charge of the photodiode is transferred is outputted as a signal potential from the amplification transistor 165.

By the processes described above, the reference potential is subtracted from the signal potential and a resulting potential is outputted as a detection signal by CDS (correlated double sampling).

<Second Configuration Example of Directional Imaging Device>

(Side Elevational Section, Top Face and Circuit Configuration Example in Second Configuration Example of Directional Imaging Device)

FIG. 11 is a view depicting a side elevational sectional view, a top plan view and a view depicting a circuit configuration example of the directional imaging device 121 in a second configuration example. In particular, at an upper stage in FIG. 11, a side elevational sectional view of a pixel 121a of the directional imaging device 121 is depicted, and at a middle stage in FIG. 11, a top plan view of the pixel 121a is depicted. Further, the side elevational sectional view at the upper stage in FIG. 11 is a sectional view taken along line A-B of the middle stage in FIG. 11. Furthermore, a lower stage in FIG. 11 depicts a circuit configuration example of the directional imaging device 121.

As depicted in FIG. 11, the directional imaging device 121 has a configuration different from that of the directional imaging device 121 of FIG. 10 in that, in the pixel 121a, four photodiodes 121f-11s to 121f-4 and a light shielding film 121p is formed in a region in which it isolates the photodiodes 121f-11 to 121f-4 from each other. In particular, in the directional imaging device 121 of FIG. 11, the light shielding film 121p is formed in a "+" shape as viewed from above. It is to be noted that such common components are denoted by like reference signs and detailed description of them is omitted.

In the directional imaging device 121 configured in such a manner as depicted in FIG. 11, since the photodiodes 121f-1 to 121f-4 are isolated from each other by the light shielding film 121p, electric and optical crosstalk between the photodiodes 121f-1 to 121f-4 can be prevented. In other words, the light shielding film 121p of FIG. 11 is provided in order to prevent crosstalk similarly to the light shielding film 121p of the directional imaging device 121 of FIG. 10 but not in order to provide an incident angle directivity.

In the second configuration example of the directional imaging device 121 of FIG. 11, one FD section 163 is shared by the four photodiodes 121f-1 to 121f-4. A lower stage in FIG. 11 depicts a circuit configuration example in which the one FD section 163 is shared by the four photodiodes 121f-1 to 121f-4. It is to be noted that description of components at the lower stage in FIG. 11 same as those at the lower stage in FIG. 10 is omitted.

The circuit configuration at the lower stage in FIG. 11 is different from that at the lower stage in FIG. 10 is that, in place of the photodiode 161 (corresponding to the photodiodes 121e at the upper stage in FIG. 10) and the transfer transistor 162, photodiodes 161-1 to 161-4 (corresponding to the photodiodes 121f-1 to 121f-4 at the upper stage in FIG. 11) and transfer transistors 162-1 to 162-4 are provided such that they share the FD section 163.

By such a configuration as described above, charge accumulated in the photodiodes 121f-1 to 121f-4 is transferred to the common FD section 163 that is provided at a connection portion between the photodiodes 121f-1 to 121f-4 and the gate electrode of the amplification transistor 165. Then, a signal according to the level of the charge retained in the FD section 163 is read out as a detection signal of a pixel output unit.

Therefore, it is possible to cause charge accumulated in the photodiodes 121f-1 to 121f-4 to selectively contribute, in various combinations, to a detection signal of a pixel output unit (it is possible to make the degrees of contribution of the charge to a detection signal of a pixel output unit different from each other).

In particular, by configuring the photodiodes 121f-1 to 121f-4 such that charge can be read out independently of each other, different incident angle directivities can be provided to different pixel output units.

For example, in FIG. 11, if charge of the photodiode 121f-1 and the photodiode 121f-3 is transferred to the FD section 163, then by adding the signals obtained by reading out the charge, an incident angle directivity in the leftward or rightward direction can be obtained. Similarly, if charge of the photodiode 121f-1 and the photodiode 121f-2 is transferred to the FD section 163, then by adding the signals obtained by reading out the charge by the FD section 163, an incident angle directivity in the upward or downward direction can be obtained.

Further, in FIG. 11, if charge of the photodiode 121f-1 and the photodiode 121f-3 and charge of the photodiode 121f-1 and the photodiode 121f-4 are transferred to the FD section 163, then by the adding signals obtained by reading out the charge, an incident angle directivity in the leftward or rightward direction can be obtained. Similarly, if charge of the photodiode 121f-1 and the photodiode 121f-2 and charge of the photodiode 121f-3 and the photodiode 121f-4 are transferred simultaneously to the FD section 163, then the FD section 163 can obtain an incident angle directivity in the upward or downward direction by adding the signals obtained by reading out the charge.

Further, a signal obtained on the basis of charge independently and selectively read out from the four photodiodes 121f-1 to 121f-4 becomes a detection signal of one-pixel output unit corresponding to one pixel configuring the detection image.

As described above, in the case of the directional imaging device 121 of FIG. 11, by changing the combination of charge of the four photodiodes 121f-1 to 121f-4 to be adopted for a detection signal, incident angle directivities different among different pixels can be obtained.

In the directional imaging device 121 of FIG. 10, one photodiode 121e is provided for one-pixel output unit. By making the state of light blocking by the light shielding film 121p of each pixel (pixel output unit) different for each pixel unit, the incident angle directivity can made different for each pixel.

In the directional imaging device 121 of FIG. 11, the four photodiodes 121f-1 to 121f-4 are provided for one-pixel output unit. By making, from among the four photodiodes 121f-1 to 121f-4, the photodiodes 121f, which contribute to a detection signal, different for each pixel output unit, an incident angle directivity different for each pixel output unit can be provided. The degree of contribution can be implemented depending upon whether or not a detection value of each photodiode 121f is to be read out to a FD (floating diffusion) or by resetting a detection value (charge) accumulated in the photodiodes 121f before reading out of charge to the FD using an electronic shutter function. It is to be noted that, in the case where the electronic shutter function is used, if the charge is reset immediately before reading out of charge of a photodiode 121f into the FD, then the photodiode 121f can be placed into a state in which it does not contribute to a pixel output unit, and if a period of time is provided between points of time of resetting and reading out to the FD, also it is possible to cause the photodiode 121f to partially contribute to the pixel output unit.

In other words, the photodiode 121e of FIG. 10 and the photodiode 121f of FIG. 11 are different in a manner in which signals detected thereby are used. In particular, a signal detected by the photodiode 121e of FIG. 10 is a signal detected by the photodiodes 121e-15 and 121e-16 and is a detection signal for one-pixel output unit of the pixels 121a-15 and 121a-16, which configure a detection image.

In contrast, signals detected by the photodiodes 121f of FIG. 11 become detection signals for one-pixel output unit configuring a detection image through selective use of four signals of the photodiodes 121f-11 to 121f-4.

This is because the pixel 121a of FIG. 10 are configured such that one photodiode 121e is provided for one pixel 121a and a range different for each pixel 121a is shielded by the light shielding film 121b and, by optical modulation using the light shielding film 121b, a detection signal for one pixel of a detection image having an incident angle directivity can be represented by one pixel 121a.

In contrast, in the case of the pixel 121a of FIG. 11, the four photodiodes 121f are provided for one pixel 121a, and the light shielding film 121b is not formed for the light receiving face of the pixel 121a. However, the pixel 121a is divided into a plurality of regions by the light shielding film 121p and four photodiodes 121f-1 to 121f-4 are provided to represent a detection signal for one pixel of a detection image having an incident angle directivity. In other words, for example, a region of the photodiodes 121f-11 to 121f-14, which does not contribute to an output functions similarly to a light shielding region and represents a detection signal for one pixel of a detection image, which has an incident angle directivity. It is to be noted that, in the case where the photodiodes 121f-1 1 to 121f-14 are used to represent a detection signal for one pixel, since the light shielding film 121b is not used, the detection signal is not a signal obtained by optical modulation.

Thus, a configuration by at least one or more photodiodes 121e or 121f for outputting a detection signal of one pixel 121a of a detection image to be outputted from the directional imaging device 121 is referred to as one-pixel output unit. In particular, in the case of the directional imaging device 121 of FIG. 10, the one-pixel output unit is configured from one photodiode 121e. Meanwhile, in the case of the directional imaging device 121 of FIG. 11, the one-pixel output unit is configured from the four photodiodes 121f-1 to 121f-4.

It is to be noted that, while, in the directional imaging device 121 of FIG. 11, the four photodiodes 121f-1 to 121f-4 are formed in a same shape for each pixel output unit and are disposed divisionally with an equal area, the photodiodes 121f-1 to 121f-4 may have dividing positions so as to be different in shape for each pixel output unit and different in area from each other. Even if only the left upper photodiode 121f-1 is used similarly in a plurality of pixel output units by setting the dividing positions of the four photodiodes 121f-1 to 121f-4 so as to be different in shape and different in area from each other, the incident angle directivity can be made different. Further, if the division number is made different among different pixel output units, then it becomes possible to set the incident angle directivity more freely. Furthermore, the matters described above may be combined.

<Principle of Generating Incident Angle Directivity>

The incident angle directivity of each pixel in the directional imaging device 121 is generated, for example, by such a principle as depicted in FIG. 12. It is to be noted that a left upper portion and a right upper portion of FIG. 12 are views illustrating a generation principle of an incident angle directivity in the directional imaging device 121 of FIG. 10, and a left lower portion and a right lower portion of FIG. 12 are views illustrating a generation principle of an incident angle directivity in the directional imaging device 121 of FIG. 11.

Further, each of the one-pixel output units in the left upper portion and the right upper portion of FIG. 12 is configured from a single photodiode 121e. In contrast, each of the one-pixel output units in the left lower portion and the right lower portion of FIG. 12 is configured from two photodiodes 121f. It is to be noted that, although an example in which a one pixel output unit is configured from two photodiodes 121f is described here, this is for the convenience of description, and the number of photodiodes 121f that configure a one-pixel output unit may be any other number.

In particular, in the left upper portion of FIG. 12, a light shielding film 121b-11 is formed such that it shields, when incident light enters downwardly from above in FIG. 12, the right half of the light receiving face of a photodiode 121e-11. Meanwhile, in the right upper portion of FIG. 12, a light shielding film 121b-12 is formed such that it shields the left half of the light receiving face of a photodiode 121e-12. It is to be noted that a dash-dotted line in FIG. 12 indicates the center position in the horizontal direction in FIG. 12 of the light receiving face of the photodiode 121e and represents a vertical direction with respect to the light receiving face.

For example, in such a configuration as in the left upper portion of FIG. 12, although incident light from the right upper direction in FIG. 12 indicated by an arrow mark having an incident angle $\theta1$ with respect to the dash-dotted line in FIG. 12 is liable to be received within the left half range that is not shielded by the light shielding film 121b-1 1 of the photodiode 121e-11, incident light from the left upper direction in FIG. 12 indicated by an arrow mark having an incident angle $\theta2$ with respect to the dash-dotted line in FIG. 12 is less liable to be received within the left half region that is not shielded by the light shielding film 121b-1 1 of the photodiode 121e-11. Accordingly, such a configuration as in the left upper portion of FIG. 12 has such an incident angle directivity that the light receiving sensitivity characteristic with respect to incident light from the right upper direction in FIG. 12 is high and the light receiving sensitivity characteristic with respect to incident light from the left upper direction is low.

On the other hand, for example, in such a configuration as in the right upper portion of FIG. 12, although incident light from the left upper direction in FIG. 12 indicated by an arrow mark having an incident angle $\theta11$ with respect to the dash-dotted line in FIG. 12 is less liable to be received within the left half range that is shielded by the light shielding film 121b-12 of the photodiode 121e-12, incident light from the left upper direction in FIG. 12 indicated by an arrow mark having an incident angle $\theta12$ with respect to the dash-dotted line in FIG. 12 is liable to be received within the right half region that is not shielded by the light shielding film 121b-12 of the photodiode 121e-12. Accordingly, such a configuration as in the right upper portion of FIG. 12 has such an incident angle directivity that the light receiving sensitivity characteristic with respect to incident light from the right upper direction in the figure is low and the light receiving sensitivity characteristic with respect to incident light from the left upper direction is high.

Meanwhile, in the case of the left lower portion of FIG. 12, the photodiodes 121f-1 and 121f-2 are provided at left and right positions in FIG. 12, and by reading out a detection signal of one of them, an incident angle directivity is provided without the provision of the light shielding film 121b.

In particular, in the case where the two photodiodes 121f-1 and 121f-2 are determined as a pixel output unit and configure a pixel 121a as indicated by the left lower portion of FIG. 12, by reading out the detection signal of the photodiode 121f-1 provided on the left side in FIG. 12, an incident angle directivity can be provided similarly as in the configuration in the left upper portion of FIG. 12. In particular, incident light from the right upper direction in FIG. 12 indicated by an arrow mark that defines an incident angle θ21 with respect to the dash-dotted line in FIG. 12 enters and received by and read out from the photodiode 121f-1. In contrast, although incident light enters the photodiode 121f-2 from the left upper direction in FIG. 12 indicated by an arrow mark that defines an incident angle θ22 with respect to the dash-dotted line in FIG. 12, the signal does not contribute to a pixel output unit.

Similarly, in the case where a pixel 121a including the two photodiodes 121f-1 1 and 121f-12 is determined as a one-pixel output unit as indicated by the right lower portion of FIG. 12, by causing the detection signal of the photodiode 121f-12 provided on the left side in FIG. 12 to contribute to a pixel output unit, an incident angle directivity can be provided similarly as in the configuration in the right upper portion of FIG. 12. In particular, although incident light enters the photodiode 121f-11 from the right upper direction in FIG. 12 indicated by an arrow mark that defines an incident angle θ31 with respect to the dash-dotted line in FIG. 12 enters, it does not contribute to a pixel output unit. In contrast, incident light from the left upper direction in FIG. 12 indicated by an arrow mark that defines an incident angle θ32 with respect to the dash-dotted line in the figure enters the photodiode 121f-12 and contributes to an output image unit. It is to be noted that, while an example in which the dash-dotted line in the vertical direction indicates the center position in the horizontal direction in FIG. 12 of the light receiving face of the photodiode 121e is depicted, this is for the convenience of description, and the dash-dotted line in the vertical direction may indicate any other position. By making the position in the horizontal direction of the light shielding film 121b indicated by the dash-dotted line in the vertical direction different, a different incident angle directivity can be provided.

<Incident Angle Directivity in Configuration Including On-Chip Lens>

While the foregoing description is directed to the generation principle of an incident angle directivity by the light shielding film 121b and the generation principle of an incident angle directivity by a plurality of photodiodes 12f, here, an incident angle directivity in a configuration including an on-chip lens 121c is described.

In particular, the incident angle directivity of each pixel in the directional imaging device 121 is set, for example, in such a manner as depicted in FIG. 13 by using the on-chip lens 121c in addition to that by the light shielding film 121b described hereinabove. In particular, in a left portion at a middle stage of FIG. 13, an on-chip lens 121c-11 that condenses incident light, a color filter 121d-11 that passes light of a predetermined wavelength and a photodiode 121e-11 for generating a pixel signal by photoelectric conversion are stacked in this order from an incident direction from above in FIG. 13, and in a right portion at a middle stage in FIG. 13, an on-chip lens 121c-12, a color filter 121d-12 and a photodiode 121e-12 are configured in this order from an incident direction from above in the figure.

It is to be noted that, in the case where there is no necessity to distinguish each of the on-chip lenses 121c-11 and 121c-12, color filters 121d-11 and 121d-12 and photodiodes 121e-11 and 121e-12, they are referred to merely as on-chip lens 121c, color filter 121d and photodiode 121e, respectively.

In the directional imaging device 121, light shielding films 121b-1 1 and 121b-12 for shielding part of a region for receiving incident light are provided as indicated in a left portion at the middle stage and a right portion at the middle stage in FIG. 13, respectively.

In the case where such a light shielding film 121b-1 1 as shields the right side half of the photodiode 121e-11 in FIG. 13 as indicated in the left portion at the middle stage in FIG. 13, the detection signal level of the photodiode 121e-11 varies in response to the incident angle θ of the incident light as indicated by a waveform of a solid line at an upper stage in FIG. 13.

In particular, if the incident angle θ that is an angle defined by incident light with respect to dash-dotted lines that indicate the center positions of the photodiode 121e and the on-chip lens 121c and are perpendicular to the photodiode 121e and the on-chip lens 121c (as the incident angle θ increases in the positive direction (as the incident angle θ is inclined in the rightward direction in FIG. 13)), since light is condensed to a range in which the light shielding film 121b-1 1 is not provided, the detection signal level of the photodiode 121e-11 becomes high. On the contrary, as the incident angle θ decreases (as the incident angle θ increases in the negative direction (as the incident angle θ is inclined to the leftward direction in FIG. 13)), since light is condensed to the region in which the light shielding film 121b-11 is provided, the detection signal level of the photodiode 121e-11 decreases.

It is to be noted that the incident angle θ here is defined such that it has 0 degree in the case where the direction of incident light coincides with the dash-dotted line, and the incident angle θ at which incident light enters from the right upper direction in the figure, on the incident angle θ21 side on the left side at the middle stage of FIG. 13 has a positive value while the incident angle θ on the incident angle θ22 side on the right side at the middle stage in FIG. 13 has a negative value. Accordingly, in FIG. 13, incident light entering the on-chip lens 121c from the right upper direction has an incident angle greater than that of incident light that enters from the left upper direction. In particular, in FIG. 13, the incident angle θ increases as the advancing direction of incident light is inclined to the right (increases in the positive direction) but decreases as the advancing direction of incident light is inclined to the left (increases in the negative direction).

On the other hand, in the case where such a light shielding film 121b-12 as shields the left side half of the photodiode 121e-12 in FIG. 13 as indicated in the right portion at the middle stage in FIG. 13, the detection signal level of the photodiode 121e-12 varies in response to the incident angle θ of incident light as indicated by a waveform of a broken line at the upper stage in FIG. 13.

In particular, as indicated by a waveform of a broken line at the upper stage in FIG. 13, if the incident angle θ that is an angle defined by incident light with respect to the dash-dotted line that indicates the center position of the photodiode 121e and the on-chip lens 121c and is perpendicular to the photodiode 121e and the on-chip lens 121c (as the incident angle θ increases in the positive direction), then since light is condensed to a range in which the light shielding film 121b-12 is provided, the detection signal level of the photodiode 121e-12 becomes low. On the contrary, as the incident angle θ decreases (as the incident angle θ increases in the negative direction), since light enters the range in which the light shielding film 121b-12 is not provided, the detection signal level of the photodiode 121e-12 increases.

It is to be noted that, at the upper stage in FIG. 13, the axis of abscissa indicates the incident angle θ and the axis of ordinate indicates the detection signal level by the photodiode 121e.

Since the waveforms indicated by a solid line and a broken line indicative of the detection signal levels according to the incident angle θ indicated at the upper stage in FIG. 13 can be changed in response to the range of the light shielding film 121b, it is possible to provide incident angles different from each other to different pixel output units. It is to be noted that the waveform of a solid line at the upper stage in FIG. 13 corresponds to an arrow mark of a solid line indicative of a manner in which incident light in the left portion at the middle stage and the left portion at the lower stage in FIG. 13. Meanwhile, the waveform of a broken line at the upper stage in FIG. 13 corresponds to an arrow mark of a broken line indicative of a manner in which incident light in the right portion at the middle stage and the right portion at the lower stage in FIG. 13.

Although the incident angle directivity is a characteristic (light receiving sensitivity characteristic) of the detection signal level of each pixel output unit according to the incident angle θ, in regard to the example at the middle stage of FIG. 13, it can be regarded as a characteristic of a light blocking value according to the incident angle θ. In particular, although the light shielding film 121b blocks incident light in a particular direction with a high level, it cannot sufficiently block incident light from any other direction than the particular direction. The variation of the level with which incident light can be blocked generates such a different detection signal level according to the incident angle θ as indicated at the upper stage in FIG. 13. Accordingly, if the direction in which incident light can be blocked with the highest level for each pixel output unit is defined as the light blocking direction of the pixel, then that different pixel output units have incident angle directivities different from each other is, in other words, that pixel output units have light blocking directions different from each other.

Further, by adopting the structure in which two photodiodes 121f-1 and 121f-2 are provided for one on-chip lens 121c-11 as indicated in the left portion at the lower stage in FIG. 13 (a pixel output unit is configured from two photodiodes 121f-1 and 121f-2), if a detection signal only of the photodiode 121f-1 in the left portion in FIG. 13 is used, a detection signal level equal to that in the state in which the right side of the photodiode 121e-11 in the left portion at the middle stage in FIG. 13 is shielded can be determined.

In particular, if the incident angle θ that is an angle defined by incident light with respect to the dash-dotted line perpendicular to the directional imaging device 121 at the center position of the on-chip lens 121c increases (if the incident angle θ increases in the positive direction), then the incident light is condensed to the range of the photodiode 121f-1 from which the detection signal is to be read out, and consequently, the detection level becomes high. On the contrary, as the incident angle θ decreases (as the incident angle θ increases in the negative direction), since light is condensed to the range of the photodiode 121f-2 from which the detection signal is not to be read out, the detection signal level decreases.

Similarly, by adopting the structure in which two photodiodes 121f-11 and 121f-12 are provided for one on-chip lens 121c-12 as indicated in the right portion at the lower stage in FIG. 13, if a detection signal only of the photodiode 121f-12 in the right portion in FIG. 13 is used, then a detection signal level of the pixel output unit equal to that in the state in which the left side of the photodiode 121e-12 in the right portion at the middle stage in FIG. 13 is shielded can be determined.

In particular, if the incident angle θ that is an angle defined by incident light with respect to the dash-dotted line perpendicular to the on-chip lens 121c at the center position of the on-chip lens 121c increases (if the incident angle θ increases in the positive direction), then since light is condensed to the range of the photodiode 121f-1 1 in which the detection signal does not contribute to the detection signal of a pixel output unit, the detection level of the detection signal of a pixel output unit becomes low. On the contrary, as the incident angle θ decreases (as the incident angle θ increases in the negative direction), since light is condensed to the range of the photodiode 121f-12 in which the detection signal contributes to the detection signal of the pixel output unit, the detection signal level of the detection signal of the pixel output unit increases.

It is to be noted that the incident angle directivity preferably has a high degree of randomness. This is because, for example, if neighboring pixels have a same incident angle directivity, then there is the possibility that the expressions (1) to (3) given hereinabove or expressions (14) to (16) given hereinbelow may become a mutually same expression, resulting in failure in satisfaction of a relationship between the number of unknown numbers as solutions to simultaneous equations and the number of equations and resulting in the possibility that it may become impossible to determine pixel values configuring a restoration image. Further, in the configuration indicated at the upper stage of FIG. 13, a one-pixel output unit is configured from each the photodiode 121e-1 and 121e-2. In the configuration indicated at the lower stage of FIG. 13, a one-pixel output unit is configured from the two photodiodes 121f-1 and 121f-2 and the photodiodes 121f-1 1 and 121f-12. Accordingly, for example, at the lower stage of FIG. 13, the photodiodes 121f itself does not configure a one-pixel output unit.

Further, in the case where a one-pixel output unit is configured from a plurality of photodiodes 121f as indicated at the lower stage of FIG. 12, it can be regarded that the output pixel value of a pixel output unit is modulated in response to the incident angle. Accordingly, it becomes possible to make a characteristic of an output pixel value (incident angle directivity) different among different pixel output units, and an incident angle directivity in a one-pixel output unit is set. Further, in the case where a one-pixel output unit is configured from a plurality of photodiodes 121f, in order to generate an incident angle directivity in a one-pixel output unit, one on-chip lens 121c for a one-pixel output unit is an essential configuration.

Further, in the case where one photodiode 121e-11 or one photodiode 121e-12 configures one-pixel output unit as indicated by the upper stage in FIG. 13, since incident light to the one photodiode 121e-11 or photodiode 121e-12 configuring the one-pixel output unit is modulated in response to the incident angle, the output pixel value is modulated. Accordingly, it becomes possible to make a characteristic of an output pixel value (incident angle directivity) different, and an incident angle directivity in a one-pixel output unit is set. Further, in the case where one photodiode 121e-11 or photodiode 121e-12 configures a one-pixel output unit, the incident angle directivity is set independently by the light shielding film 121b provided for each one-pixel output unit upon fabrication.

Further, in the case where one-pixel output unit is configured from a plurality of photodiodes 121f as indicated by the lower stage in FIG. 13, the number of plural photodiodes 121f for setting an incident angle directivity for each one-pixel output unit (division number of a photodiode 121f configuring a one-pixel output unit) or the division number is set independently of each one-pixel output unit upon fabrication. Further, which photodiodes 121f is used among them to set an incident angle directivity can be switched upon imaging.

<Setting of Incident Angle Directivity>

For example, as indicated by an upper stage in FIG. 14, the setting range of the light shielding film 121b is determined, in regard to the horizontal direction of the pixel 121a, as a range from the left end portion to a position A, and in regard to the vertical direction, as a range from the upper end portion to a position B.

In this case, a weight Wx of 0 to 1 in the horizontal direction, which becomes an index to the incident angle directivity, according to the incident angle θx (degrees) from the center position in the horizontal direction of each pixel is set. More particularly, in the case where it is assumed that the weight Wx becomes 0.5 at the incident angle θx = θa corresponding to the position A, the weight Wh is set such that, at the incident angle θx < θa - α, the weight Wx becomes 1; where θa - α ≤ incident angle θx ≤ θa + α, the weight Wx becomes (-(θx - θa)/2α + 1/2); and at the incident angle θx > θa + α, the weight Wx becomes 0. It is to be noted that, also an example in which the weight Wh becomes 0, 0.5 and 1 is described here, the weight Wh becomes 0, 0.5 or 1 when an ideal condition is satisfied.

Similarly, a weight Wy of 0 to 1 in the vertical direction, which becomes an index to the incident angle directivity, according to the incident angle θy (degrees) from the center position in the vertical direction of each pixel is set. More particularly, in the case where it is assumed that the weight Wy becomes 0.5 at the incident angle θy = θb corresponding to the position B, the weight Wy is set such that, at the incident angle θy < θb - α, the weight Wy becomes 0; where θb - α ≤ incident angle θy ≤ θb + α, the weight Wy becomes (-(θy - θb)/2α + 1/2); and at the incident angle θy > θb + α, the weight Wy becomes 0.

Then, by using the weights Wx and Wy determined in this manner, the incident angle directivity of each pixel 121a, namely, a coefficient corresponding to the light receiving sensitivity characteristic, can be determined.

Further, at this time, the inclination (1/2α) indicative of a variation of the weight within a range within which the weight Wx in the horizontal direction and the weight Wy in the vertical direction vary across 0.5 can be set by using the on-chip lenses 121c at different focal lengths.

In particular, by using the on-chip lenses 121c of different curvatures, different focal lengths can be obtained.

For example, by using the on-chip lenses 121c having different curvatures, when light is condensed by the focal length such that the focus comes to the light shielding film 121b as indicated by a solid line at the lower stage in FIG. 14, the inclination ($1/2\alpha$) is steep. In particular, the weight Wx in the horizontal direction and the weight Wy in the vertical direction at the upper stage in FIG. 14 abruptly change to 0 or 1 at the incident angle $\theta x$ in the horizontal direction = $\theta a$ at which the weight Wx is around 0.5 and in the proximity of the boundary of the incident angle $\theta y$ in the vertical direction = $\theta b$.

Further, by using the on-chip lenses 121c having different curvatures, when light is condensed by the focal length such that the focus comes to the photodiode 121e as indicated by a broken line at the lower stage in FIG. 14, the inclination ($1/2\alpha$) is gentle. In particular, the weight Wx in the horizontal direction and the weight Wy in the vertical direction at the upper stage in FIG. 14 gently change to 0 or 1 at the incident angle $\theta x$ in the horizontal direction = $\theta a$ at which the weight Wx is around 0.5 and in the proximity of the boundary of the incident angle $\theta y$ in the vertical direction = $\theta b$.

As described above, by using the on-chip lenses 121c having different curvatures with the on-chip lenses 121c set to different focal lengths, different incident angle directivities, namely, different light receiving sensitivity characteristics, can be obtained.

Accordingly, the incident angle directivities of the pixels 121a can be set to different values by making the range within which the photodiode 121e is to be shielded by the light shielding film 121b and the curvature of the on-chip lens 121c different. It is to be noted that the curvature of the on-chip lens may be equal in all pixel output units in the directional imaging device 121 or may be different in part of the pixel output units.

<Difference between On-Chip Lens and Imaging Lens>

Although the directional imaging device 121 in the imaging apparatus 101 of the present disclosure is configured such that the optical block 152 configured from an imaging lens is not required, the on-chip lens 121c is sometimes provided. It is to be noted that, in the case of the configuration of FIG. 11, the on-chip lens 121c is an essentially required component. The on-chip lens 121c and the imaging lens are different in physical action.

Here, description is given assuming that the optical block 152 is an imaging lens 152.

As depicted in FIG. 15, when light emitted from a point light source P101 enters in a spreading manner to the imaging lens 152, for the imaging lens 152, a pixel position P111 at which an image is formed on the imaging device 151 is specified by a principal ray L101 that passes the point light source P101 and the center 152a of the imaging lens 152.

At this time, the imaging lens 152 is designed such that, from within light emitted from the point light source P101, light that enters the optical block 152 at an incident angle different from that of the principal ray L101 due to spreading of the light can be condensed at the pixel position P111 on the imaging device 151.

Further, as depicted in FIG. 16, for example, a pixel position P112 neighboring with the pixel position P111 is specified by a principal ray L102 that passes a point light source P102 different from the point light source P101 and the center position 152a of the imaging lens 152.

Accordingly, the imaging lens 152 forms images of the different point light sources P101 and P102 having different rays from each other at the pixel positions P111 and P1121 different from each other on the imaging device 151.

Further, as depicted in FIG. 17, in the case where entering of infinity light is assumed, since the incident infinity light is parallel light, it can be considered that it is, for example, parallel rays L121 and L122 with respect to the principal ray L101 where the point light source P101 is assumed. Accordingly, the imaging lens 152 forms images of point light sources whose principal ray incident angles are different from each other at different pixel positions on the imaging device 151.

In other words, the imaging lens 152 has a condensing mechanism for allowing diffused light rays having different principal ray incident angles to enter a plurality of pixel output units neighboring with each other.

In contrast, as described hereinabove with reference, for example, to FIGS. 10 and 11, light passing through the on-chip lens 121c enters only the light receiving face of the photodiode 121e or photodiode 121f configuring a corresponding one-pixel output unit. In other words, the on-chip lens 121c is provided for each pixel output unit and condenses object light entering itself only upon a corresponding pixel output unit. In particular, the on-chip lens 121c does not have a condensing mechanism for causing diffused light emitted from a virtual point light source to enter a plurality of pixel output units neighboring with each other.

<Example of Calculation of Pixel Value Using Simultaneous Equations Including Coefficient Set and Detection Signal>

An example of particular calculation of a pixel value using simultaneous equations including a coefficient set and a detection signal, which is executed by the signal processing section 122, is described.

Here, it is assumed that the object plane 31 has 3 regions $\times$ 3 regions, namely, totaling nine regions, and the regions are configured from regions O11 to 013, 021 to O23 and 031 to O33 as indicated at an upper stage in FIG. 18.

Further, a representative point is set in each region (a round mark in the figure), and it is assumed that a point light source having an integrated value of a light intensity of the region exists at this representative point. Accordingly, in the description given below, the light intensities of the point light sources of the regions O11 to 013, 021 to O23 and 031 to O33 are referred to also as light intensities O11 to 013, 021 to O23 and 031 to O33. Further, each of them is referred to also merely as region Oij or light intensity Oij (i and j = 1, 2, 3).

Further, it is assumed that the directional imaging device 121 is configured from totaling nine pixels of 3 pixels × 3 pixels as depicted at a lower stage in FIG. 18 and light shielding films 121b different among different pixels are provided. Further, the pixels are referred to as pixels P11 to P13, P21 to P23 and P31 to P33, and also detection signal levels of the pixels are referred to as pixels P11 to P13, P21 to P23 and P31 to P33. Further, they are referred to merely as pixels Pij (i, j = 1, 2, 3).

It is to be noted that, in the description of FIGS. 18 and 20 to 32, the light shielding film 121b is included within a range of the pixel Pij (i, j = 1, 2, 3) indicated by gray and the reference sign of the light shielding film 121b is omitted.

Further, for example, in the case where point light sources G1 to G3 positioned at infinity are assumed as depicted in FIG. 19, as light incident to the directional imaging device 121, incident light from the point light sources G1 to G3 is parallel light as viewed in a perpendicular direction to the light receiving face of the directional imaging device 121 at a lower portion in FIG. 19, and light emitted from a same point light source can be regarded as entering at an equal incident angle to a pixel at any position of the directional imaging device 121. Accordingly, for example, light from the point light source G2 is incident at the incident angle of 0 degree to a pixel at any position of the directional imaging device 121.

<Incident Angle to Each Pixel of Directional Imaging Device in Each Region of Object Plane>

Further, it is assumed that the incident angle (θx, θy) to the directional imaging device 121 in each region Oij of the object plane 31 is defined as depicted in FIG. 20 independently of the position of the pixel Pij of the directional imaging device 121.

In particular, to the region O11, (θx, θy) = (-5 deg, +5 deg); to the region O12, (θx, θy) = (-5 deg, 0 deg); and to the region 013, (θx, θy) = (-5 deg, -5 deg). Similarly, to the region 021, (θx, θy) = (0 deg, +5 deg); to the region O22, (θx, θy) = (0 deg, 0 deg); and to the region O23, (θx, θy) = (0 deg, -5 deg). Further, to the region 031, (θx, θy) = (+5 deg, +5 deg); to the region O32, (θx, θy) = (+5 deg, 0 deg); and to the region O33, (θx, θy) = (+5 deg, -5 deg).

<Light Receiving Sensitivity Characteristic in Vertical Direction>

As depicted in FIG. 21, 3 pixels of the pixels P11, P21 and P31, 3 pixels of pixels P12, P22 and P32 and 3 pixels of pixels P13, P23 and P33 are unified in height of the light shielding film 121b in the perpendicular direction to the plane of the figure.

More particularly, in the three pixels of the pixels P11, P21 and P31, a region of the height A1 from an upper end of each pixel is a region shielded by the light shielding film 121b while the remaining region having a height A2 is a region that is not shielded.

Further, in the three pixels of the pixels P12, P22 and P32, a region of the height A11 from an upper end of each pixel is a region not shielded while the remaining region having a height A12 is a region that is shielded by the light shielding film 121b.

Furthermore, in the three pixels of the pixels P13, P23 and P33, a region of the height A21 from an upper end of each pixel is a region not shielded while the remaining region having a height A22 is a region that is shielded by the light shielding film 121b.

Therefore, the three pixels of the pixels P11, P21 and P31, three pixels of the pixels P12, P22 and P32 and three pixels of the pixels P13, P23 and P33 are unified in terms of the light receiving sensitivity characteristic in the vertical direction.

In particular, in regard to the three pixels of the pixels P11, P21 and P31, as depicted in the right upper portion in FIG. 21, in the case where the incident angle θy in the vertical direction is smaller than - 6 deg, the weight Wy is set to 0; in the case where the incident angle θy is -6 deg to -4 deg, the weight Wy is set to (θy + 6)/2; and in the case where the incident angle θy is greater than -4 deg, the weight Wy is set to 1.

Meanwhile, in regard to the three pixels of the pixels P12, P22 and P32, as depicted in the right middle portion in FIG. 21, in the case where the incident angle θy in the vertical direction is smaller than -1 deg, the weight Wy is set to 1; in the case where the incident angle θy is set to -1 deg to +1 deg, the weight Wy is (θy - 1)/2; and in the case where the incident angle θy is greater than +1 deg, the weight Wy is set to 0.

Furthermore, in regard to the three pixels of the pixels P13, P23 and P33, as depicted in the right lower portion in FIG. 21, in the case where the incident angle θy in the vertical direction is smaller than +3 deg, the weight Wy is set to 1; in the case where the incident angle θy is +3 deg to +5 deg, the weight Wy is set to (-(θy - 5)/2); and in the case where the incident angle θy is greater than + deg, the weight Wy is set to 0.

<Light Receiving Sensitivity Characteristic in Horizontal Direction>

As depicted in FIG. 22, 3 pixels of the pixels P11 to P13, 3 pixels of pixels P21 to P23 and 3 pixels of pixels P31 to P33 are unified in width of the light shielding film 121b in the horizontal direction.

More particularly, in the three pixels of the pixels P11 to P13, a region of a width B1 from a left end of each pixel is a region shielded by the light shielding film 121b while the remaining region having a width B2 is a region that is not shielded.

Further, in the three pixels of the pixels P21 to P23, a region of a width B11 from a left end of each pixel is a region not shielded while the remaining region having a width B12 is a region that is shielded by the light shielding film 121b.

Furthermore, in the three pixels of the pixels P31 to P33, a region of a width B21 from a left end of each pixel is a region not shielded while the remaining region having a width B22 is a region that is shielded by the light shielding film 121b.

Therefore, the three pixels of the pixels P11 to P13, three pixels of the pixels P21 to P23 and three pixels of the pixels P31 to P33 are unified in terms of the light receiving sensitivity characteristic in the horizontal direction.

In particular, in regard to the three pixels of the pixels P11 to P13, as depicted in a left lower portion in FIG. 22, in the case where the incident angle θx in the horizontal direction is smaller than 4 deg, the weight Wx is set 1; in the case where the incident angle θx is 4 deg to 6 deg, the weight Wx is set to (-(θx - 6)/2); and in the case where the incident angle θx is greater than 6 deg, the weight Wx is set to 0.

Meanwhile, in regard to the three pixels of the pixels P21 to P23, as depicted in the middle lower portion in FIG. 22, in the case where the incident angle θx in the horizontal direction is smaller than -1 deg, the weight Wx is set to 0; in the case where the incident angle θx is -1 deg to +1 deg, the weight Wx is set to (θx + 1)/2; and in the case where the incident angle θx is greater than -3 deg, the weight Wx is set to 1.

Furthermore, in regard to the three pixels of the pixels P31 to P33, as depicted in the right lower portion in FIG. 22, in the case where the incident angle θx in the horizontal direction is smaller than -5 deg, the weight Wx is set 0; in the case where the incident angle θy is -5 dg to -3 deg, the weight Wx is set to (θx + 5)/2; and in the case where the incident angle θx is greater than -3 deg, the weight Wx is set to 1.

As a result, the detection signal level of the pixels P11 to P13, P21 to P23 and P31 to P33 of the directional imaging device 121 is represented with a pixel Pij (i, j = 1, 2, 3), it is represented by the following expression (4).

$$Pij = \Sigma(Wx(\theta xj) \times Wy(\theta yi) \times Oij) \quad \dots (4)$$

Here, Wx(θxj) is the weight in the horizontal direction for the incident angle θx to the jth pixel in the horizontal direction of the directional imaging device 121, and Wy(θyi) is the weight in the vertical direction for the ith incident angle θy in the vertical direction of the directional imaging device 121. Further, Oij is the light intensity of a point light source configured from a representative point in each region of the object plane 31.

In particular, if the incident angles θx and θy are restricted to -5, 0 and +5 degrees from the relationships of FIGS. 21 and 22, then the weights Wx and Wy assume such values as depicted in FIG. 23 for the pixels Pij.

In particular, in the pixels P11, P21 and P31 (pixels Pij (j = 1)), in the case where the incident angle θy in the vertical direction is +5 deg, the weight Wy is 1; in the case where the incident angle θy in the vertical direction is 0 deg, the weight Wy is 1; and in the case where the incident angle θy in the vertical direction is -5 deg, the weight Wy is 0.5.

In the pixels P12, P22 and P32 (pixels Pij (j = 2)), in the case where the incident angle θy in the vertical direction is +5 deg, the weight Wy is 0; in the case where the incident angle θy in the vertical direction is 0 deg, the weight Wy is 0.5; and in the case where the incident angle θy in the vertical direction is -5 deg, the weight Wy is 1.

In the pixels P13, P23 and P33 (pixels Pij (j = 3)), in the case where the incident angle θy in the vertical direction is +5 deg, the weight Wy is 0; in the case where the incident angle θy in the vertical direction is 0 deg, the weight Wy is 1; and in the case where the incident angle θy in the vertical direction is -5 deg, the weight Wy is 1.

In the pixels P11 to P13 (pixels Pij (i = 1)), in the case where the incident angle θx in the horizontal direction is +5 deg, the weight Wx is 0.5; in the case where the incident angle θx in the horizontal direction is 0 deg, the weight Wx is 1; and in the case where the incident angle θx in the horizontal direction is -5 deg, the weight Wx is 1.

In the pixels P21 to P23 (pixels Pij (i = 2)), in the case where the incident angle θx in the horizontal direction is +5 deg, the weight Wx is 1; in the case where the incident angle θx in the horizontal direction is 0 deg, the weight Wx is 0.5; and in the case where the incident angle θx in the horizontal direction is -5 deg, the weight Wx is 0.

In the pixels P31 to P33 (pixels Pij (i = 3)), in the case where the incident angle θx in the horizontal direction is +5 deg, the weight Wx is 1; in the case where the incident angle θx in the horizontal direction is 0 deg, the weight Wx is 1; and in the case where the incident angle θx in the horizontal direction is -5 deg, the weight Wx is 0.

As a signal of what detection signal level incident light from a representative point of each region Oij is received by each pixel Pij of the directional imaging device 121 on the basis of such conditions as described above is described.

(Region O11)

Incident light from a point light source at the representative point in the region O11 enters all pixels Pij at the incident angle θx = -5 deg in the horizontal direction and at the incident angle θy = +5 deg in the vertical direction.

Therefore, as depicted in FIG. 24, at the pixel P11, since the weight Wx in the horizontal direction is 1 and the weight Wy in the vertical direction is 1, Wx × Wy is 1.

It is to be noted that, in FIGS. 24 to 32, the selected weights Wx and Wy are indicated by a frame added thereto, and in the pixel Pij, the selected weight Wx in the horizontal direction and the selected weight Wy in the vertical direction are indicated.

Similarly, at the pixel P12, since the weight Wx in the horizontal direction is 1 and the weight Wy in the vertical direction is 0, Wx × Wy is 0. At the pixel P13, the weight Wx in the horizontal direction is 1 and the weight Wy in the vertical direction is 0, Wx × Wy is 0.

At the pixel P21, since the weight Wx in the horizontal direction is 0 and the weight Wy in the vertical direction is 1, Wx × Wy is 0. At the pixel P22, since the weight Wx in the horizontal direction is 0 and the weight Wy in the vertical direction is 0, Wx × Wy is 0. At the pixel P23, since the weight Wx in the horizontal direction is 0 and the weight Wy in the vertical direction is 0, Wx × Wy = 0.

At the pixel P31, since the weight Wx in the horizontal direction is 0 and the weight Wy in the vertical direction is 1, Wx × Wy is 0. At the pixel P32, since the weight Wx in the horizontal direction is 0 and the weight Wy in the vertical direction is 0, Wx × Wy is 0. At the pixel P33, since the weight Wx in the horizontal direction is 0 and the weight Wy in the vertical direction is 0, Wx × Wy is 0.

(Region 021)

Incident light from a point light source at the representative point in the region 021 enters all pixels Pij at the incident angle θx = 0 deg in the horizontal direction and at the incident angle θy = +5 deg in the vertical direction.

Therefore, as depicted in FIG. 25, at the pixel P11, the weight Wx = 1 and the weight Wy is 1, and Wx × Wy = 1. At the pixel P12, the weight Wx = 1 and the weight Wy in the vertical direction = 0, and Wx × Wy = 0. At the pixel P13, since the weight Wx = 1 and the weight Wy = 0, Wx × Wy = 0.

At the pixel P21, the weight Wx = 0.5 and the weight Wy = 1, and Wx × Wy = 0.5. At the pixel P22, the weight Wx = 0.5 and the weight Wy = 0, and Wx × Wy = 0. At the pixel P23, the weight Wx = 0.5 and the weight Wy = 0, and Wx × Wy = 0.

At the pixel P31, the weight Wx = 1 and the weight Wy = 1, and Wx × Wy = 1. At the pixel P32, the weight Wx = 1 and the weight Wy = 0, and Wx × Wy = 0. At the pixel P33, the weight Wx = 1 and the weight Wy = 0, and Wx × Wy = 0.

(Region 031)

Incident light from a point light source at the representative point in the region 031 enters all pixels Pij at the incident angle θx = +5 deg in the horizontal direction and at the incident angle θy = +5 deg in the vertical direction.

Therefore, as depicted in FIG. 26, at the pixel P11, the weight Wx = 0.5 and the weight Wy is 1, and Wx × Wy = 0.5. At the pixel P12, the weight Wx = 0.5 and the weight Wy = 0, and Wx × Wy = 0. At the pixel P13, the weight Wx = 0.5 and the weight Wy = 0, Wx × Wy = 0.

At the pixel P21, the weight Wx = 1 and the weight Wy = 1, and Wx × Wy = 1. At the pixel P22, the weight Wx = 1 and the weight Wy = 0, and Wx × Wy = 0. At the pixel P23, the weight Wx = 1 and the weight Wy = 0, and Wx × Wy = 0.

At the pixel P31, the weight Wx = 1 and the weight Wy = 1, and Wx × Wy = 1. At the pixel P32, the weight Wx = 1 and the weight Wy = 0, and Wx × Wy = 0. At the pixel P33, the weight Wx = 1 and the weight Wy = 0, and Wx × Wy = 0.

(Region 012)

Incident light from a point light source at the representative point in the region O12 enters all pixels Pij at the incident angle θx = -5 deg in the horizontal direction and at the incident angle θy = 0 deg in the vertical direction.

Therefore, as depicted in FIG. 27, at the pixel P11, the weight Wx = 1 and the weight Wy is 1, and Wx × Wy = 1. At the pixel P12, the weight Wx = 1 and the weight Wy = 0.5, and Wx × Wy = 0.5. At the pixel P13, the weight Wx = 1 and the weight Wy = 1, Wx × Wy = 1.

At the pixel P21, the weight Wx = 0 and the weight Wy = 1, and Wx × Wy = 0. At the pixel P22, the weight Wx = 0 and the weight Wy = 0.5, and Wx × Wy = 0. At the pixel P23, the weight Wx = 0 and the weight Wy = 1, and Wx × Wy = 0.

At the pixel P31, the weight Wx = 0 and the weight Wy = 1, and Wx × Wy = 0. At the pixel P32, the weight Wx = 0 and the weight Wy = 0.5, and Wx × Wy = 0. At the pixel P33, the weight Wx = 0 and the weight Wy = 1, and Wx × Wy = 0.

(Region O22)

Incident light from a point light source at the representative point in the region O22 enters all pixels Pij at the incident angle θx = 0 deg in the horizontal direction and at the incident angle θy = 0 deg in the vertical direction.

Therefore, as depicted in FIG. 28, at the pixel P11, the weight Wx = 1 and the weight Wy = 1, and Wx × Wy = 1. At the pixel P12, the weight Wx = 1 and the weight Wy = 0.5, and Wx × Wy = 0.5. At the pixel P13, the weight Wx = 1 and the weight Wy = 1, Wx × Wy = 1.

At the pixel P21, the weight Wx = 0.5 and the weight Wy = 1, and Wx × Wy = 0.5. At the pixel P22, the weight Wx = 0.5 and the weight Wy = 0.5, and Wx × Wy = 0.25. At the pixel P23, the weight Wx = 0.5 and the weight Wy = 1, and Wx × Wy = 0.5.

At the pixel P31, the weight Wx = 1 and the weight Wy = 1, and Wx × Wy = 1. At the pixel P32, the weight Wx = 1 and the weight Wy = 0.5, and Wx × Wy = 0.5. At the pixel P33, the weight Wx = 1 and the weight Wy = 1, and Wx × Wy = 1.

(Region O32)

Incident light from a point light source at the representative point in the region O32 enters all pixels Pij at the incident angle θx = +5 deg in the horizontal direction and at the incident angle θy = 0 deg in the vertical direction.

Therefore, as depicted in FIG. 29, at the pixel P11, the weight Wx = 0.5 and the weight Wy = 1, and Wx × Wy = 0.5. At the pixel P12, the weight Wx = 0.5 and the weight Wy = 0.5, and Wx × Wy = 0.25. At the pixel P13, the weight Wx = 0.5 and the weight Wy = 1, Wx × Wy = 0.5.

At the pixel P21, the weight Wx = 1 and the weight Wy = 1, and Wx × Wy = 1. At the pixel P22, the weight Wx = 1 and the weight Wy = 0.5, and Wx × Wy = 0.5. At the pixel P23, the weight Wx = 1 and the weight Wy = 1, and Wx × Wy = 1.

At the pixel P31, the weight Wx = 1 and the weight Wy = 1, and Wx × Wy = 1. At the pixel P32, the weight Wx = 1 and the weight Wy = 0.5, and Wx × Wy = 0.5. At the pixel P33, the weight Wx = 1 and the weight Wy = 1, and Wx × Wy = 1.

(Region 013)

Incident light from a point light source at the representative point in the region O13 enters all pixels Pij at the incident angle θx = -5 deg in the horizontal direction and at the incident angle θy = -5 deg in the vertical direction.

Therefore, as depicted in FIG. 30, at the pixel P11, the weight Wx = 1 and the weight Wy = 0.5, and Wx × Wy = 0.5. At the pixel P12, the weight Wx = 1 and the weight Wy = 1, and Wx × Wy = 1. At the pixel P13, the weight Wx = 1 and the weight Wy = 1, Wx × Wy = 1.

At the pixel P21, the weight Wx = 0 and the weight Wy = 0.5, and Wx × Wy = 0.5. At the pixel P22, the weight Wx = 0 and the weight Wy = 1, and Wx × Wy = 1. At the pixel P23, the weight Wx = 0 and the weight Wy = 1, and Wx × Wy = 1.

At the pixel P31, the weight Wx = 0 and the weight Wy = 0.5, and Wx × Wy = 0. At the pixel P32, the weight Wx = 0 and the weight Wy = 1, and Wx × Wy = 0. At the pixel P33, the weight Wx = 0 and the weight Wy = 1, and Wx × Wy = 0.

(Region O23)

Incident light from a point light source at the representative point in the region O23 enters all pixels Pij at the incident angle θx = 0 deg in the horizontal direction and at the incident angle θy = -5 deg in the vertical direction.

Therefore, as depicted in FIG. 31, at the pixel P11, the weight Wx = 1 and the weight Wy = 0.5, and Wx × Wy = 0.5. At the pixel P12, the weight Wx = 1 and the weight Wy = 1, and Wx × Wy = 1. At the pixel P13, the weight Wx = 1 and the weight Wy = 1, Wx × Wy = 1.

At the pixel P21, the weight Wx = 0.5 and the weight Wy = 0.5, and Wx × Wy = 0.25. At the pixel P22, the weight Wx = 0.5 and the weight Wy = 1, and Wx × Wy = 0.5. At the pixel P23, the weight Wx = 0.5 and the weight Wy = 1, and Wx × Wy = 0.5.

At the pixel P31, the weight Wx = 1 and the weight Wy = 0.5, and Wx × Wy = 0.5. At the pixel P32, the weight Wx = 1 and the weight Wy = 1, and Wx × Wy = 1. At the pixel P33, the weight Wx = 1 and the weight Wy = 1, and Wx × Wy = 1.

(Region O33)

Incident light from a point light source at the representative point in the region O33 enters all pixels Pij at the incident angle $\theta x$ = +5 deg in the horizontal direction and at the incident angle $\theta y$ = -5 deg in the vertical direction.
Therefore, as depicted in FIG. 32, at the pixel P11, the weight Wx = 0.5 and the weight Wy = 0.5, and Wx $\times$ Wy = 0.25. At the pixel P12, the weight Wx = 0.5 and the weight Wy = 1, and Wx $\times$ Wy = 0.5. At the pixel P13, the weight Wx = 0.5 and the weight Wy = 1, Wx $\times$ Wy = 0.5.
At the pixel P21, the weight Wx = 1 and the weight Wy = 0.5, and Wx $\times$ Wy = 0.5. At the pixel P22, the weight Wx = 1 and the weight Wy = 1, and Wx $\times$ Wy = 1. At the pixel P23, the weight Wx = 1 and the weight Wy = 1, and Wx $\times$ Wy = 1.
At the pixel P31, the weight Wx = 1 and the weight Wy = 0.5, and Wx $\times$ Wy = 0.5. At the pixel P32, the weight Wx = 1 and the weight Wy = 1, and Wx $\times$ Wy = 1. At the pixel P33, the weight Wx = 1 and the weight Wy = 1, and Wx $\times$ Wy = 1.
On the basis of the processing results described above, the signal processing section 122 determines the pixels Pij of the detection signal level of the directional imaging device 121 as the product sums of the light intensity and the weight where the representative point of each region Oij on the object plane 31 described above is a point light source.
In particular, the product sums are given as nine simultaneous equations represented by the following expressions (5) to (13).

$$P11 = 1\times O11 + 1\times O21 + 0.5\times O31 + 1\times O12 + 1\times O22 + 0.5\times O32 + 0.5\times O13 + 0.5\times O23 + 0.25\times O33 \quad ...(5)$$

$$P12 = 0\times O11 + 0\times O21 + 0\times O31 + 0.5\times O12 + 0.5\times O22 + 0.25\times O32 + 1\times O13 + 1\times O23 + 0.5\times O33 \quad ...(6)$$

$$P13 = 0\times O11 + 0\times O21 + 0\times O31 + 1\times O12 + 1\times O22 + 0.5\times O32 + 1\times O13 + 1\times O23 + 0.5\times O33 \quad ...(7)$$

$$P21 = 0\times O11 + 0.5\times O21 + 1\times O31 + 0\times O12 + 0.5\times O22 + 1\times O32 + 0\times O13 + 0.25\times O23 + 0.5\times O33 \quad ...(8)$$

$$P22 = 0\times O11 + 0\times O21 + 0\times O31 + 0\times O12 + 0.25\times O22 + 0.5\times O32 + 0\times O13 + 0.5\times O23 + 1\times O33 \quad ...(9)$$

$$P23 = 0\times O11 + 0\times O21 + 0\times O31 + 0\times O12 + 0.5\times O22 + 1\times O32 + 0\times O13 + 0.5\times O23 + 1\times O33 \quad ...(10)$$

$$P31 = 0\times O11 + 1\times O21 + 1\times O31 + 0\times O12 + 1\times O22 + 1\times O32 + 0\times O13 + 0.5\times O23 + 0.5\times O33 \quad ...(11)$$

$$P32 = 0\times O11 + 0\times O21 + 0\times O31 + 0\times O12 + 0.5\times O22 + 0.5\times O32 + 0\times O13 + 1\times O23 + 1\times O33 \quad ...(12)$$

$$P33 = 0\times O11 + 0\times O21 + 0\times O31 + 0\times O12 + 1\times O22 + 1\times O32 + 0\times O13 + 1\times O23 + 1\times O33 \quad ...(13)$$

Here, the value represented by the pixel Pij is a signal level of a detection signal that configures a detection image that is imaged by the directional imaging device 121 but cannot be recognized as an image even if the user visually observes the detection image.
The signal processing section 122 uses, for example, the nine simultaneous equations described above to determine the luminance (light intensity) Oij of each region on the object plane 31 to restore a restoration image corresponding to the object plane 31.

It is to be noted that values obtained by multiplying the pixels Pij described hereinabove by the weights Wx in the horizontal direction and the weights Wy in the horizontal direction determined for the pixels Pij are a coefficient set. More particularly, the coefficient sets are the coefficients α1, β1, γ1, α2, β2, γ2, α3, β3 and γ3 themselves of the above expressions (1) to (3) on the object plane 31. Further, the weight Wx in the horizontal direction and the weight Wy in the vertical direction differ depending upon the difference of the object plane 31, and by changing over the coefficient set in response to the distance or the angle of view of the restoration image for specifying the object plane, it is possible to restore a restoration image of a desired imaging plane. However, it is necessary to set the incident angle directivity such that the independence of the simultaneous equations can be secured. It is to be noted that to secure the independence of the simultaneous equations here signifies to secure the independence of the mutual linearity, for example, when the coefficient set (αs, (βs, ys) and the coefficient set (αt, βt, γt) are considered and to prevent each of the vector (αs, βs, ys) and the vector (αt, βt, γt) from becoming a multiple of the other.

<Relationship in Distance between Object Plane and Directional Imaging Device>

Now, a relationship in distance between an object plane and the directional imaging device 121 is described with reference to FIG. 33.

It is assumed that, as depicted at a left portion at an upper stage in FIG. 33, in the case where the object distance from the directional imaging device 121 (similar to the imaging device 51 of FIG. 5) to the object plane 31 is a distance d1, for example, when point light sources PA, PB and PC on the object plane 31 depicted at the upper stage in FIG. 5 are set, the detection signal levels DA, DB and DC at corresponding positions Pa, Pb and Pc on the directional imaging device 121 can be represented by expressions same as the expressions (1) to (3) given hereinabove.

$$DA = \alpha1 \times a + \beta1 \times b + \gamma1 \times c \qquad \text{... (1)}$$

$$DB = \alpha2 \times a + \beta2 \times b + \gamma2 \times c \qquad \text{... (2)}$$

$$DC = \alpha3 \times a + \beta3 \times b + \gamma3 \times c \qquad \text{... (3)}$$

In contrast, in the case of an object plane 31' from which the object distance to the directional imaging device 121 (similar to the imaging device 51 of FIG. 5) is a distance d2 that is greater by d than the distance d1 as indicated at a left portion at the lower stage in FIG. 33, namely, in the case of the object plane 31' on the deeper side than the object plane 31 as viewed from the directional imaging device 121, the detection signal level is similar among detection signal levels DA, DB and DC as indicated at a central portion at the upper stage and a central portion at the lower stage of FIG. 33.

However, in this case, rays of light of light intensities a', b' and c' from the point light sources PA', PB' and PC' on the object plane 31' are received by the pixels of the directional imaging device 121. Thereupon, since the incident angles of the rays of light of the light intensities a', b' and c' received by the directional imaging device 121 differ (vary), different coefficient sets are required individually, and the detection signal levels DA, DB and DC at the positions Pa, Pb and Pc are represented, for example, as indicated by the following expressions (14) to (16), respectively.

$$DA = \alpha11 \times a' + \beta11 \times b' + \gamma11 \times c' \qquad \text{... (14)}$$

$$DB = \alpha12 \times a' + \beta12 \times b' + \gamma12 \times c' \qquad \text{... (15)}$$

$$DC = \alpha13 \times a' + \beta13 \times b' + \gamma13 \times c' \qquad \text{... (16)}$$

Here, the coefficient set group including the coefficient set α11, β11 and γ11, coefficient set α12, β12 and γ12 and coefficient set α13, β13 and γ13 is a coefficient set group of the object plane 31' corresponding to the coefficient set α1, β1 and γ1, coefficient set α2, β2 and γ2 and coefficient set α3, β3 and γ3 of the object plane 31.

Accordingly, by solving the expressions (14) to (16) using the coefficient set group α11, β11, γ11, α12, β12, γ12, α13, β13 and γ13 set in advance, it is possible to determine the light intensities a', b' and c' of rays of light from the point light sources PA', PB' and PC' as depicted in a right portion at the lower stage in FIG. 33 by a technique similar to that by which the light intensities a, b and c of rays of light of the point light sources PA, PB and PC in the case of the object plane 31 indicated at a right portion at the upper stage in FIG. 33 are calculated. As a result, it becomes possible to determine a restoration image of the object on the object plane 31'.

In particular, the imaging apparatus 101 of FIG. 6 can obtain a restoration image of an object plane at various object distances on the basis of one detection image by storing a coefficient set group for each distance to the object plane from the directional imaging device 121 in advance, changing over the coefficient set group to configure simultaneous equations and solving the configured simultaneous equations.

In short, only by imaging a detection image only once, it is possible to generate a restoration image at an arbitrary distance by later processing by changing over the coefficient set group in response to the distance to the object plane to determine a restoration image.

Further, even if, after a restoration image is obtained, image recognition or the like is not performed on the restoration image, it is possible also to apply mechanical learning such as deep learning for a detection signal of an imaging device to perform image recognition using the detection signal itself.

Further, in such a case that an object distance or an angle of view can be specified, a restoration image may be generated without using all pixels but using a detection image formed from detection signals of pixels that have incident angle directivities suitable for imaging of an imaging plane corresponding to a specified object distance or angle of view. Since this makes it possible to determine a restoration image using detection signals of pixels suitable for imaging of an object plane corresponding to a specified object distance or angle of view, it is possible to determine a restoration image of the specified object distance or angle of view with a high degree of accuracy.

Here, the reason why a restoration image can be determined with a high degree of accuracy by determining a restoration image using a detection signal of a pixel suitable for imaging of an object plane corresponding to a specified object distance or angle of view is described.

For example, a pixel 121a shielded by a light shielding film 121b over a distance d1 from an end of each of the four sides as indicated at an upper stage in FIG. 34 and a pixel 121a' shielded over a distance d2 (> d1) from an end of each of the four sides by the light shielding film 121b as indicated at a lower stage in FIG. 34 are considered.

The pixel 121a is used to restore of an image I1 of FIG. 34 corresponding to a view angle SQ1 including such an entire person H101 of an object as depicted at an upper stage of FIG. 35. In contrast, a pixel 121a' is used to restore an image 12 of FIG. 34 corresponding to a view angle SQ2 in which a periphery of the face of the person H101 is zoomed up.

This is because, since the pixel 121a of FIG. 34 is included in an incidence possible angle range A1 of incident light to the directional imaging device 121 as depicted in a left portion in FIG. 36, it can receive incident light over an object width W1 in the horizontal direction on the object plane 31.

In contrast, since the pixel 121a' of FIG. 34 is shielded over a wider range than the pixel 121a of FIG. 34, as depicted in a left portion of FIG. 36, it is included in an incidence possible angle range A2 (< A1) of incident light to the directional imaging device 121, and therefore, it receives incident light over an object width W2 (< W1) in the horizontal direction on the object plane 31.

In particular, while the pixel 121a of FIG. 34 having a narrow shielding range is a wide angle pixel suitable for imaging over a wide range on the object plane 31, the pixel 121a' of FIG. 34 having a wide shielding range is a narrow angle pixel suitable for imaging over a narrow range on the object plane 31. It is to be noted that the wide angle pixel and the narrow angle pixel here are representations for comparison between the pixels 121a and 121a' of FIG. 34, and the representations are not limited to them in comparison with pixels of other angles of view.

It is to be noted that FIG. 36 depicts a relationship between positions on the object plane 31 with respect to the center position C1 of the directional imaging device 121 and incident angles of incident light from the positions. Further, while FIG. 36 depicts a relationship between positions on the object plane 31 and incident angles of incident light from the positions on the object plane in the horizontal direction, a similar relationship is exhibited also in the vertical direction. Further, the pixels 121a and 121a' in FIG. 34 are depicted in a right portion of FIG. 36.

By such a configuration as described above, in the case where a predetermined number of pixels 121a of FIG. 34 are placed into a range ZA surrounded by a broken line in the directional imaging device 121 and an equal number of pixels 121a' are placed in a range ZB surrounded by a dash-dotted line in the directional imaging device 121 as depicted at a lower stage in FIG. 35 to configure the directional imaging device 121, when an image of the view angle SQ1 corresponding to the object width W1 is to be restored, by using the pixel 121a of FIG. 34 for imaging with the view angle SQ1, an image of the object width W1 of the object plane 31 can be restored appropriately.

Similarly, when an image of the view angle SQ2 corresponding to the object width W2 is to be restored, by using the detection signal of the pixel 121a' of FIG. 34 for imaging an image with the view angle SQ2, an image of the object width W2 can be restored appropriately.

It is to be noted that, while the lower stage in FIG. 35 depicts a configuration that includes a predetermined number of pixels 121a' on the left side in the figure and includes the predetermined number of pixels 121 on the right side, this configuration is indicated as an example that simplifies the description, and preferably, the pixels 121a and the pixels 121a' are disposed in a randomly mixed manner.

Since the view angle SQ2 has an angle of view narrower than that of the view angle SQ1 in this manner, in the case where images of the view angle SQ2 and the view angle SQ1 are to be stored with an equal predetermined pixel number, where the image of the view angle SQ2 having a narrower angle of view is restored, a restoration image of higher picture quality can be obtained than where the image of the view angle SQ1 is restored.

In short, in the case where it is considered to obtain a restoration image using an equal pixel number, a restoration image of higher picture quality can be obtained where an image of a narrower angle of view is restored.

It is to be noted that, in the case where an image having a wider angle of view is obtained as a restoration image, all pixels of the wide view angle pixels may be used or part of the wide view angle pixels may be used. Meanwhile, in the case where an image of a narrower angle of view is used as a restoration image, all pixels of the narrow view angle pixels may be used or part of the narrow view angle pixels may be used.

<Imaging Process by Imaging Apparatus of FIG. 6 of Present Disclosure>

Now, an imaging process by the imaging apparatus 101 of FIG. 6 is described with reference to a flow chart of FIG. 37. It is to be noted that, since processes at steps S34 to S38 in the flow chart of FIG. 37 are similar to the processes at steps S14 to S18 described hereinabove with reference to the flow chart of FIG. 8, description of them is suitably omitted.

In particular, at step S31, the directional imaging device 121 acquires, for each of the pixel output units having incident angle directivities different among different pixel output units, a detection signal according to the light amount of received incident light and supplies such detection signals as a detection image to the signal processing section 122.

At step S32, the imaging distance determination section 129 determines an object distance determined on the basis of an operation signal from the operation section 130 or an autofocus function. The coefficient set selection section 131 reads out a coefficient set group stored in an associated relationship on the basis of the object distance and supplies the coefficient set group to the signal processing section 122. The coefficient set group read out here is, for example, a coefficient set group including a plurality of coefficients corresponding to the coefficient set group including the coefficients $\alpha 1$ to $\alpha 3$, $\beta 1$ to $\beta 3$, $\gamma 1$ to $\gamma 3$, $\alpha 11$ to $\alpha 13$, $\beta 11$ to $\beta 13$ and $\gamma 11$ to $\gamma 13$ in the expressions (1) to (3) or the expressions (14) to (16) given hereinabove.

At step S33, the signal processing section 122 uses the detection signals of the pixel output units in the detection image and the coefficient set group selected by the coefficient set selection section 131 to calculate pixel values of a demodulation image. More particularly, the signal processing section 122 configures simultaneous equations described hereinabove, for example, with reference to the expressions (1) to (3) or the expressions (14) to (16) and FIGS. 18 to 32, determines a restoration image by solving the simultaneous equations and outputs the restoration image to the demosaic processing section 123.

Thereafter, the restoration image is demosaic processed by the demosaic processing section 123, $\gamma$ corrected by the $\gamma$ correction section 124, adjusted in white balance by the white balance adjustment section 125 and then converted into an image of a predetermined compression format by the image outputting section 126. Then, as occasion demands, the restoration image having the predetermined compression format as a result of the conversion is stored into the storage section 127, displayed on the display section 128, and outputted to the imaging distance determination section 129 or is subjected to one of such processes.

It is to be noted that, while the foregoing description is directed to an example in which a restoration image is determined from a detection image using a coefficient set group associated with an object distance from the directional imaging device 121, coefficient set groups that are set in an associated relationship not only with object distances but also with angles of view may be prepared such that a coefficient set group according to an object distance and an angle of view is selected to determine a restoration image from a detection image, as described above with reference to the FIGS, 34 and 35. It is to be noted that it is assumed that the resolution for the object distance and the angle of view depends upon the number of prepared coefficient sets.

Further, while the description of the processes given with reference to the flow chart of FIG. 37 is directed to an example in which detection signals of all pixel output units included in a detection image are used, a restoration image may be determined using a detection image configured so as to include only detection signals of pixel output units each of which corresponds to a specified object distance and angle of view from among detection signals of pixel output units that configure the directional imaging device 121. Since such a process as just described makes it possible to restore a restoration image from a detection image suitable for an object distance and an angle of view of a restoration image to be determined, it is possible to restore a restoration image with higher degree of accuracy. In particular, in the case where an image corresponding to a specified object distance and angle of view is, for example, an image corresponding to the view angle SQ1 in FIG. 35, by selecting the pixels 121a having an incident angle directivity corresponding to the view angle SQ1 and restoring a restoration image from a detection image obtained from the pixels 121a, an image of the view angle SQ1 can be restored with a high degree of accuracy.

By the processes described above, it is possible to implement the imaging apparatus 101 that includes the directional imaging device 121, in which an incident angle directivity is provided to each pixel, as an essential component.

As a result, since an optical device configured from an imaging lens, a diffraction grating and so forth or a pinhole becomes unnecessary, it is possible to improve the degree of freedom in design of an apparatus, and since an optical device that is configured as a separate member from an imaging device and is supposed to be incorporated together with an imaging device at a stage at which an imaging apparatus is configured becomes unnecessary, it becomes possible to implement scaling down of an apparatus in an incident direction of incident light and it becomes possible to reduce the fabrication cost. Further, a lens equivalent to an imaging lens for forming an optical image like a focus lens becomes unnecessary. However, a zoom lens for changing the magnification may be provided.

Further, only if a detection image is acquired, restoration images of various object distances can be generated by solving simultaneous equations configured by selectively using coefficient set groups according an object distance and an angle of view to determine a restoration image.

For example, in the case where an imaging apparatus configured from an imaging lens and a conventional imaging device is used, in order to obtain images of various focal lengths or various angles of view, it is necessary to perform imaging while variously changing the focal length or the angle of view. However, in the imaging apparatus 101 of the present disclosure, since it is possible to change over the coefficient set group to restore a restoration image, such a process as to repetitively perform imaging while the focal length, namely, the object distance, or the angle of view is changed variously.

Further, while the foregoing description is directed to an example in which only a restoration image is stored into the storage section 127, by storing detection images into the storage section 127, upon reproduction, a restoration image may be generated using a plurality of coefficient set groups of different object distances. This makes it possible to generate, upon reproduction, a restoration image at an arbitrary object distance or on an object plane of an arbitrary angle of view.

Furthermore, since it is possible, in comparison with an imaging apparatus configured from an optical filter configured from a diffraction grating and a conventional imaging device, to generate a restoration image using a detection image imaged by the directional imaging device 121 having an incident angle directivity in a unit of a pixel, multipixelization can be implemented. Further, it becomes possible to image an image of a high resolution and a high angular resolution.

Further, since the imaging apparatus 101 of the present disclosure incudes the directional imaging device 121 as an essentially required component and does not require an optical filter configured, for example, from a diffraction grating or the like, such a situation that the temperature of the use environment becomes high and the optical filter is distorted by heat does not occur, and therefore, an imaging apparatus having a high environmental tolerance can be implemented.

Furthermore, since the imaging apparatus 101 of the present disclosure does not require an optical device such as a diffraction grating or an imaging lens, the degree of freedom in design of a configuration that includes a function for imaging can be improved.

<First Modification>

While the foregoing description is directed to an example in which, as depicted in FIG. 9, the light shielding film 121b of each pixel 121a of the directional imaging device 121 is configured such that it blocks light entirely in the vertical direction and is changed in regard to the light shielding width or the position in the horizontal direction, naturally the light shielding film 121b may otherwise be configured such that it blocks light entirely in the horizontal direction and is changed in regard to the width (height) or the position in the vertical direction such that an incident angle directivity is provided to each pixel.

It is to be noted that, in the following description, the light shielding film 121b that shields the pixel 121a entirely in the vertical direction like each pixel 121a indicated in the right portion in FIG. 9 and besides shields the pixel 121a with a predetermined width in the horizontal direction is referred to as light shielding film 121b of the horizontal belt type. Further, the light shielding film 121b that shields the pixel 121a entirely in the horizontal direction and shields the pixel 121a with a predetermined height in the vertical direction as in the case where each of the pixels 121a depicted in the right portion in FIG. 9 is rotated by 90° around an axis provided by the center position of the pixel 121a is referred to as light shielding film 121b of the vertical belt type.

Further, as depicted in the left portion in FIG. 38, the light shielding films 121b of the vertical belt type and the horizontal belt type may be combined such that an L-shaped light shielding film 121b is provided, for example, for pixels of a Bayer array. It is to be noted that, in FIG. 38, a black range represents a light shielding film 121b, and unless otherwise specified, a similar representation is applied also in the succeeding drawings.

Each pixel has such an incident angle directivity as indicated in a right portion in FIG. 38. In particular, in the right portion in FIG. 38, a light receiving sensitivity of each pixel is indicated, and the axis of abscissa represents the incident angle θx in the horizontal direction (x direction) of incident light and the axis of ordinate represents the incident angle θy in the vertical direction (y direction). Further, the light receiving sensitivity within a range C4 is higher than that outside the range C4; the light receiving sensitivity in a range C3 is higher than that outside the range C3; the light receiving sensitivity in a range C2 is higher than that outside the range C2; and the light receiving sensitivity in a range C1 is higher than that outside the range C1.

Accordingly, it is indicated that, in regard to each pixel, the detection signal level of incident light that satisfies conditions of the incident angle θx in the horizontal direction (x direction) and the incident angle θy in the vertical direction (y direction) in the range C1 is highest and the detection signal level becomes lower in order of conditions of the inside of the range C2, the inside of the range C3, the inside of the range C4 and the outside of the range C4. It is to be noted that the light receiving sensitivity indicated in the right portion of FIG. 38 is determined by a range of each pixel 121a shielded by the light shielding film 121b irrespective of the Bayer array.

Further, in the left portion in FIG. 38, it is indicated that L-shaped light shielding films 121b-21 to 121b-24 are provided for pixels 121a-21 and 121a-24 of G pixels, a pixel 121a-22 of an R pixel and a pixel 121a-23 of a B pixel of a Bayer array, respectively.

It is to be noted that, in the following description, the L-shaped light shielding films 121b-21 to 121b-24 having an L-like shape as depicted in FIG. 38 and, regarding the light shielding films 121b-21 to 121b-24, light shielding films 121b having a shape considering a case where the light shielding films 121b-21 to 121b-24 are disposed in point symmetry with respect to the center of the pixels 121a are collectively referred to as L-shaped light shielding films 121b.

Further, it has been described that the directional imaging device 121 of the first modification described above with reference to FIG. 38 is a directional imaging device 121 that is described with reference to the FIGS. 9 and 10 and that sets an incident angle directivity for each pixel output unit using the light shielding film 121b for one photodiode 121e described hereinabove with reference to FIG. 10. However, the directional imaging device 121 of the first modification may be a directional imaging device 121 that sets an incident angle directivity by changing the division number of a plurality of photodiodes 121f, which configure a pixel output unit, and the division position such that a range that does not contribute to outputting functions similarly to a shielded region like the directional imaging device 121 described hereinabove with reference to FIG. 11.

<Second Modification>

Although the foregoing description is directed to examples in which light blocking films of the horizontal belt type, vertical belt type and L-shaped type are disposed on pixels such that a shielded range varies at random, a light shielding film 121b may be configured which shields, in the case where rectangular openings are provided, for example, as indicated by a directional imaging device 121' of FIG. 39, regions other than ranges in the proximity of positions at which light is received by individual pixels.

In particular, the light shielding film 121b may be provided such that, in the case where a rectangular opening is provided for each pixel, the pixel has such an incident angle directivity that it receives, from among rays of light emitted from point light sources that configure an object plane at a predetermined object distance, only rays of light that pass through the rectangular opening so as to be received by the pixel.

It is to be noted that, in FIG. 39, for example, in a pixel array in the horizontal direction, the width of the light shielding film 121b in the horizontal direction varies like dx1, dx2, ..., dxn, and the widths have a relationship of dx1 < dx2 < ... < dxn. Similarly, in a pixel array in the vertical direction, the height of the light shielding film 121b in the vertical direction varies like dy1, dy2, ..., dym, and the heights have a relationship of dy1 < dy2 < ... < dym. Further, the distances in variation of the width in the horizontal direction and the width in the vertical direction of the light shielding film 121b depend upon the object resolution (angular resolution) for restoration.

In other words, it can be considered that each pixel 121a in the directional imaging device 121' of FIG. 39 is configured such that it has such an incident angle directivity that varies the light shielding range so as to correspond to the pixel disposition in the directional imaging device 121' in the horizontal direction and the vertical direction.

More particularly, the light blocking range of each pixel 121a of FIG. 39 is determined, for example, in accordance with a rule described with reference to the pixel 121a indicated at a left portion in FIG. 40.

It is to be noted that a right portion in FIG. 40 depicts a configuration of a directional imaging device 121' same as that of FIG. 39. Meanwhile, a left portion in FIG. 40 depicts a configuration of the pixel 121a of the directional imaging device 121' in the right portion of FIG. 40 (same as FIG. 39).

As depicted by the left portion in FIG. 40, the pixel 121a is shielded over a width dx1 from end portions of the upper side and the lower side toward the inner side thereof by the light shielding film 121b and is shielded over a depth dy1 from end portions of the left side and the right side toward the inner side thereof by the light shielding film 121b. It is to be noted that, in FIGS. 40 and 41, the light shielding film 121b is represented by a range indicated by black.

A range shielded by the light shielding film 121b formed in this manner in the left portion in FIG. 40 is hereinafter referred to as main light shielding portion Z101 (black portion in the left portion in FIG. 40) of the pixel 121a, and a range other than this is referred to as range Z102.

It is assumed that a rectangular opening Z111 that is not shielded by the light shielding film 121b is provided in the range Z102 of the pixel 121a. Accordingly, in the range Z102, a range other than the rectangular opening Z111 is shielded by the light shielding film 121b.

In the pixel array in the directional imaging device 121' of FIG. 39, as depicted in a right portion of FIG. 40 (same as FIG. 39), the left side of the rectangular opening Z111 of the pixel 121a-1 at a left end portion at an upper end portion is disposed at a distance of the width dx1 from the left side of the pixel 121a, and the upper side of the rectangular opening Z111 is disposed at a distance of dy 1 from the upper side of the pixel 121a.

Similarly, the pixel 121a-2 neighboring on the right side with the pixel 121a-1 is configured such that the left side of the rectangular opening Z111 is disposed at a distance of the width dx2 from the left side of the pixel 121a and disposed at a distance of the height dy1 from the upper face of the pixel 121a such that a region of the pixel 121a-2 other than the rectangular opening Z111 is shielded by the light shielding film 121b.

Similarly, as the disposition of the pixel 121a neighboring in the horizontal direction advances to the right side in the figure, the right side of the rectangular opening Z111 moves by the width dx1, dx2, ..., dxn from the right side of the pixel 121a. It is to be noted that a broken line square portion of a right upper portion in the range Z102 in FIG. 40 depicts a state when the rectangular opening Z111 is disposed such that the left side thereof is positioned at a distance of the width dxn from the left side of the pixel 121a and the upper side thereof is positioned at a distance of the height dy1 from the upper side of the pixel 121a. Further, the distance between the widths dx1, dx2, ..., dxn is a value when the width obtained by subtracting the width of the rectangular opening Z111 from the width of the range Z102 in the horizontal direction is divided by the pixel number n in the horizontal direction. In other words, the distance of variation in the horizontal direction is determined by dividing the value by the pixel number n in the horizontal direction.

Further, the position in the horizontal direction of the rectangular opening Z111 in the pixel 121a of the directional imaging device 121' is same in the pixel 121a whose position in the horizontal direction in the directional imaging device 121' is same (in the pixel 121a in the same column).

Furthermore, the pixel 121a-3 neighboring just below the pixel 121a-1 is configured such that the rectangular opening Z111 is disposed such that the left side thereof is positioned at a distance of the width dx1 from the left side of the pixel 121a and the upper side thereof is positioned at a distance of the height dy2 from the upper side of the pixel 121a such that a range of the pixel 121a-3 other than the rectangular opening Z111 is shielded by the light shielding film 121b.

Similarly, as the disposition of the pixel 121a neighboring in the vertical direction advances toward the lower side in FIG. 40, the upper side of the rectangular opening Z111 successively moves to the height dy1, dy2, ..., dyn from the upper side of the pixel 121a. It is to be noted that a broken line square portion of a left lower portion in the range Z102 of FIG. 40 depicts a state when the rectangular opening Z111 is disposed such that the left side thereof is positioned at a distance of the width dx1 from the left side of the pixel 121a and the upper side thereof is positioned at a distance of the height dym from the upper side of the pixel 121a. Further, the distance between the widths dy1, dy2, ..., dym is a value when the height obtained by subtracting the height of the rectangular opening Z111 from the height of the range Z102 in the vertical direction is divided by the pixel number m in the vertical direction. In other words, the distance of variation in the horizontal direction is determined by dividing the value by the pixel number m in the horizontal direction.

Further, the position in the vertical direction of the rectangular opening Z111 in the pixel 121a of the directional imaging device 121' is same in the pixel 121a whose position in the vertical direction in the directional imaging device 121' is same (in the pixel 121a in the same row).

<Variation of Angle of View>

Further, the angle of view can be changed by changing the main light shielding portion Z101 and the rectangular opening Z111 of each pixel 121a configuring the directional imaging device 121' depicted in FIG. 40 (FIG. 39).

A right portion of FIG. 41 depicts a configuration of the directional imaging device 121' in the case where the angle of view is made wider with respect to the directional imaging device 121' of FIG. 40 (FIG. 39). Further, a left portion of FIG. 41 depicts a configuration of the pixel 121a of the directional imaging device 121' in the right portion of FIG. 41.

In particular, as depicted in the left portion of FIG. 41, for example, in the pixel 121a, a main light shielding portion Z151 (black portion in the left portion of FIG. 41) having a light shielding range narrower than that of the main light shielding portion Z101 in FIG. 40 is set, and any other range is set as range Z152. Further, in the range Z152, a rectangular opening Z161 having an opening area greater than that of the rectangular opening Z111 is set.

More particularly, as depicted by the left portion of FIG. 41, the pixel 121a is shielded over a width dx1' (< dx1) from end portions of the upper side and the lower side toward the inner side thereof by the light shielding film 121b and is shielded over a depth dy1' (< dy1) from end portions of the left side and the right side toward the inner side thereof by the light shielding film 121b thereby to form the rectangular opening Z161.

Here, as depicted in the right portion of FIG. 41, the pixel 121a-1 at a left end portion at an upper end portion is configured such that the left side of the rectangular opening Z161 thereof is disposed at a distance of the width dx1' from the left side of the pixel 121a and the upper side of the rectangular opening Z161 is disposed at a distance of the height dy1' from the upper side of the pixel 121a such that the range thereof other than the rectangular opening Z161 is shielded by the light shielding film 121b..

Similarly, the pixel 121a-2 neighboring on the right side with the pixel 121a-1 is configured such that the left side of the rectangular opening Z161 is disposed at a distance of the width dx2' from the left side of the pixel 121a and disposed at a distance of the height dy1' from the upper face of the pixel 121a such that the range of the pixel 121a-2 other than the rectangular opening Z161 is shielded by the light shielding film 121b.

Similarly, as the disposition of the pixel 121a neighboring in the horizontal direction advances to the right side in FIG. 41, the right side of the rectangular opening Z161 moves by the width dx1', dx2', ..., dxn' from the right side of the pixel 121a. Here, the distance between the widths dx1', dx2', ..., dxn' is a value when the width obtained by subtracting the width of the rectangular opening Z161 in the horizontal direction from the width of the range Z152 in the horizontal direction is divided by the pixel number n in the horizontal direction. In other words, the distance of variation in the vertical direction is determined by dividing the value by the pixel number n in the horizontal direction. Accordingly, the distance of variation between the widths dx1', dx2', ..., dxn' is greater than the distance of variation between the widths dx1, dx2, ..., dxn.

Further, the position in the horizontal direction of the rectangular opening Z161 in the pixel 121a of the directional imaging device 121' of FIG. 41 is same in the pixel 121a whose position in the horizontal direction in the directional imaging device 121' is same (in the pixel 121a in the same column).

Furthermore, the pixel 121a-3 neighboring just below the pixel 121a-1 is configured such that the rectangular opening Z161 is disposed such that the left side thereof is positioned at a distance of the width dx1' from the left side of the pixel 121a and the upper side thereof is positioned at a distance of the height dy2' from the upper side of the pixel 121a such that the range of the pixel 121a-3 other than the rectangular opening Z161 is shielded by the light shielding film 121b.

Similarly, as the disposition of the pixel 121a neighboring in the vertical direction advances to the lower side in FIG. 41, the upper side of the rectangular opening Z161 successively moves to the height dy1', dy2', ..., dyn' from the upper side of the pixel 121a. Here, the distance of variation between the widths dy1', dy2', ..., dym' is a value when the height obtained by subtracting the height of the rectangular opening Z161 from the height of the range Z152 in the vertical direction is divided by the pixel number m in the vertical direction. In other words, the distance of variation in the horizontal direction is determined by dividing the value by the pixel number m in the vertical direction. Accordingly, the distance of variation between the widths dy1', dy2', ..., dyn' is greater than the distance of variation between the widths dy1, dy2, ..., dyn.

Further, the position in the vertical direction of the rectangular opening Z161 in the pixel 121a of the directional imaging device 121' of FIG. 41 is same in the pixel 121a whose position in the vertical direction in the directional imaging device 121' is same (in the pixel 121a in the same row).

By changing the combination of the shielding range of the main shielding portion and the opening range of the opening in this manner, it is possible to implement a directional imaging device 121' configured from pixels 121a of various angles of view (having various incident angle directivities).

Furthermore, not only the pixels 121a of a same angle of view but also pixels 121a of various angles of view may be combined to implement the directional imaging device 121.

For example, as depicted in FIG. 42, by forming one unit U from four pixels including 2 pixels × 2 pixels indicated by broken lines, each unit U is configured from four pixels of a pixel 121a-W of a wide angle of view, a pixel 121a-M of a medium angle of view, a pixel 121a-N of a narrow angle of view and a pixel 121a-AN of a very narrow angle of view.

In this case, for example, in the case where the pixel number of all pixels 121a is X, it is possible to restore a restoration image using detection images each including X/4 pixels for each four kinds of angles of view. Thereupon, four kinds of coefficient sets that are different among the different angles of view are used and restoration images of the different angles of view are reproduced depending upon four different simultaneous equations.

Therefore, by restoring a restoration image of an angle of view to be restored using a detection image obtained from pixels suitable for imaging of the angle of view for restoration, it is possible to restore an appropriate restoration image according to the four angles of view.

Further, images of angles of view intermediate between the four angles of view or of angles of view around such angles may be generated by interpolation from the images of the four angles of view, or by generating images of various angles of view seamlessly, pseudo optical zooming may be implemented.

Note that it is described that the directional imaging device 121' of the second modification described hereinabove with reference to FIGS. 39 to 42 is the directional imaging device 121 that sets an incident angle directivity for each pixel output unit using the light shielding film 121b for one photodiode 121e described hereinabove with reference to FIGS. 9 and 10. However, the directional imaging device 121’ of the second modification may be the directional imaging device 121 that sets an incident angle directivity by causing a range that does not contribute to outputting similarly to a shielded region by changing the division number of a plurality of photodiodes 121f configuring a pixel output unit and the division position like the directional imaging device 121 described hereinabove with reference to FIG. 11.

<Third Modification>

Incidentally, in the case where the shielding range of the light shielding film 121b of the pixel 121a in the directional imaging device 121 has randomness, as the clutter in difference of the shielding range of the light shielding film 121b increases, the load upon processing by the signal processing section 122 increases. Therefore, part of the variation of the shielding range of the light shielding film 121b of the pixel 121a may be made regular to decrease the clutter thereby to reduce the processing load.

In particular, the processing load upon the signal processing section 122 may be reduced, for example, by configuring the L-shaped light shielding film 121b in which a vertical belt type and a horizontal belt type are combined such that, for a predetermined column direction, light shielding films 121b of the horizontal belt type having an equal width are combined and, for a predetermined row direction, light shielding films 121b of the vertical belt type of an equal height are combined thereby to reduce the clutter in incident light directivity of the pixels.

In particular, for example, as indicated by a directional imaging device 121" of FIG. 43, for pixels in a same column indicated by a range Z130, light shielding films 121b of the horizontal belt type of an equal width X0 are used and, for pixels of a same row indicated by a range Z150, light shielding films 121b of the vertical belt type of an equal height Y0 are used. Further, for a pixel 121a specified by each row and each column, a light shielding film 121b of the L-shaped type that is a combination of them is set.

Similarly, for pixels in a same column indicated by a range Z131 neighboring with the range Z130, light shielding films 121b of the horizontal belt type of an equal width X1 are used and, for pixels of a same row indicated by a range Z151 neighboring with the range Z150, light shielding films 121b of the vertical belt type of an equal height Y1 are used. Further, for a pixel 121a specified by each row and each column, a light shielding film 121b of the L-shaped type that is a combination of them is set.

Furthermore, for pixels in a same column indicated by a range Z132 neighboring with the range Z131, light shielding films of the horizontal belt type of an equal width X2 are used, and for pixels in a same row indicated by a range Z152 neighboring with the main light shielding portion Z151, light shielding films of the vertical belt type of an equal height Y2 are used. Further, for a pixel 121a specified by each row and each column, a light shielding film 121b of the L-shaped type that is a combination of them is set.

Since this makes it possible to change the range of the light shielding film in a unit of a pixel while regularity is provided to the width and the position in the horizontal direction of the light shielding film 121b and the height and the position in the vertical direction of the light shielding film 121b, the clutter in incident angle directivity can be suppressed. As a result, it becomes possible to reduce patterns of coefficient sets and reduce the processing load of an arithmetic operation process on the signal processing section 122.

More particularly, in the case where a restoration image of N × N pixels is determined from a detection image Pic of N pixels × N pixels as depicted at a right upper portion in FIG. 44, from a vector X whose elements are pixel values of pixels of a restoration image of N × N rows and one column, a vector Y whose elements are pixel values of pixels of a detection image of N × N rows and one column and a matrix A of N × N rows and N × N columns configured from coefficient sets, such a relationship as depicted at a left portion of FIG. 44 is satisfied.

In particular, in FIG. 44, it is depicted that a result of multiplication of pixels of the matrix A of N × N rows and N × N columns configured from coefficient sets and the vector X of N × N rows and one column representative of a restoration image becomes the vector Y of N × N rows and one column representative of a detection image, and from this relationship, for example, simultaneous equations corresponding to the expressions (5) to (13) described hereinabove are configured.

It is to be noted that FIG. 44 depicts that elements in the first column indicated by the range Z201 of the matrix A correspond to elements of the first row of the vector X, and elements in the (N × N)th column indicated by the range Z202 of the matrix A correspond to elements of the (N × N)th row of the vector X.

In other words, a restoration image is determined by calculating the elements of the vector X by solving simultaneous equations based on the matrix indicated in FIG. 44. Further, in the case where a pinhole is used and in the case where a condensing mechanism for causing incident light rays incident from a same direction to enter both of pixel output units neighboring with each other like an imaging lens or the like is used, since the relationship between the position of and the incident angle of light to each pixel is determined uniquely, the matrix A becomes a diagonal matrix in which all elements on a rightwardly downwardly inclined diagonal line are 1. Conversely, in the case where any of a pinhole and an imaging lens is used as in the imaging apparatus 101 of FIG. 6, since the relationship between the position of and the incident angle of light to each pixel is not determined uniquely, the matrix A does not become a diagonal matrix.

Incidentally, generally the determinant of FIG. 44 is deformed as depicted in FIG. 45 by multiplying the both sides thereof by an inverse matrix A-1 to the matrix A from the left, and the elements of the vector X that is a detection image are calculated by multiplying the vector Y of the detection image by the inverse matrix A-1 from the right.

However, in regard to the real matrix A, sometimes it is impossible to solve simultaneous equations of the same from one of reasons that it cannot be calculated accurately, that it cannot be measured accurately, that it cannot be solved because of a case in which the base vector of the matrix A is close to linear dependence and that noise is included in elements of a detection image or from a combination of them.

Therefore, a configuration robust against various errors is considered, and the following expression (17) that uses a concept of regularized least squares method is taken.

[Math. 1]

$$\hat{X} = \min\|A\hat{x} - y\|^2 + \|\gamma\hat{x}\|^2$$

... (17)

Here, in the expression (17), x having "^" applied to the top thereof represents the vector X, A represents the matrix A, Y the vector Y, γ a parameter, and ||A|| an L2 norm (square root of sum of squares). Here, the first term is a norm when the both sides of FIG. 44 are minimized, and the second term is a normalization term.

If this expression (17) is solved for x, then it is represented by the following expression (18).

[Math. 2]

$$\hat{X} = (A^tA + \gamma I)^{-1}A^ty$$

However, since the matrix A has a very great size, a memory of a great capacity is required for a calculation time period or calculation.

Therefore, it is considered that, for example, as depicted in FIG. 46, the matrix A is decomposed into a matrix AL of N rows and N columns and another matrix ART of N rows and N columns such that a result when the matrix AL and the matrix ART are multiplied from the front stage and the rear stage of a matrix X of N rows and N columns representative of a restoration image, respectively, becomes a matrix Y of N rows and N columns representative of a detection image. Since the matrix A of the element number of (N × N) × (N × N) is turned into the matrices AL and ART both having the element number of (N × N), the element number can be reduced to 1/(N × N). As a result, since only it is necessary to use the two matrices AL and ART whose element number is (N × N), the calculation amount and the memory capacity can be reduced.

Here, AT is a transposed matrix of the matrix A, γ a parameter, and I a unit matrix. By using the matrix AL as the matrix in the parentheses of the expression (18) and using the matrix ART as the inverse matrix to the transposed matrix of the matrix A, the determinant depicted in FIG. 46 is implemented.

In this manner, such calculation as depicted in FIG. 47 calculates an element group Z222 by multiplying a noticed element Xp in a matrix X by each element group Z221 in a corresponding column of the matrix AL. Further, by multiplying the element group Z222 and an element of a row corresponding to the noticed element Xp of the matrix ART, a two-dimensional response Z224 corresponding to the noticed element Xp is calculated. Then, the matrix Y is calculated by accumulating the corresponding two-dimensional response Z224 to all elements of the matrix X.

Therefore, to the element group Z221 corresponding to each row of the matrix AL, a coefficient set corresponding to the incident angle directivity of the pixels 121a of the horizontal belt type set to an equal width for each column of the directional imaging device 121 depicted in FIG. 43 is provided.

Similarly, to an element group Z223 corresponding to each row of the matrix ART, a coefficient set corresponding to the incident angle directivity of the pixels 121a of the vertical belt type set to an equal height for each row of the directional imaging device 121 depicted in FIG. 43 is provided.

As a result, since it becomes possible to reduce the size of a matrix to be used when a restoration image is restored on the basis of a detection image, by reducing the calculation amount, it becomes possible to improve the processing speed and reduce the power consumption required for calculation. Further, since the size of the matrix can be reduced, it becomes possible to reduce the capacity of the memory to be used for calculation and reduce the apparatus cost.

It is to be noted that, while, in the example of FIG. 43, an example is depicted in which the range to be shielded (range capable of receiving light) is changed in a unit of a pixel while predetermined regularity is provided in the horizontal direction and the vertical direction, in the technology of the present disclosure, it is deemed that, even if the range shielded in a unit of a pixel in this manner (range capable of receiving light) is not set fully at random but is set at random to some degree, it is set at random. In other words, in the present technology, not only in a case in which the shielded range (range capable of receiving light) is set in a unit of a pixel but also in a case in which the range is set at random to some degree (for example, in a case in which, although all pixels include, at part thereof, a range in which the pixels have regularity, the pixels in the other range are set at random) or in another case in which it seems that there is no regularity to some degree (in the case of a disposition in which it cannot be confirmed that, from among all pixels, some pixels are not disposed in accordance with such a rule as described hereinabove with reference to FIG. 43), it is deemed that the range is set at random.

Further, it is described that the directional imaging device 121" of the third modification described hereinabove with reference to FIGS. 43 to 47 is the directional imaging device 121 in which the light shielding film 121b is used to set an incident angle directivity for each pixel output unit to one photodiode 121e, described hereinabove with reference to FIGS. 9 and 10. However, the directional imaging device 121" of the third modification may be a directional imaging device 121 that sets an incident angle directivity by changing the division number of a plurality of photodiodes 121f that configure a pixel output unit and the division position such that a range that does not contribute to outputting functions similarly to a shielded region like the directional imaging device 121 described hereinabove with reference to FIG. 11.

<Fourth Modification>

As variations of the shape of the light shielding film 121b that configures each pixel output unit of the directional imaging device 121 in the foregoing description, those of the horizontal belt type that is indicated by 3 patterns at the uppermost stage in FIG. 48 and in which different incident angle directivities are provided by difference in width and position in the horizontal direction, the vertical belt type that is indicated by 3 patterns at the second uppermost stage in FIG. 48 and in which different incident angle directivities are provided by difference in height and position in the vertical direction, and the L-shaped type that is indicated at the third stage from above in FIG. 48 and is a combination of the horizontal belt type and the vertical belt type, are described. However, the type of the light shielding film 121b is not limited to any of them.

For example, different incident angle directivities may be provided by setting the light shielding films 121b to triangular shapes and making the ranges of them different from each other as indicated by 3 patterns at the fourth stage from above in FIG. 48, or different incident angle directivities may be provided by setting the light shielding films 12b to circular shapes and making the ranges of them different from each other as indicated by 3 patterns at the lowermost stage in FIG. 48. It is to be noted that, though not depicted, patterns different from the patterns described above may be provided, and for example, linear light shielding films in an oblique direction may be provided.

It is to be noted that, in the description given below, the light shielding film 121b indicated by the 3 patterns at the fourth stage in FIG. 48 is referred to as light shielding film 121b of the triangle type, and the light shielding film 121b indicated by the 3 patterns at the lowermost stage in FIG. 48 is referred to as light shielding film 121b of the circle type.

Further, it is described that the directional imaging device 121 of the fourth modification described with reference to FIG. 48 is the directional imaging device 121 that sets the incident angle directivity for each pixel output unit using the light shielding film 121b to one photodiode 121e, described hereinabove with reference to FIGS. 9 and 10. However, the directional imaging device 121 of the fourth modification may be a directional imaging device 121 that sets an incident angle directivity by changing the division number of a plurality of photodiodes 121f that configure a pixel output unit and the division position such that a range that does not contribute to outputting functions similarly to a shielded region like the directional imaging device 121 described hereinabove with reference to FIG. 11.

<Fifth Modification>

While the foregoing description is directed to variations of the light shielding film 121b set in a one-pixel output unit of the directional imaging device 121, a variation (pattern) of the light shielding film 121b may be set in a plurality of pixel output units configuring an aggregation configured from a predetermined plural number of pixel output units. As an example, not a monochromatic imaging device but a color imaging device is conceivable.

In particular, as indicated by a pattern Pt1 of FIG. 49, using a plurality of pixel output units that configure an aggregation including totaling four pixel output units including 2 pixel output units $\times$ 2 pixel output units configuring a Bayer array, light shielding films 121b of the horizontal belt type of an equal width may be disposed in a matrix.

Meanwhile, as indicated by a pattern Pt2, using a plurality of pixel output units that configure an aggregation including totaling four pixel output units configuring a Bayer array, light shielding films 121b of the horizontal belt type of widths different among the different pixel output units may be disposed in a matrix.

Further, as indicated by a pattern Pt3, a plurality of pixel output units that configure an aggregation including totaling four pixel output units configuring a Bayer array may be disposed in a matrix such that a position of light shielding film 121b of the horizontal belt type or the vertical belt type for one-pixel output unit is changed in point symmetry relative to the corresponding pixel output position with the central position of a four-pixel output unit centered.

Further, in the case where pixel output units of a same color scheme are set, for example, from four pixel output units of 2 pixel output units × 2 pixel output units and aggregations of a same color scheme of four pixel output units configure a Bayer array in totaling four aggregation units (16 pixel output units) configured from 2 aggregations × 2 aggregations, as indicated by a pattern Pt4, light shielding films 121b of the horizontal belt type of an equal width may be disposed in a matrix in four pixel output units configuring an aggregation including four pixel output units of a same color scheme.

Furthermore, as indicated by a pattern Pt5, using a four-pixel output unit that configures an aggregation configured from four pixel output units of a same color scheme, light shielding films 121b of the horizontal belt type having a width different for each one-pixel output unit may be disposed in a matrix.

Further, as indicated by a pattern Pt6, using a four-pixel output unit that configures an aggregation including four pixel output units of a same color scheme, light shielding films 121b of the horizontal belt type and the vertical belt type may be disposed in a matrix with their positions changed such that the shielded ranges of the four pixel output units are changed in point symmetry with respect to the center at the central position of the four-pixel output unit per one-pixel output unit.

Furthermore, in the case where pixel output units of a same color scheme are set, for example, from a nine-pixel output unit of 3 pixel output units × 3 pixel output units and a Bayer array is configured from totaling four aggregation units (36 pixel output units) configured from 2 aggregations × 2 aggregations in an aggregation unit of a same color scheme of a nine-pixel output unit, as indicated by a pattern Pt7, light shielding films 121b of the horizontal belt type of an equal width may be disposed in a matrix in in a nine-pixel output unit configuring an aggregation including nine pixel output units of a same color scheme.

Further, as indicated by a pattern Pt8, using a nine-pixel output unit configuring an aggregation configured from nine pixels of a same color scheme, light shielding films 121b of the horizontal belt type having a width different by a one-pixel output unit may be disposed in a matrix.

Furthermore, as indicated by a pattern Pt9, using a nine-pixel output unit that configures an aggregation configured from nine pixel output units of a same color scheme, light shielding films 121b of the horizontal belt type, vertical belt type and triangle type may be disposed in a matrix with their positions changed such that the shielded ranges of the eight pixel output units centered at the center pixel of the nine-pixel output unit are changed in point symmetry in a unit of 2 pixel output units.

It is to be noted that, while the foregoing description is given of patterns that use the light shielding films 121b of the horizontal belt type, vertical belt type and triangle type, the light shielding films 121b of other types, for example, of a circular type or the like may be used. Further, while the foregoing description is directed to examples that use a Bayer array, a color scheme pattern different from that may be used. Further, although, in regard to the pixel output unit number of a same color scheme configuring an aggregation, examples of a one-pixel output unit, a four-pixel output unit and a nine-pixel output unit are described, pixel output units of a same color scheme may be set in any other pixel output unit number.

Further, it is preferable that the randomness of patterns of ranges in which the light shielding film 121b in each pixel configuring an aggregation blocks light is high, namely, that the pixels configuring an aggregation have incident angle directivities different from each other.

Further, although an example is described with reference to FIG. 49, in which, for one aggregation including a four-pixel output unit including 2 pixel output units × 2 pixel output units configuring a Bayer array, a pattern of the light shielding film 121b is set or a light shielding film 121b is set as a pattern between aggregations, the light shielding film 121b may be set in any other unit. For example, the light shielding film 121b may be set for processing unit that is configured from a plural number of pixel output units considering, for example, a pixel output unit of a first exposure time period and a pixel output unit of a second exposure time period longer than the first exposure time period that are different from each other in exposure time, in addition to color scheme.

Further, it is described that the directional imaging device 121 of the fifth modification described hereinabove with reference to FIG. 49 is the directional imaging device 121 that sets an incident angle directivity for each pixel output unit using the light shielding film 121b for one photodiode 121e, described hereinabove with reference to FIGS. 9 and 10. However, the directional imaging device 121 of the fifth modification may be a directional imaging device 121 that sets an incident angle directivity by changing the division number of a plurality of photodiodes 121f, which configure a pixel output unit, and the division position such that a range that does not contribute to outputting functions similarly to a shielded region like the directional imaging device 121 described hereinabove with reference to FIG. 11.

<Sixth Modification>

While the foregoing description is directed to an example in which a pattern of disposition of light shielding films 121b is set in a plurality of pixel output units configuring an aggregation of at least one or more pixel output units of a same color scheme configuring a Bayer array, a disposition pattern of light shielding films 121b may be set between aggregations.

In particular, a disposition pattern of light shielding films 121b of pixel output units of the directional imaging device 121 may be such that, in the case where an aggregation is configured from four pixel output units of a Bayer array of 2 pixel output units × 2 pixel output units, for example, as indicated by a pattern Pt11 in FIG. 50, the light shielding films 121b may be disposed such that, among different aggregations, for a pixel output unit of a G pixel at a left upper portion in FIG. 50 within the four pixel output units, the light shielding film 121b of the horizontal belt type is disposed at a left end portion in the pixel output unit and the width of the light shielding film 121b is successively set wider for every one aggregation in the rightward direction from the left in FIG. 50.

Further, as indicated by a pattern Pt12 of FIG. 50, the width of the light shielding film 121b of a pixel output unit of a G pixel at a left upper portion within a four-pixel output unit in each aggregation may be set so as to vary at random.

Furthermore, as indicated by a pattern Pt13 of FIG. 50, the shielding range of the light shielding film 121b of a pixel output unit of a G pixel at a left upper portion within a four-pixel output unit in each aggregation may be set so as to vary, among the aggregations, in point symmetry with respect to the center of the pixel output unit.

It is to be noted that, while the foregoing description is directed to examples that use the horizontal belt type and the vertical belt type, naturally a pattern that uses the light shielding film 121b of the L-shaped type, triangular type, circular type or the like may be set.

It is to be noted that, while the fifth modification and the sixth modification described hereinabove are directed to examples in which a pattern of a shielding range by the light shielding film 121b is set in a plurality of pixel output units in an aggregation of a Bayer array or the like or between aggregations, a pattern of a shielding range of a light shielding film 121b may be set in an aggregation or between aggregations each configured from a plurality of pixel output units classified by a different category.

Further, it is described that the directional imaging device 121 of the sixth modification described hereinabove with reference to FIG. 50 is a directional imaging device 121 that sets an incident angle directivity for each pixel output unit using the light shielding film 121b for one photodiode 121e, described hereinabove with reference to FIGS. 9 and 10. However, the directional imaging device 121 of the sixth modification may be a directional imaging device 121 that sets an incident angle directivity by changing the division number of a plurality of photodiodes 121f, which configure a pixel output unit, and the division position such that a range that does not contribute to outputting functions similarly to a shielded region like the directional imaging device 121 described hereinabove with reference to FIG. 11.

<Seventh Modification>

As described hereinabove with reference to FIG. 11, as an example of a plurality of photodiodes 121f, the example is described in which a pixel output unit is configured from disposition of two × two photodiodes 121f and the directivity of an output pixel value of the pixel output unit with respect to an incident angle is changed variously by changing over presence/absence or the degree of contribution of each photodiode 121f to the pixel output unit, naturally the number of plural photodiodes 121f configuring a pixel output unit may be any other number.

In particular, as depicted in FIG. 51, a pixel 121a-b may be configured in which a pixel output unit is configured from three photodiodes 121f × three photodiodes 121f (= nine photodiodes 121f) of photodiodes 121f-1 11 to 121e-119. It is to be noted that the number of photodiodes 121f that configure a pixel output unit may be different from four and nine described hereinabove.

In other words, a plurality of photodiodes 121f may be changed over and used such that they form pixels 121a of various pixel output units.

<Eighth Modification>

The foregoing description is directed to examples in which the incident angle directivity of an output pixel value of a pixel output unit is changed over variously by a plurality of photodiodes 121f. Incidentally, when one pixel output unit includes a predetermined number of photodiodes 121f, one on-chip lens 121c is essentially required for one-pixel output unit.

In particular, as depicted in FIG. 52, for example, such a configuration that photodiodes 121f-111 to 121f-119 of three photodiodes 121f × three photodiodes 121f (= nine photodiodes 121f) are set for one on-chip lens 121c is made a pixel output unit. In the case of such a configuration as just described, if reading out is not performed for five pixels of, for example, the photodiodes 121f-111, 121f-114 and 121f-117 to 121f-119 depicted in FIG. 52, then the range of the photodiodes 121f-111, 121f-114 and 121f-117 to 121f-119 is placed into a state in which it does not contribute to a detection signal, and by using only signals, which contribute to a detection signal, from within the range of the photodiodes 121f-112, 121f-113, 121f-115 and 121f-116, it is possible to set an incident angle directivity.

It is to be noted that it can be considered that this configuration is a configuration that applies the configuration at the lower portion in FIG. 12 or FIG. 13 described hereinabove.

A detection signal similar to that when the light shielding film 121b is provided can be obtained without providing the light shielding film 121b in this manner, and by changing over the pattern of the photodiode 121f that does not contribute to a detection signal, it is possible to substantially form light shielding films 121b that are different in shielding position and range, namely, to implement processing equivalent to providing a different incident light directivity.

Accordingly, by providing a plurality of photodiodes 121f for one on-chip lens 121c such that an aggregation including the plurality of photodiodes 121f is processed as one-pixel output unit, it is possible to image a detection image similar to that by the pixels 121a formed using the light shielding film 121b by changing over such that reading out of any photodiode 121f that corresponds to the light shielding film 121b is not performed without providing the light shielding film 121b. In short, one on-chip lens is an essentially required component for one-pixel output unit.

<<3. Second Embodiment>

While the foregoing description is directed to an example in which the directional imaging device 121, signal processing section 122 and so forth are formed as separate members from each other, the signal processing section 122 may be configured on a substrate same as the substrate on which the directional imaging device 121 is provided, or the substrate on which the directional imaging device 121 is provided and the substrate on which the signal processing section 122 and so forth are configured may be stacked and connected to each other by through-electrodes such as a TSV (Through Silicon Via) or the like such that they are configured integrally.

FIG. 53 depicts a configuration example of an imaging apparatus 101 that uses an integrated directional imaging device 121 in which, on a substrate stacked on the rear face side of a substrate that is same as a substrate on which a pixel array of directional imaging devices 121 is configured or of the substrate on which the pixel array of directional imaging devices 121 is configured, an imaging distance determination section 129, a coefficient set selection section 131 and a signal processing section 122 are provided.

It is to be noted that, since basic functions and an imaging processes are similar to those of the imaging apparatus 101 of FIG. 6, description of them is omitted.

It is to be noted that the present technology can take also the following configurations.

<1> An imaging apparatus, including:
an imaging device that has a plurality of pixel output units for receiving incident light incident thereto without intervention of any of an imaging lens and a pinhole and in which characteristics of output pixel values of at least two of the plurality of pixel output units in regard to an incident angle of incident light from an object are different from each other.

<2> The imaging apparatus according to <1>, in which
the characteristic is an incident angle directivity indicative of a directivity of the incident light from the object with respect to the incident angle.

<3> The imaging apparatus according to <2>, in which
single detection signal is outputted from each of the plurality of pixel output units.

<4> The imaging apparatus according to <3>, further including:
an image restoration section configured to restore a restoration image, on which the object is viewable, using a detection image configured from a plurality of detection signals outputted from the plurality of pixel output units.

<5> The imaging apparatus according to <4>, in which
the image restoration section restores the restoration image by selectively using detection signals of part of the plurality of pixel output units.

<6> The imaging apparatus according to <4>, in which
the image restoration section selectively executes a restoration process for restoring the restoration image by using detection signals of part of the plurality of pixel output units and a restoration process for restoring the restoration image using detection signals of all of the plurality of pixel output units.

<7> The imaging apparatus according to <4>, in which

the plurality of pixel output units include a wide angle compatible pixel output unit having the incident angle directivity suitable for a wide angle image and a narrow angle compatible pixel output unit narrower than the wide angle compatible pixel output unit, and
the image restoration section restores the restoration image by selectively using the wide angle compatible pixel output unit and the narrow angle compatible pixel output unit.

<8> The imaging apparatus according to <2>, in which
the imaging apparatus does not include a condensing mechanism for introducing diffused light rays having different principal ray incident angles from the object to a plurality of pixel output units neighboring with each other.
<9> The imaging apparatus according to <1>, in which
the plurality of pixel output units have a structure capable of individually setting characteristics for incident angles of the incident light from the object independently of each other.
<10> An imaging device, having:
a plurality of pixel output units for receiving incident light incident thereto without intervention of any of an imaging lens and a pinhole and in which characteristics of output pixel values of at least two of the plurality of pixel output units in regard to an incident angle of incident light from an object are different from each other.
<11> The imaging device according to <10>, in which
at least two of the plurality of pixel output units are different from each other in incident angle directivity indicative of a directivity of incident light from an object with respect to an incident angle.
<12> The imaging device according to <11>, in which

each of the plurality of pixel output units is configured from one photodiode, and
single detection signal is outputted from each of the plurality of pixel output units.

<13> The imaging device according to <12>, in which

each of the at least two pixel output units includes a light shielding film for blocking incidence of object light that is incident light from the object to the photodiode, and
ranges in which incidence of the object light to the two pixel output units is blocked by the light shielding film are different from each other between the at least two pixel output units.

<14> The imaging device according to <11>, in which
each of the plurality of pixel output units is configured from a plurality of photodiodes, and single detection signal is outputted from each of the plurality of pixel output units.
<15> The imaging device according to <14>, in which
the at least two pixel output units are different from each other in one of the plurality of photodiodes, which contributes to the detection signal.
<16> The imaging device according to <11>, in which
the plurality of pixel output units include a wide angle compatible pixel output unit having an incident angle directivity suitable for a wide angle image and a narrow angle compatible pixel output unit narrower than the wide angle compatible pixel output unit.
<17> The imaging device according to <11>, further including:
a plurality of on-chip lenses individually corresponding to each of the plurality of pixel output units.
<18> The imaging device according to <17>, in which
the incident angle directivity has a characteristic according to a curvature of the on-chip lenses.
<19> The imaging device according to <18>, in which
the incident angle directivity has a characteristic according to a light shielding region.
<20> The imaging device according to <18>, in which
the curvature of at least part of the plurality of on-chip lenses is different from a curvature of other on-chip lenses.
<21> The imaging device according to <10>, in which
the plurality of pixel output units have a structure capable of individually setting characteristics for incident angles of the incident light from the object independently of each other.
<22> An image processing apparatus, comprising:
an image restoration section configured to restore, using a detection image configured from a plurality of detection signals each of which outputted from each of the plurality of pixel output units of an imaging device having a plurality of pixel output units for receiving incident light thereto without intervention of any of an image pickup lens and a pinhole and in which an incident angle directivity of incident light from an object with respect to an incident angle is different between output pixel values of at least two of the plurality of pixel output units, a restoration image on which the object is viewable.
<23> The image processing apparatus according to <22>, in which
the image restoration section restores the restoration image by selectively using a detection signal or signals of part of the plurality of image output units.

<24> The image processing apparatus according to <22>, in which
the image restoration section selectively executes a restoration process for restoring the restoration image by using detection signals of part of the plurality of pixel output units and a restoration process for restoring the restoration image using detection signals of all of the plurality of pixel output units.
<25> The image processing apparatus according to <22>, in which

the plurality of pixel output units include a wide angle compatible pixel output unit having the incident angle directivity suitable for a wide angle image and a narrow angle compatible pixel output unit narrower than the wide angle compatible pixel output unit, and
the image restoration section restores the restoration image by selectively using the wide angle compatible pixel output unit and the narrow angle compatible pixel output unit.

<26> An imaging method for an imaging apparatus, including the step of:
imaging an image by an imaging device that has a plurality of pixel output units for receiving incident light incident thereto without the intervention of any of an imaging lens and a pinhole and in which characteristics of output pixel values of at least two of the plurality of pixel output units in regard to an incident angle of incident light from an object are different from each other.
<27> An imaging method for an imaging device, including the step of:
imaging an image by the imaging device that has a plurality of pixel output units for receiving incident light incident thereto without the intervention of any of an imaging lens and a pinhole and in which characteristics of output pixel values of at least two of the plurality of pixel output units in regard to an incident angle of incident light from an object are different from each other.
<28> An image processing method, including the step of:

restoring, by an image restoration section having a plurality of pixel output units for receiving incident light incident thereto without the intervention of any of an imaging lens and a pinhole,
using a detection image configured from a plurality of detection signals outputted from the plurality of pixel output units of an imaging device in which an incident angle directivity of incident light from an object with respect to an incident angle is different between output pixel values of at least two of the plurality of pixel output units, a restoration image on which the object is viewable.

[Reference Signs List]

101 imaging apparatus
121 directional imaging device
121a pixel
121b light shielding film
121c on-chip lens
121d color filter
121e, 121f photodiode
122 signal processing section
123 demosaic processing section
124 $\gamma$ correction section
125 white balance adjustment section
126 image outputting section
127 storage section
128 display section
129 imaging distance determination section
130 operation section
131 coefficient set selection section
151 imaging device
152 optical block
153 focus adjustment section

## Claims

1. An imaging device, having:
a plurality of pixel output units for receiving incident light incident thereto without intervention of any of an imaging lens and a pinhole and in which characteristics of output pixel values of at least two of the plurality of pixel output units in regard to an incident angle of incident light from an object are different from each other.

2. The imaging device according to claim 1, wherein
at least two of the plurality of pixel output units are different from each other in incident angle directivity indicative of a directivity of incident light from an object with respect to an incident angle.

3. The imaging device according to claim 2, wherein

    each of the plurality of pixel output units is configured from one photodiode, and
    a single detection signal is outputted from each of the plurality of pixel output units.

4. The imaging device according to claim 3, wherein

    each of the at least two pixel output units includes a light shielding film for blocking incidence of object light that is incident light from the object to the photodiode, and
    ranges in which incidence of the object light to the two pixel output units is blocked by the light shielding film are different from each other between the at least two pixel output units.

5. The imaging device according to claim 4, wherein the light shielding film for each of the at least two pixel output units provides a rectangular opening for receiving the incident light.

6. The imaging device according to claim 5, wherein the at least two pixel output units are arranged in a pixel array with two or more of the pixel output units in the same column, and a horizontal position of the rectangular opening in each of the two or more pixel output units in the same column is the same.

7. The imaging device according to claim 5 or 6, wherein the at least two pixel output units are arranged in a pixel array with two or more of the pixel output units in the same row, and a vertical position of the rectangular opening in each of the two or more pixel output units in the same row is the same.

8. An imaging apparatus comprising an imaging device according to any of claims 1 to 7.

9. An apparatus configured

    to receive a plurality of detection signals from an imaging device having a plurality of pixel output units for receiving incident light thereto without intervention of any of an imaging lens and a pinhole and in which an incident angle directivity of incident light from an object with respect to an incident angle is different between output pixel values of at least two of the plurality of pixel output units, and
    to perform image recognition based on the plurality of detection signals by applying machine learning to the plurality of detection signals.

10. The apparatus according to claim 9, wherein
the characteristic is an incident angle directivity indicative of a directivity of the incident light from the object with respect to the incident angle.

11. The apparatus according to claim 10, wherein the plurality of detection signals each indicate a detection signal level according to an amount of incident light received by a respective one of the plurality of pixel output unit of the imaging device.

12. The apparatus according to any of claims 9 to 11, wherein the apparatus is configured

    to combine signals representing the incident light received by the two or more pixel output units by configuring and solving simultaneous equations for multiple positions on the imaging device to form an image without use of a lens or a pinhole, wherein in each of the simultaneous equations a signal level representing incident light received by a pixel output unit is represented as a composite value of products of components of point light sources on an object plane to be restored as said image multiplied by coefficients indicative of incident angle directivities according to respective incident angles of a ray from the point light source, and
to determine that a relationship between a number of unknown numbers as solutions to the simultaneous equations and a number of the simultaneous equations is such that it is not possible to determine pixel values configuring the image.

**13.** The apparatus according to any of claims 9 to 12, comprising

an image restoration section configured
to restore, using a detection image configured from the plurality of detection signals, a restoration image on which the object is viewable.

**14.** The apparatus according to claim 13, wherein the apparatus is configured to perform the image recognition based on the plurality of detection signals by applying machine learning to the plurality of detection signals after the restoration image is restored.

**15.** The apparatus according to any of claims 9 to 14, wherein the imaging device is comprised in the apparatus.

FIG.1

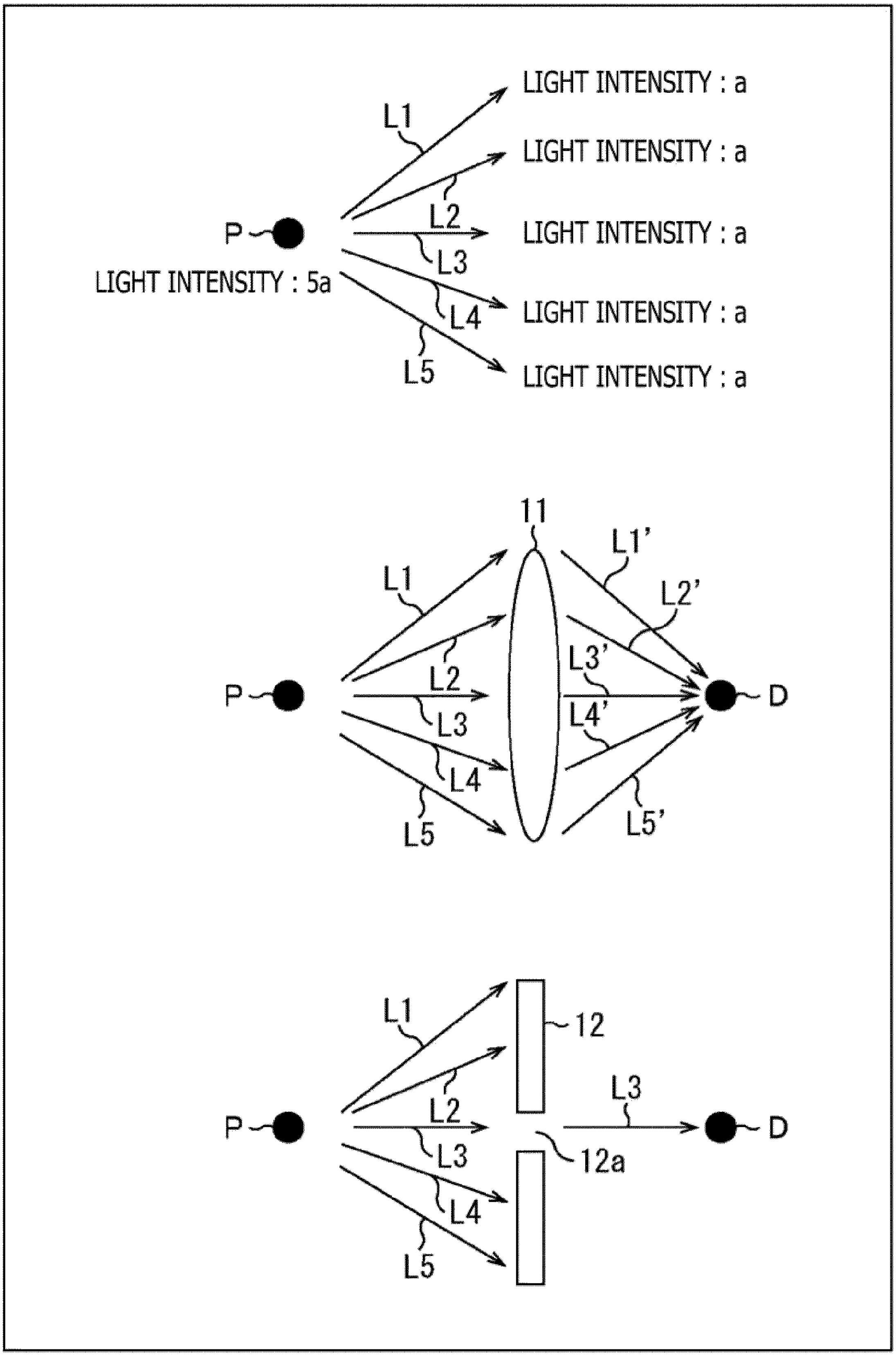
LIGHT INTENSITY : a
L1
LIGHT INTENSITY : a
L2
P
LIGHT INTENSITY : a
L3
LIGHT INTENSITY : 5a
LIGHT INTENSITY : a
L4
L5
LIGHT INTENSITY : a
11
L1'
L1
L2'
L3'
L2
P
D
L3
L4'
L4
L5
L5'
L1
12
L2
L3
P
D
L3
12a
L4
L5

FIG. 2

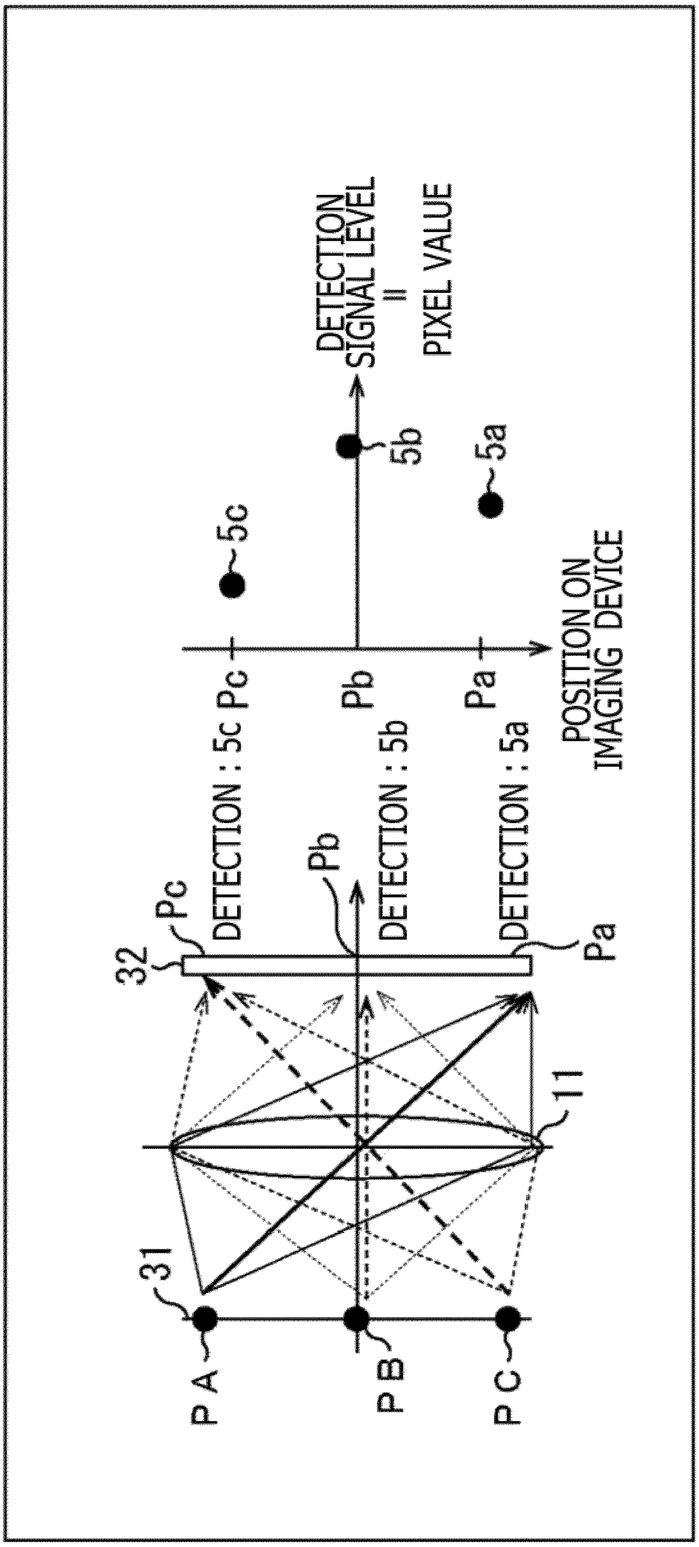
P A
P B
P C
31
11
32
Pc
Pb
Pa
DETECTION : 5c
DETECTION : 5b
DETECTION : 5a
Pc
Pb
Pa
POSITION ON IMAGING DEVICE
5c
5b
5a
DETECTION SIGNAL LEVEL
=
PIXEL VALUE

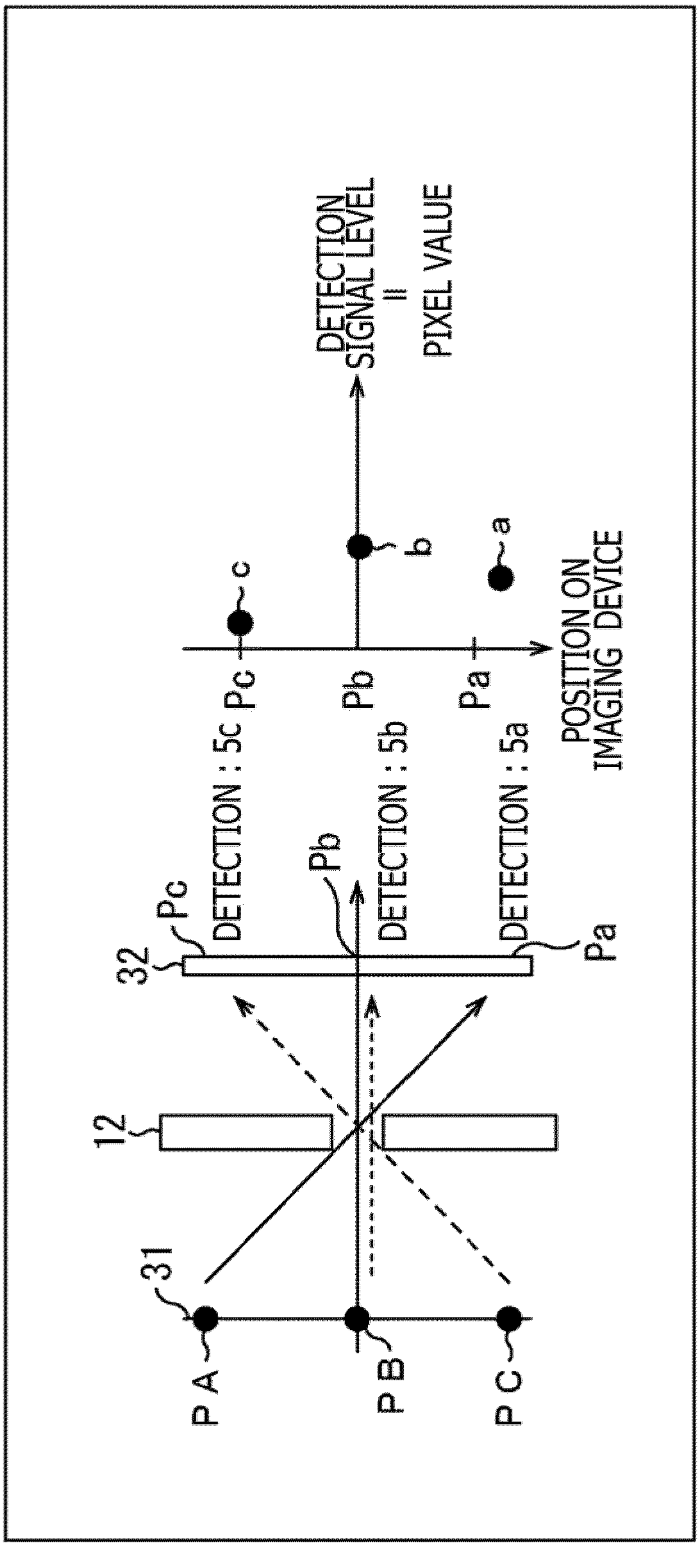
P A
P B
P C
31
12
32
Pc
Pb
Pa
DETECTION : 5c
DETECTION : 5b
DETECTION : 5a
Pc
Pb
Pa
c
b
a
POSITION ON IMAGING DEVICE
DETECTION SIGNAL LEVEL
=
PIXEL VALUE

FIG. 3

FIG. 4

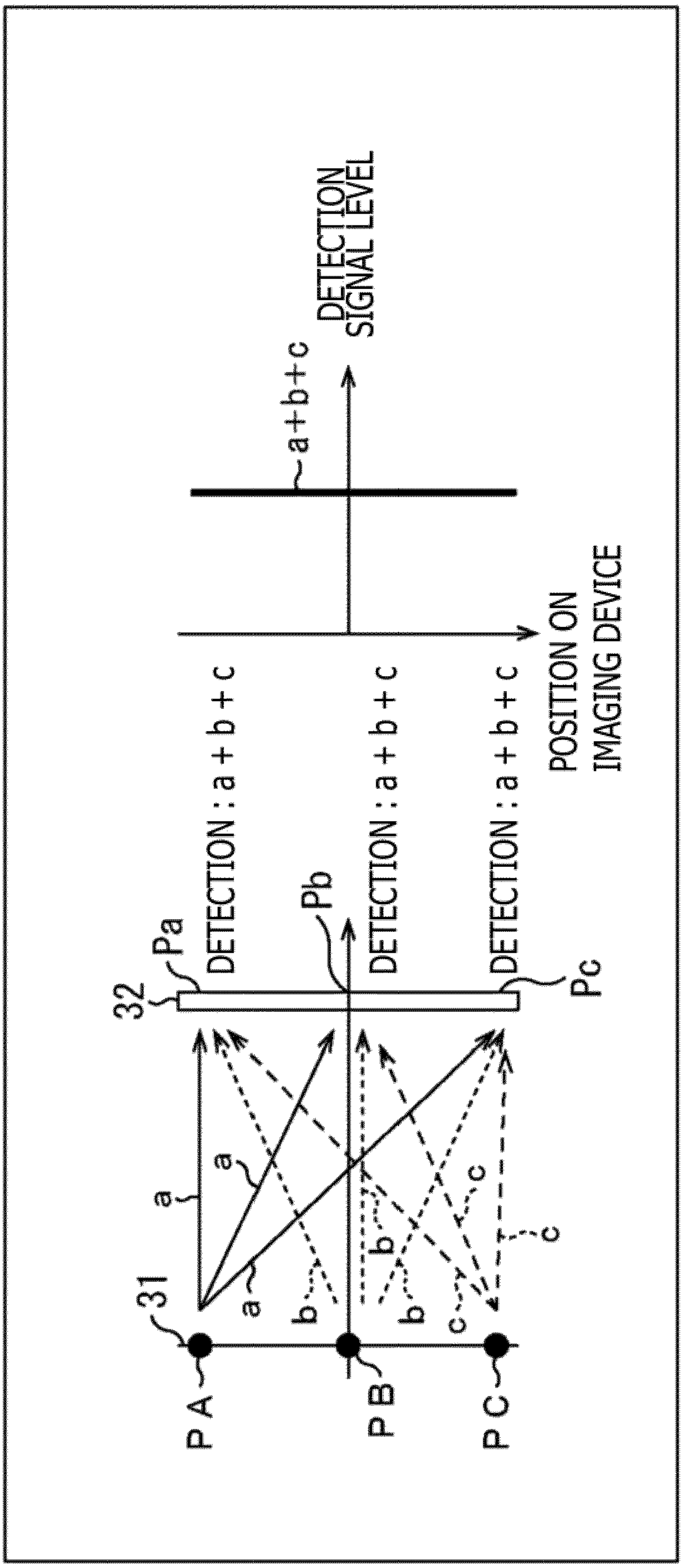
31
32
PA
PB
PC
a
b
c
Pa
Pb
Pc
DETECTION : a + b + c
DETECTION : a + b + c
DETECTION : a + b + c
a+b+c
DETECTION SIGNAL LEVEL
POSITION ON IMAGING DEVICE

FIG.5

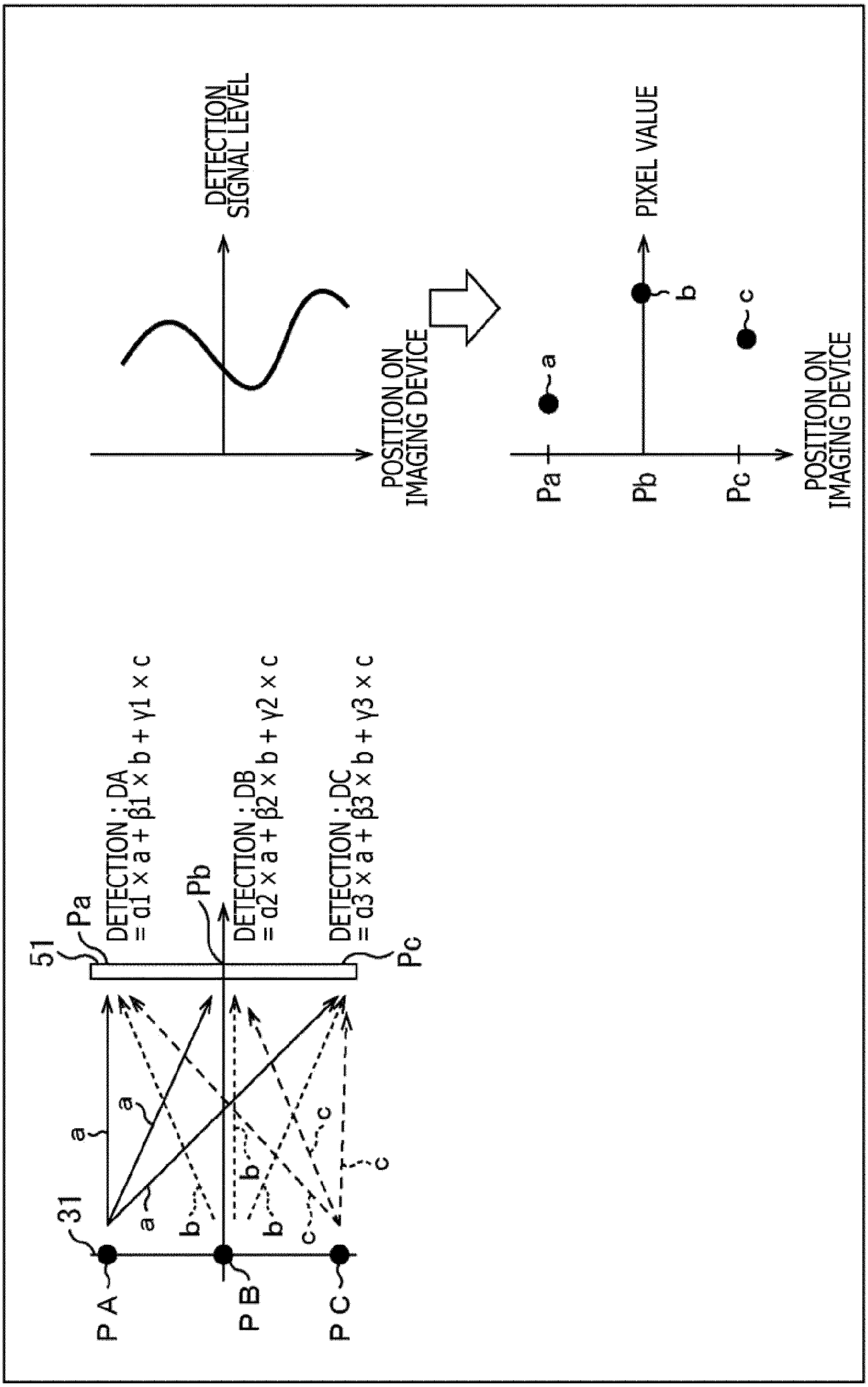
DETECTION SIGNAL LEVEL
POSITION ON IMAGING DEVICE
PIXEL VALUE
a
b
c
Pa
Pb
Pc
POSITION ON IMAGING DEVICE
51
31
PA
PB
PC
DETECTION : DA
= α1 × a + β1 × b + γ1 × c
DETECTION : DB
= α2 × a + β2 × b + γ2 × c
DETECTION : DC
= α3 × a + β3 × b + γ3 × c

FIG. 6

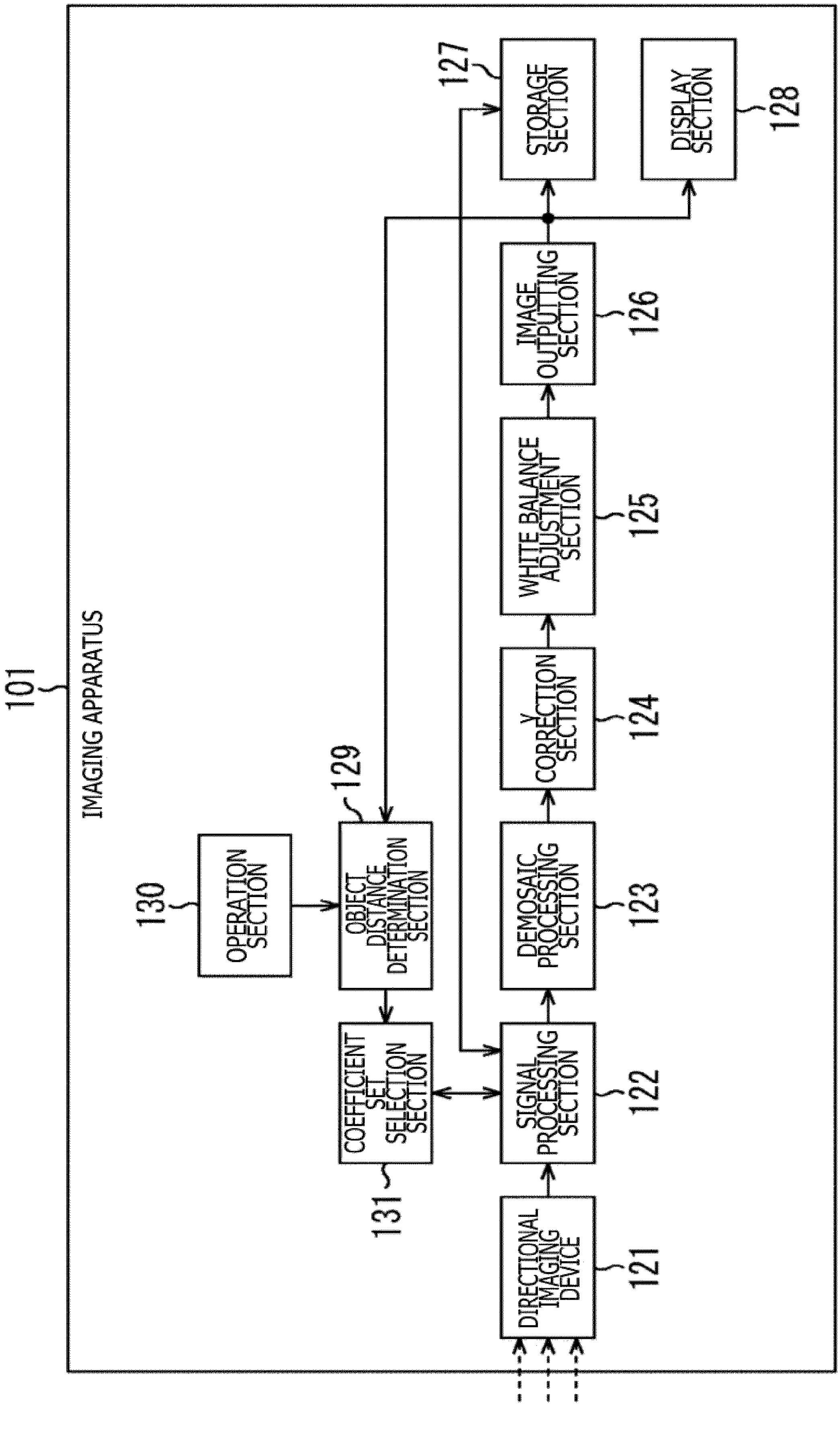
101
IMAGING APPARATUS
121 DIRECTIONAL IMAGING DEVICE
122 SIGNAL PROCESSING SECTION
123 DEMOSAIC PROCESSING SECTION
124 γ CORRECTION SECTION
125 WHITE BALANCE ADJUSTMENT SECTION
126 IMAGE OUTPUTTING SECTION
127 STORAGE SECTION
128 DISPLAY SECTION
129 OBJECT DISTANCE DETERMINATION SECTION
130 OPERATION SECTION
131 COEFFICIENT SET SELECTION SECTION

FIG. 7

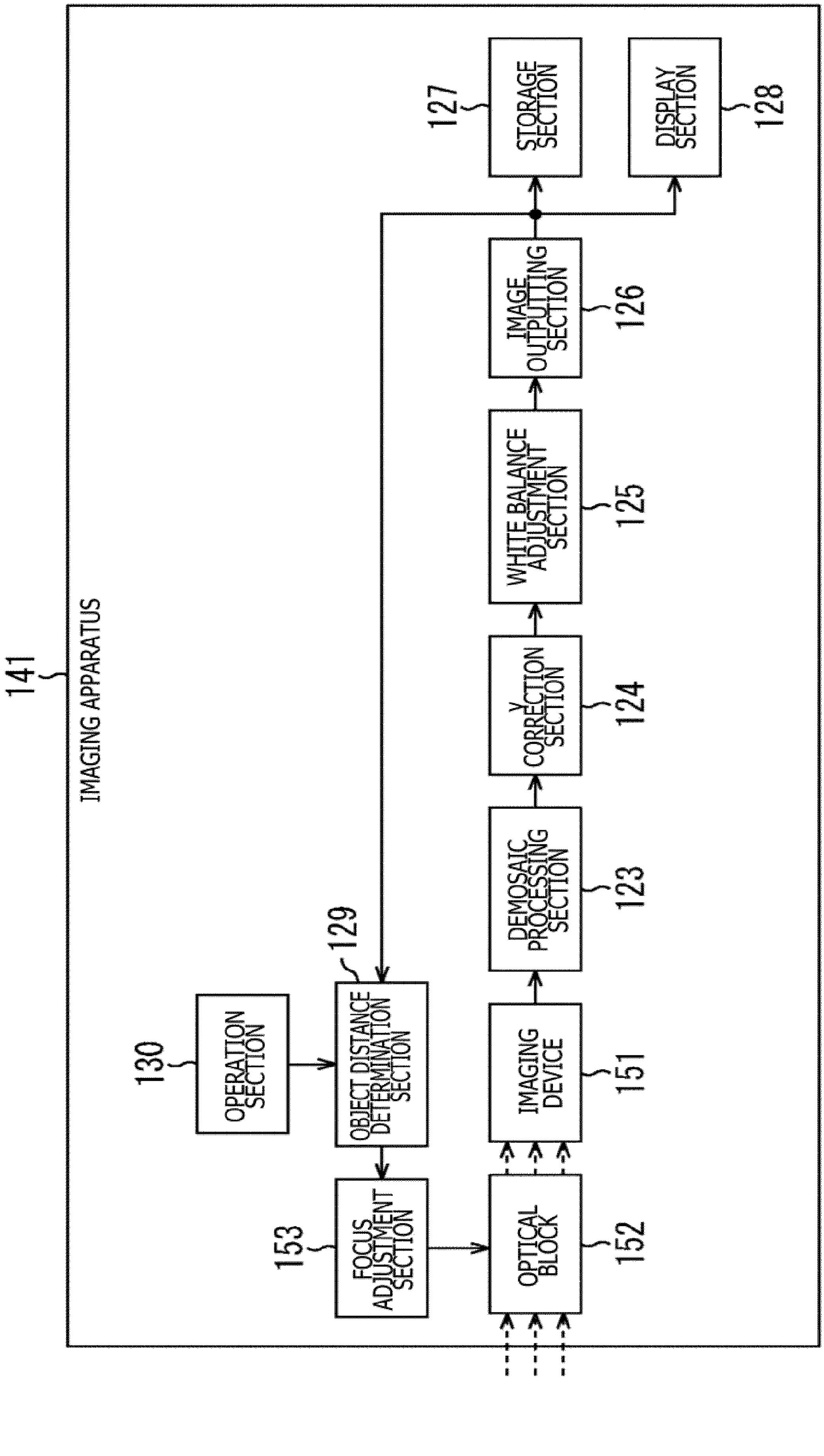
141
IMAGING APPARATUS
130
OPERATION SECTION
129
OBJECT DISTANCE DETERMINATION SECTION
153
FOCUS ADJUSTMENT SECTION
OPTICAL BLOCK
152
IMAGING DEVICE
151
DEMOSAIC PROCESSING SECTION
123
γ CORRECTION SECTION
124
WHITE BALANCE ADJUSTMENT SECTION
125
IMAGE OUTPUTTING SECTION
126
127
STORAGE SECTION
DISPLAY SECTION
128

FIG. 8

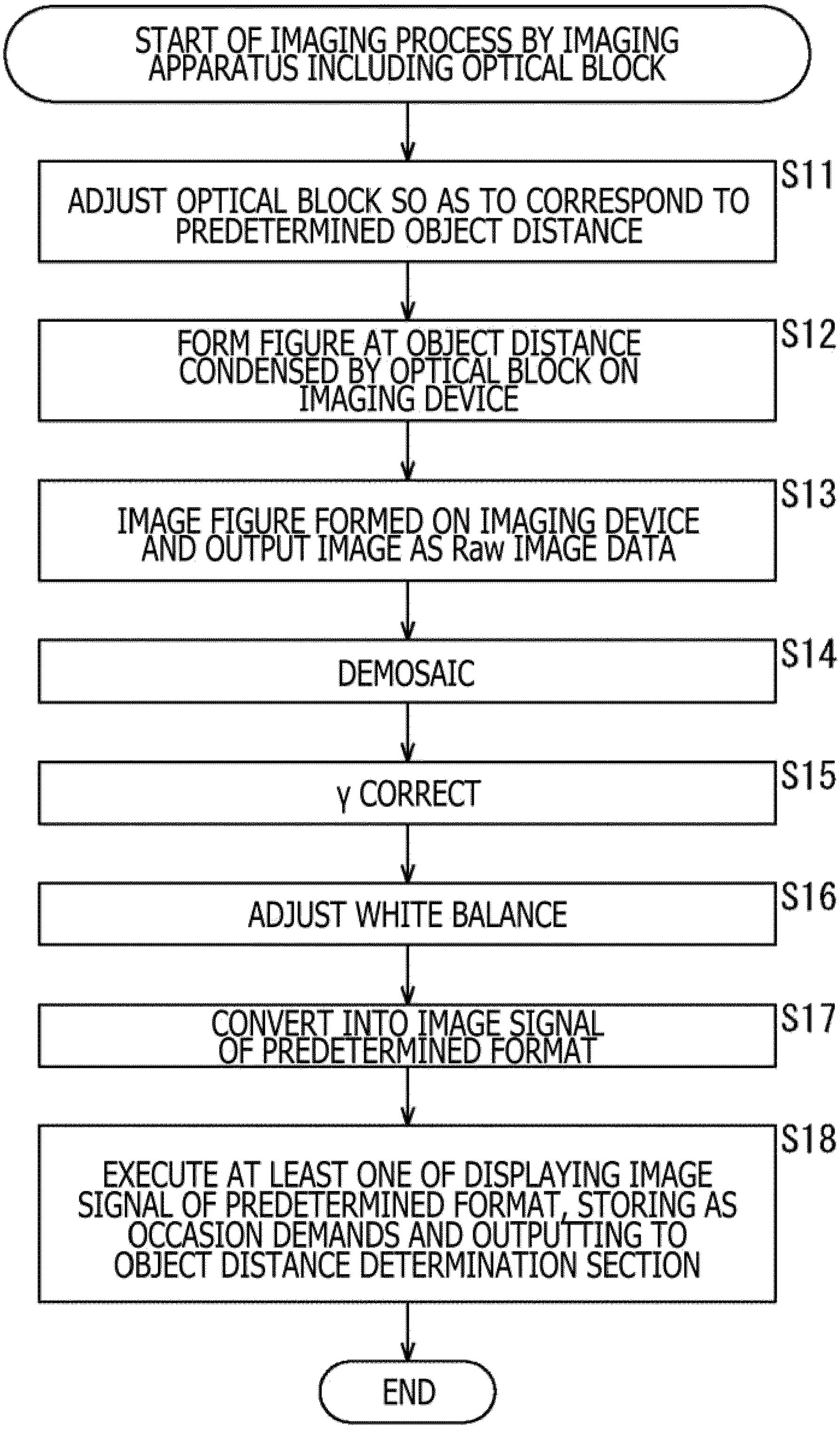
START OF IMAGING PROCESS BY IMAGING APPARATUS INCLUDING OPTICAL BLOCK
ADJUST OPTICAL BLOCK SO AS TO CORRESPOND TO PREDETERMINED OBJECT DISTANCE
S11
FORM FIGURE AT OBJECT DISTANCE CONDENSED BY OPTICAL BLOCK ON IMAGING DEVICE
S12
IMAGE FIGURE FORMED ON IMAGING DEVICE AND OUTPUT IMAGE AS Raw IMAGE DATA
S13
DEMOSAIC
S14
γ CORRECT
S15
ADJUST WHITE BALANCE
S16
CONVERT INTO IMAGE SIGNAL OF PREDETERMINED FORMAT
S17
EXECUTE AT LEAST ONE OF DISPLAYING IMAGE SIGNAL OF PREDETERMINED FORMAT, STORING AS OCCASION DEMANDS AND OUTPUTTING TO OBJECT DISTANCE DETERMINATION SECTION
S18
END

FIG. 9

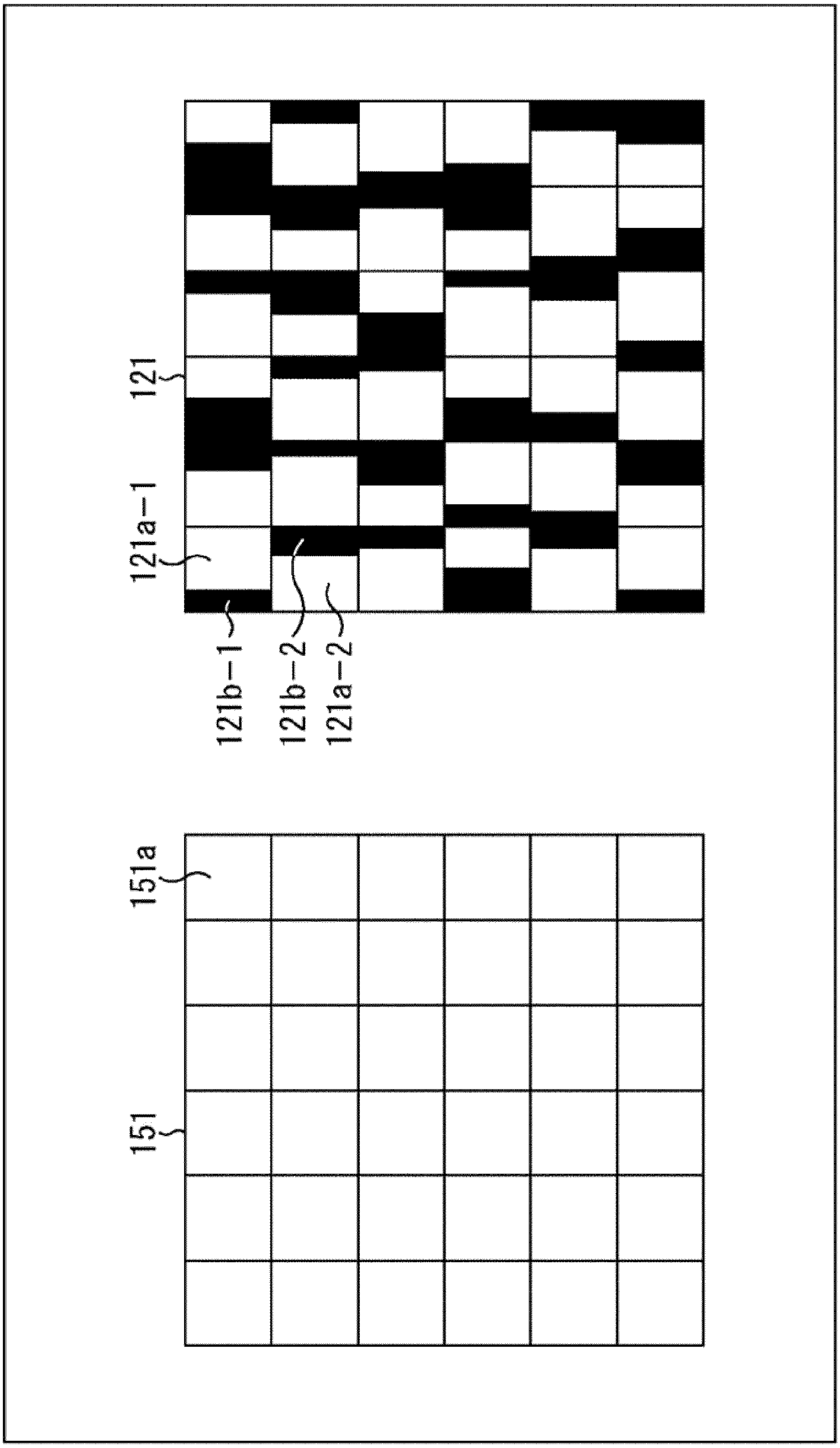

FIG.10

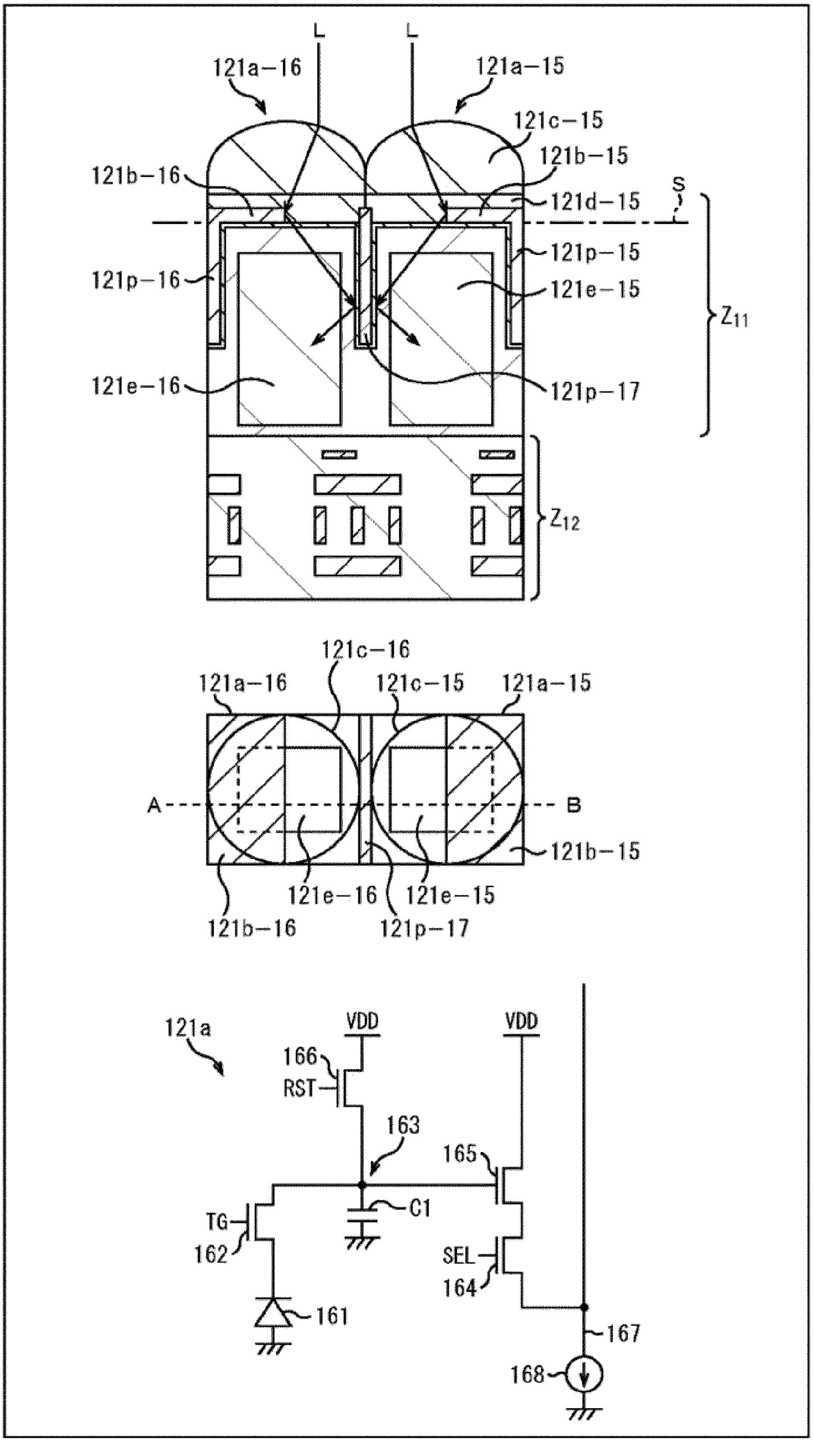
L
L
121a−16
121a−15
121c−15
121b−15
121b−16
S
121d−15
121p−15
121p−16
121e−15
Z11
121e−16
121p−17
Z12
121c−16
121a−16
121c−15
121a−15
A
B
121b−15
121e−16
121e−15
121b−16
121p−17
121a
VDD
VDD
166
RST
163
165
C1
TG
162
SEL
164
161
167
168

FIG.11

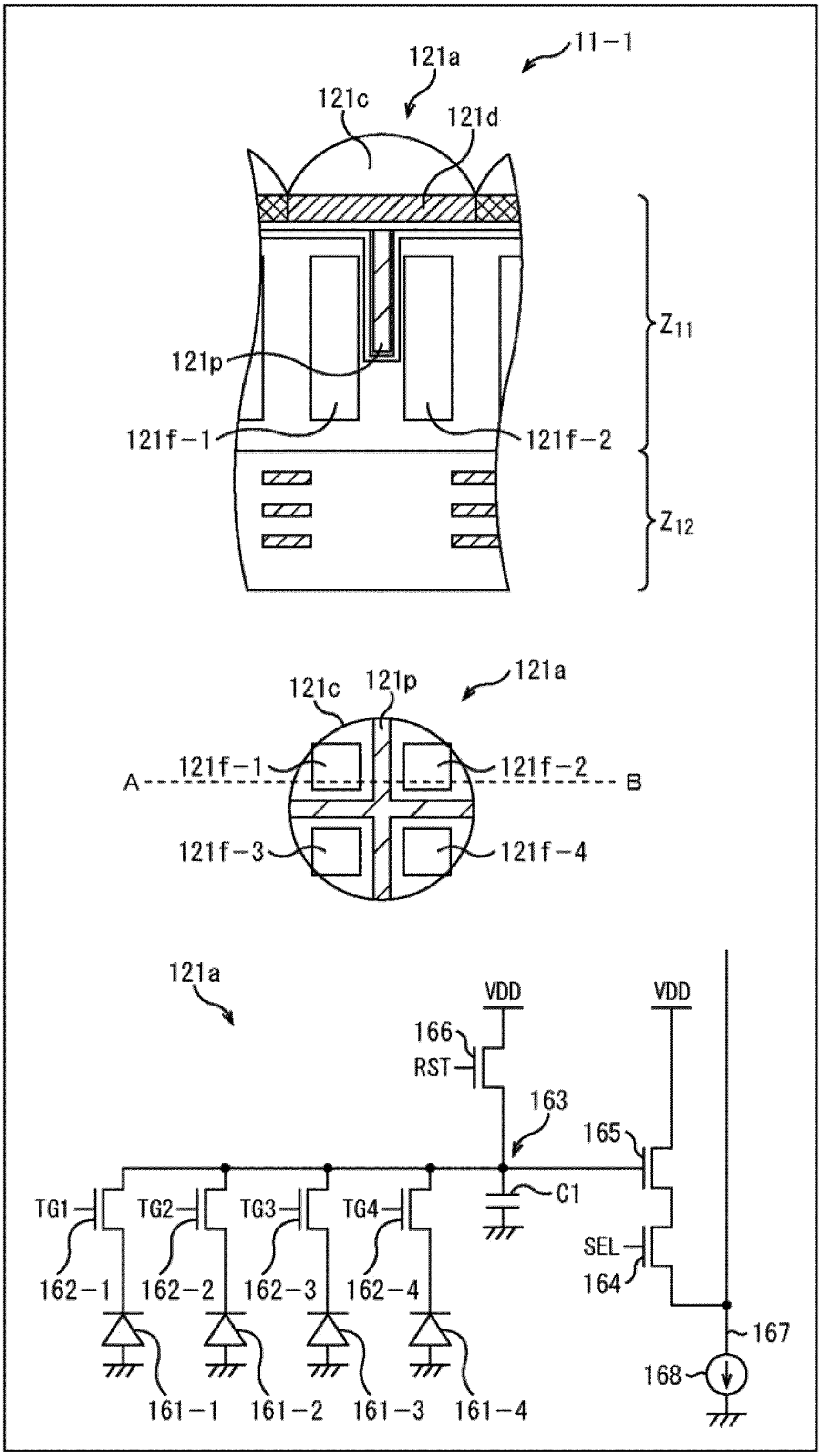
11-1
121a
121c
121d
121p
121f-1
121f-2
Z11
Z12
121a
121c
121p
121f-1
121f-2
A
B
121f-3
121f-4
121a
VDD
VDD
166
RST
163
165
C1
TG1
TG2
TG3
TG4
SEL
162-1
162-2
162-3
162-4
164
167
168
161-1
161-2
161-3
161-4

FIG.12

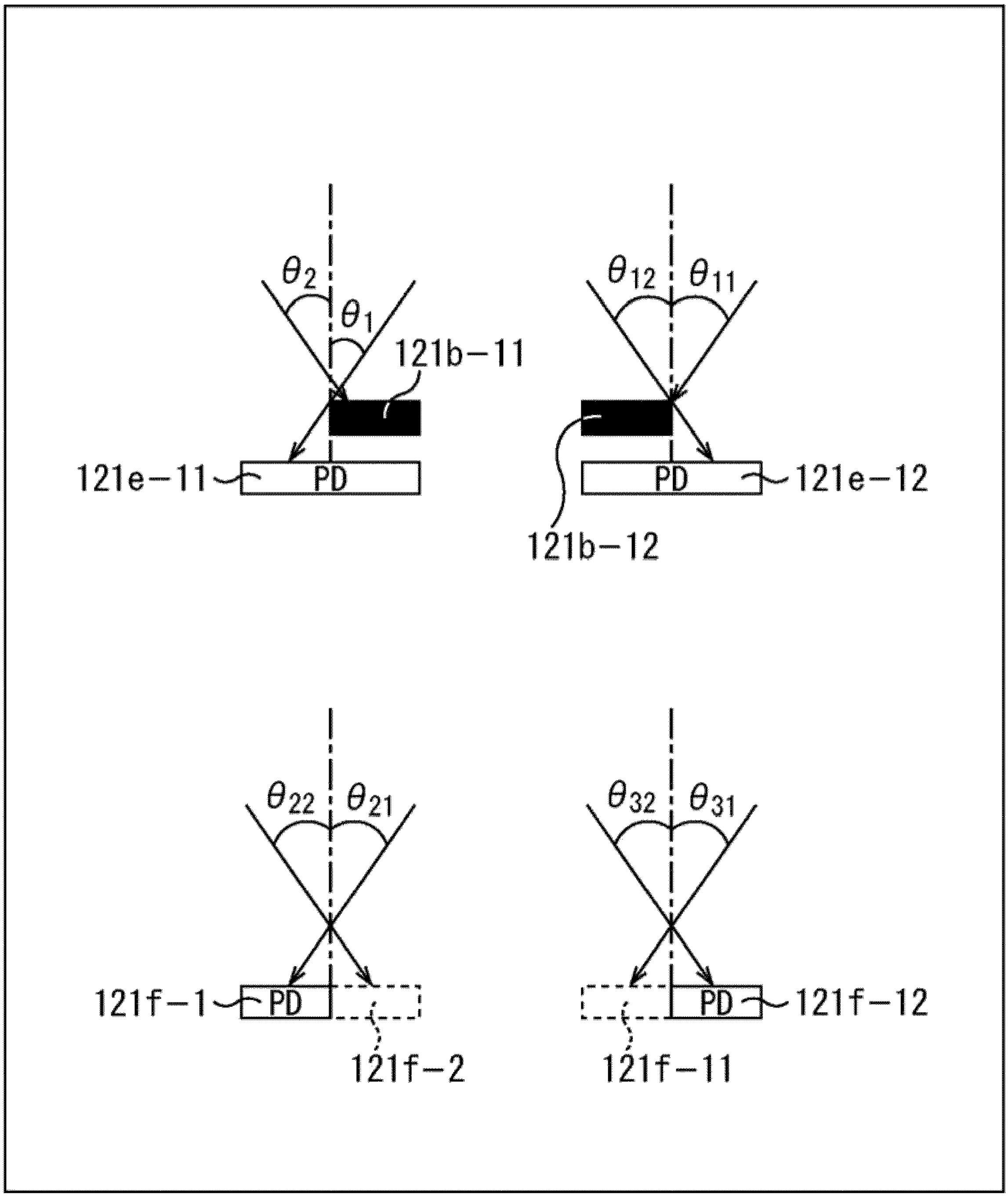
$\theta_2$
$\theta_1$
121b−11
121e−11
PD
$\theta_{12}$
$\theta_{11}$
PD
121e−12
121b−12
$\theta_{22}$
$\theta_{21}$
121f−1
PD
121f−2
$\theta_{32}$
$\theta_{31}$
PD
121f−12
121f−11

FIG.13

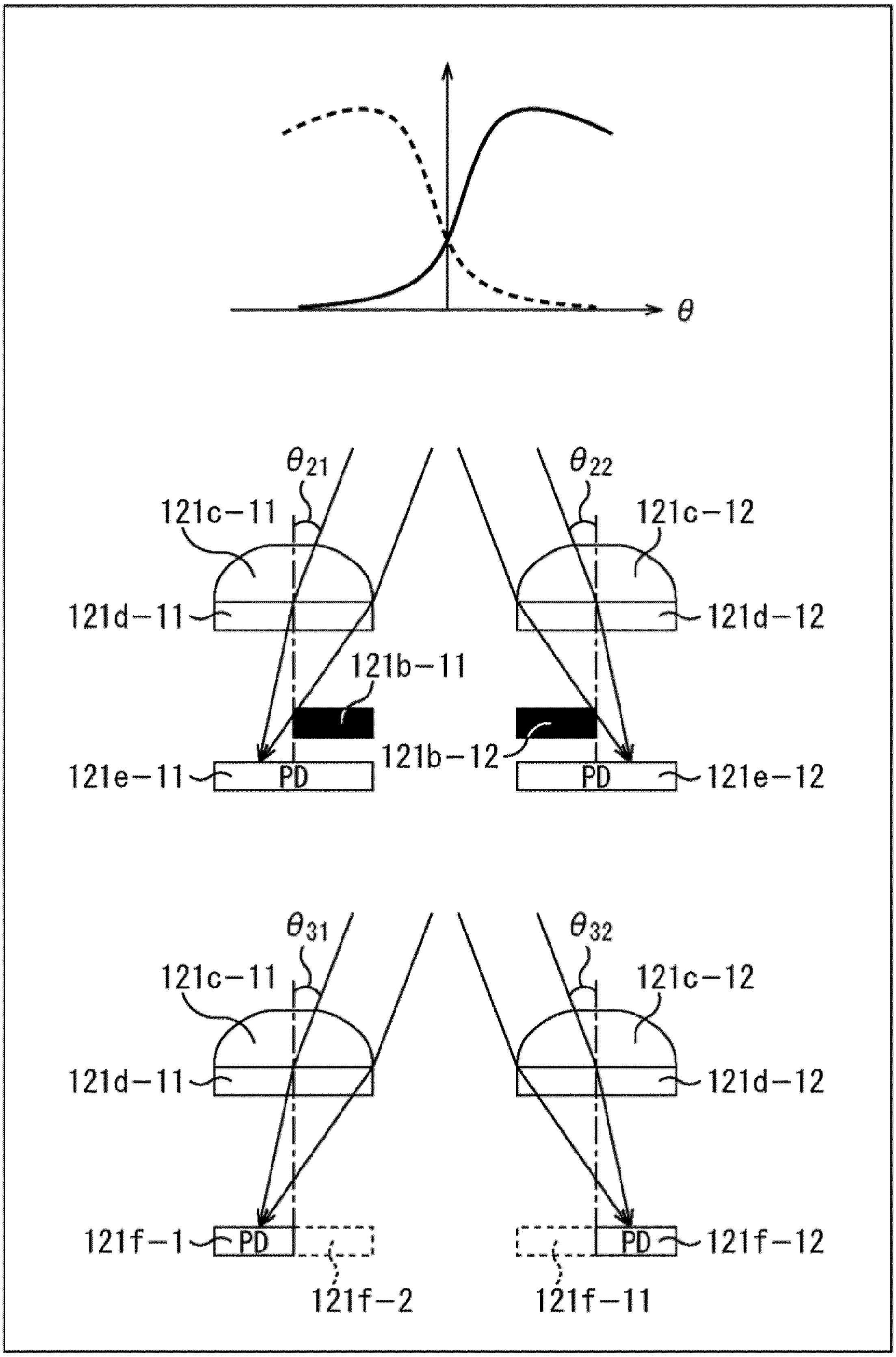
θ
θ21
θ22
121c-11
121c-12
121d-11
121d-12
121b-11
121b-12
121e-11
121e-12
PD
PD
θ31
θ32
121c-11
121c-12
121d-11
121d-12
121f-1
121f-12
121f-2
121f-11
PD
PD

FIG.14

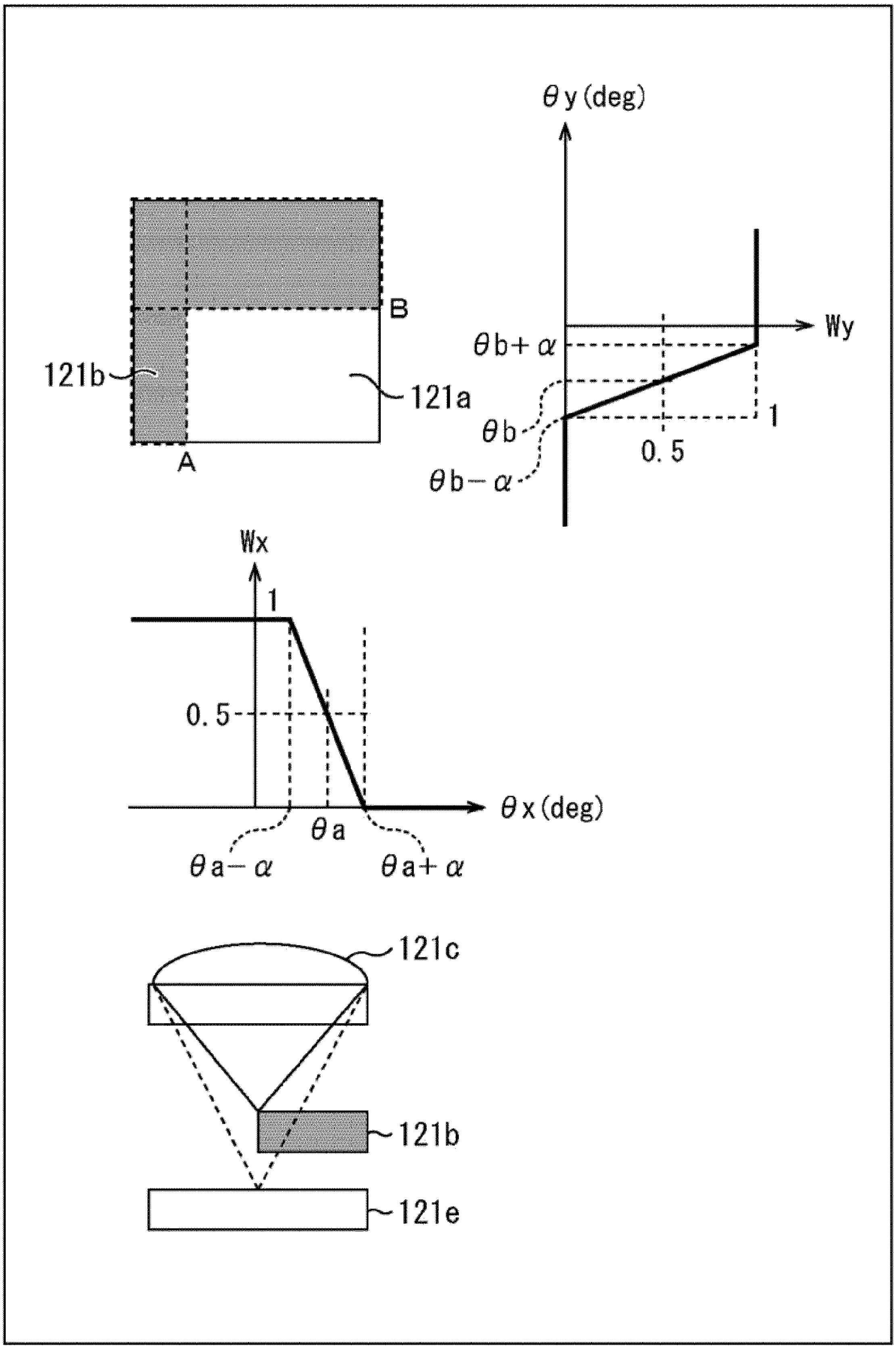
θy(deg)
Wy
B
121b
121a
θb+α
θb
θb−α
A
0.5
1
Wx
1
0.5
θx(deg)
θa
θa−α
θa+α
121c
121b
121e

FIG.15

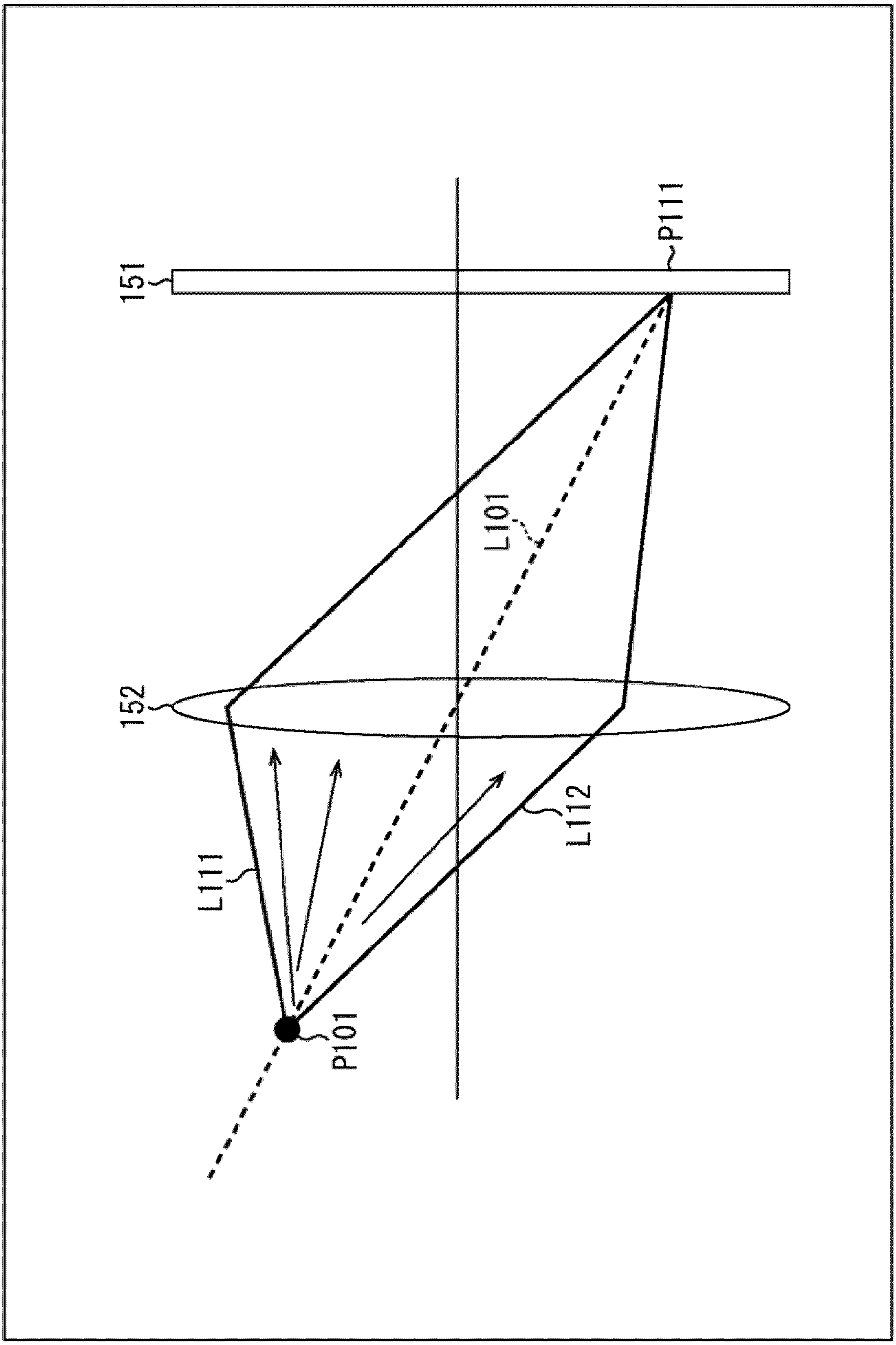

FIG.16

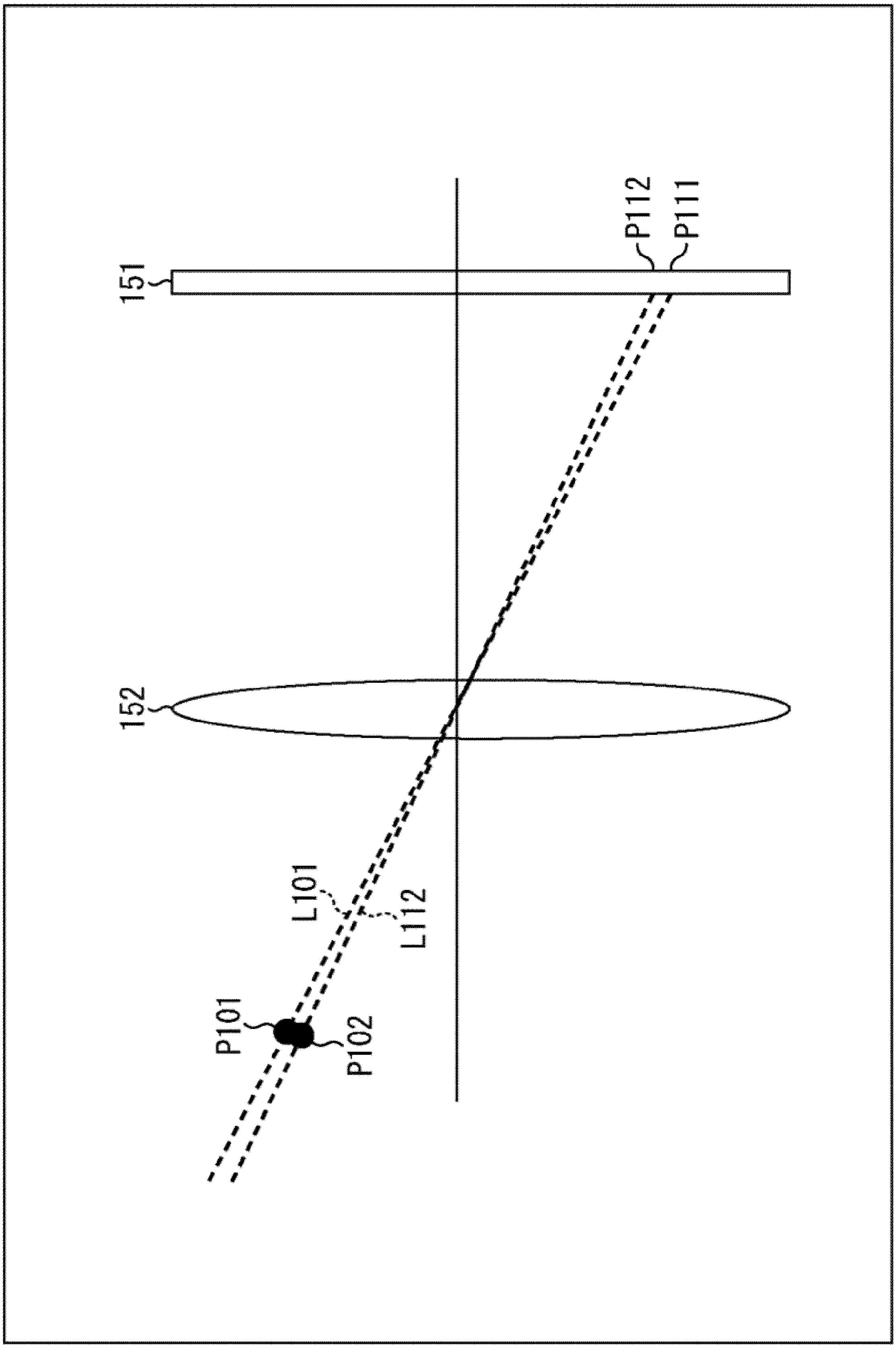

FIG.17

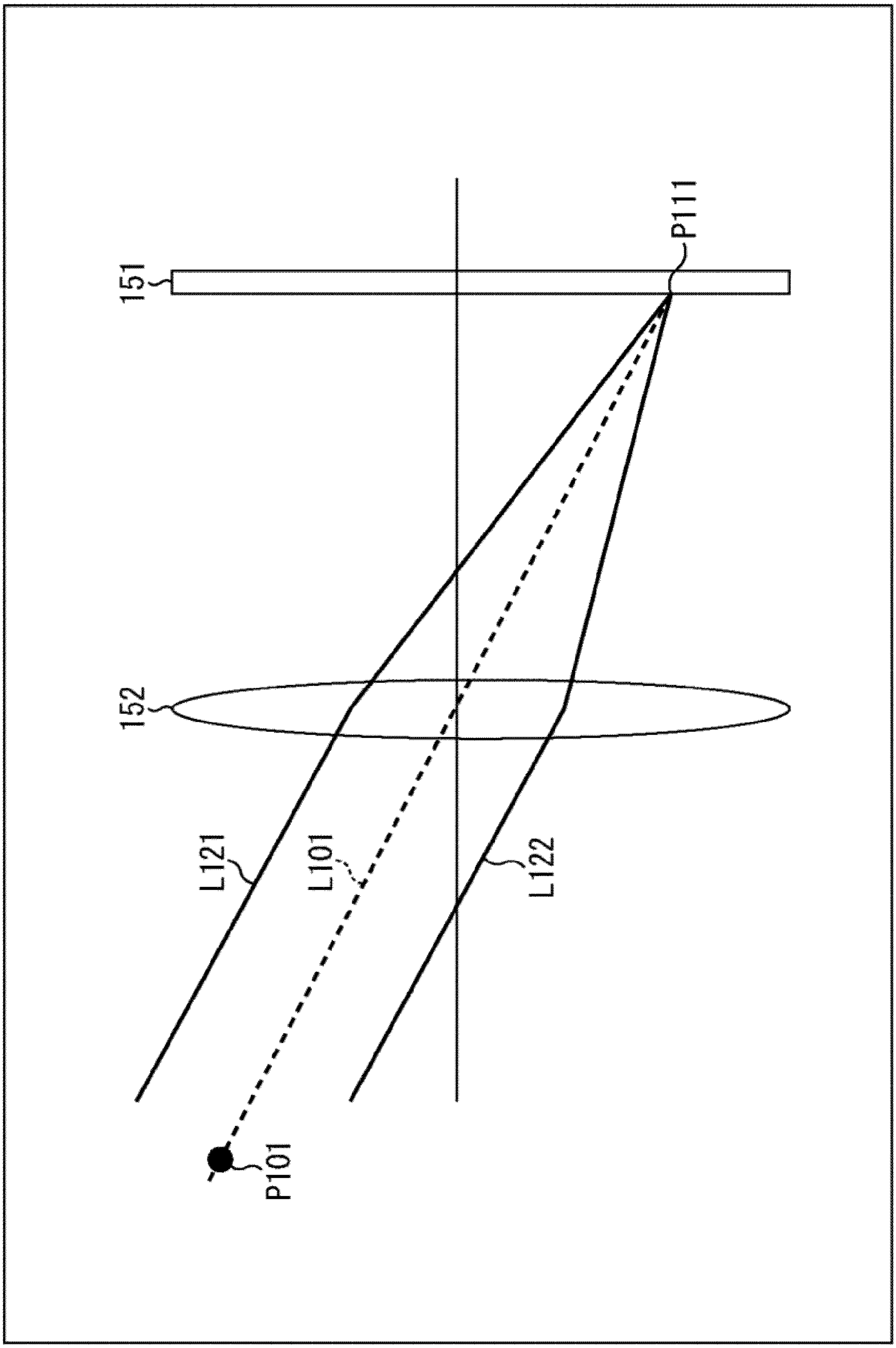

FIG.18

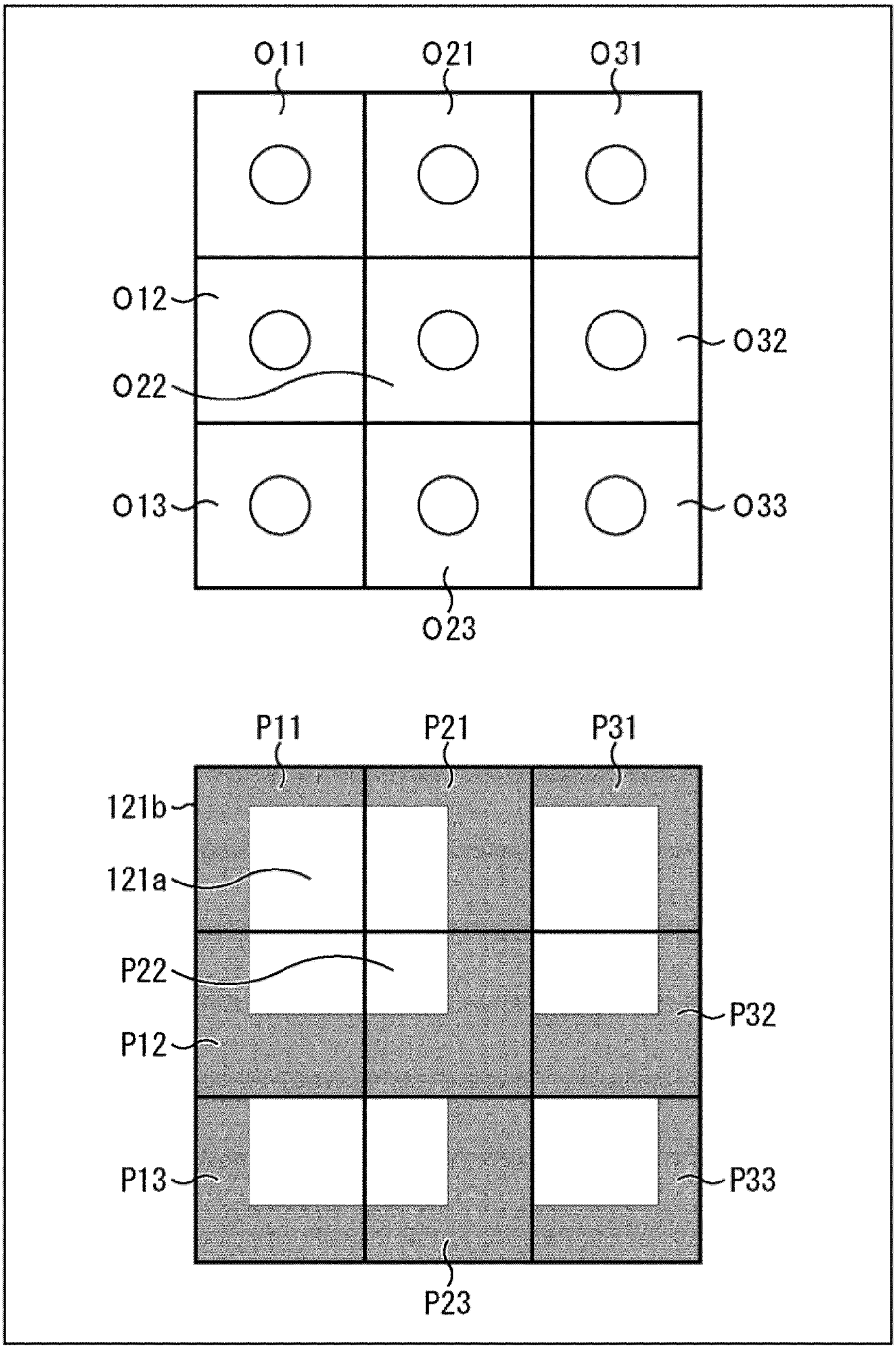
O11
O21
O31
O12
O22
O32
O13
O33
O23
P11
P21
P31
121b
121a
P22
P32
P12
P13
P33
P23

FIG.19

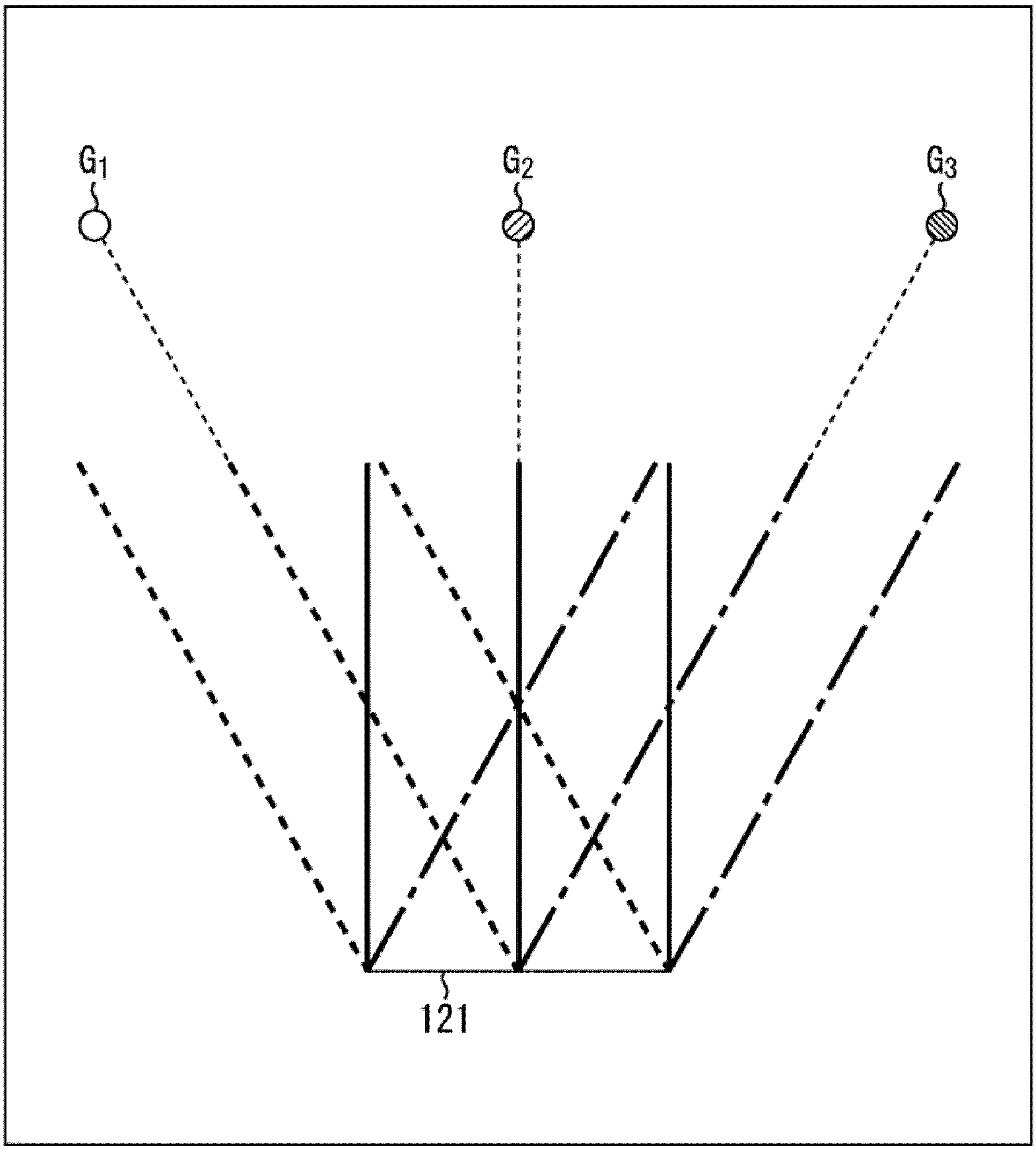

FIG.20

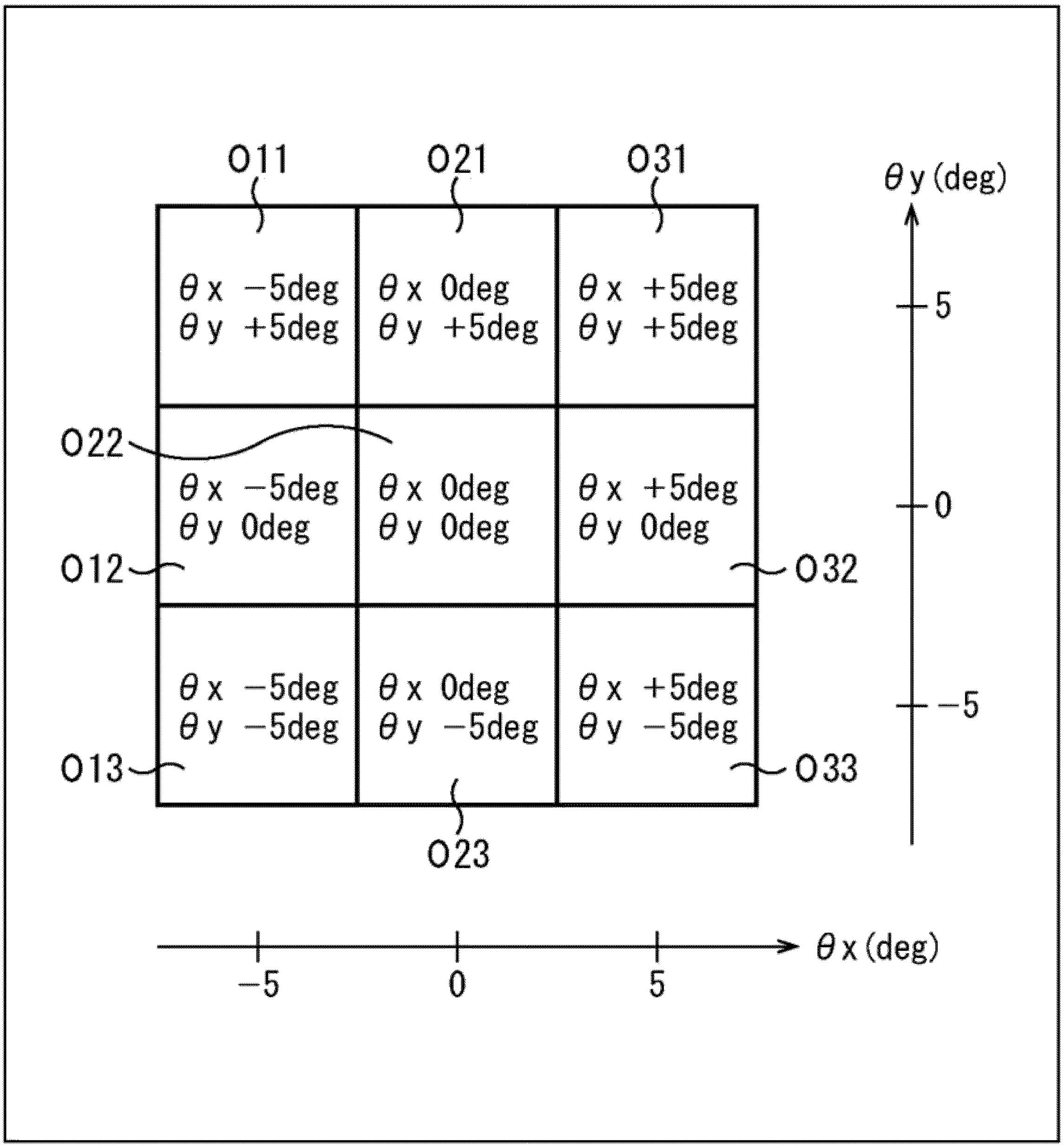
O11
O21
O31
θy (deg)
θx −5deg
θy +5deg
θx 0deg
θy +5deg
θx +5deg
θy +5deg
5
O22
θx −5deg
θy 0deg
θx 0deg
θy 0deg
θx +5deg
θy 0deg
0
O12
O32
θx −5deg
θy −5deg
θx 0deg
θy −5deg
θx +5deg
θy −5deg
−5
O13
O33
O23
θx (deg)
−5
0
5

FIG. 21

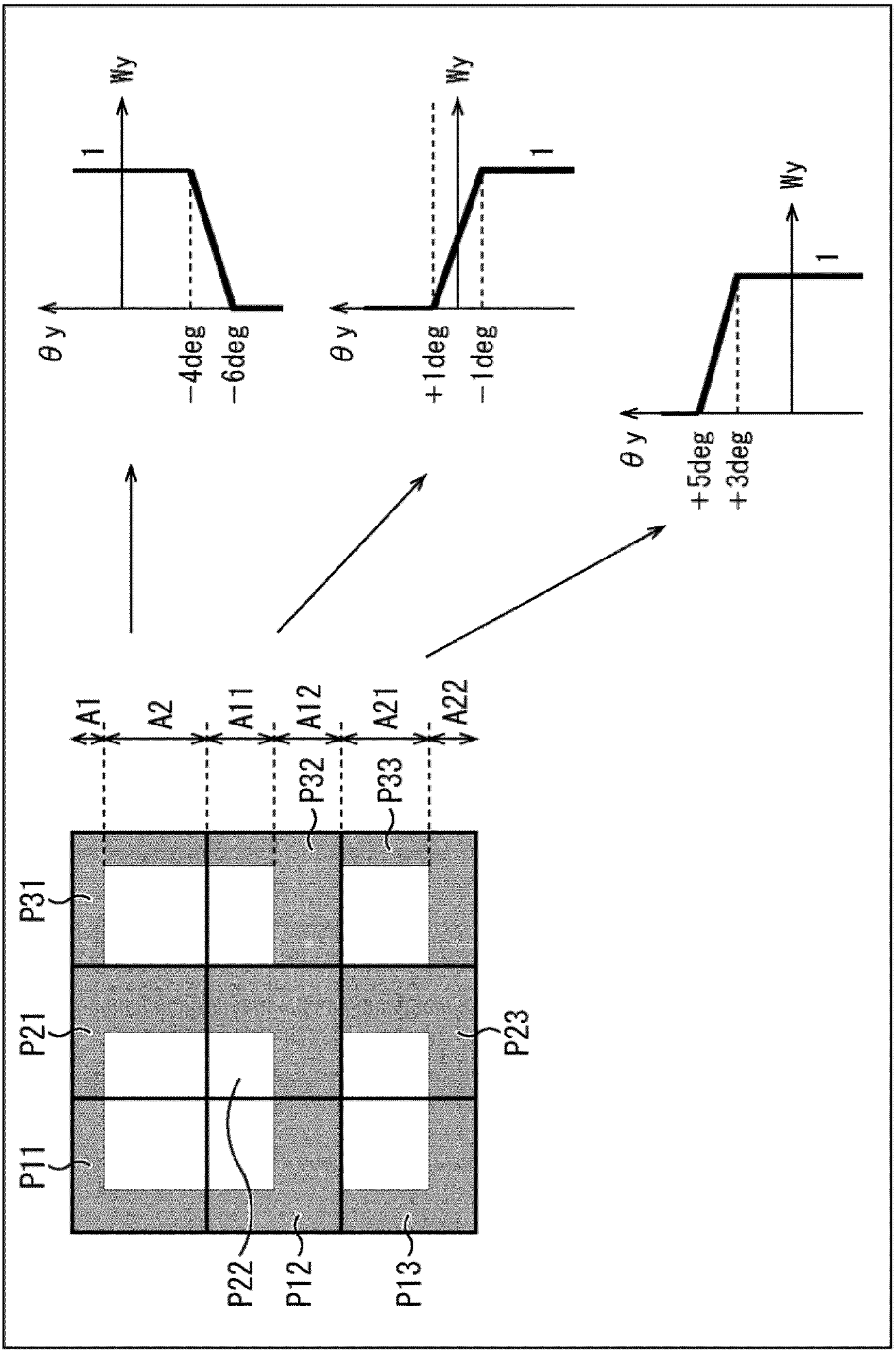
P11
P21
P31
P22
P12
P13
P23
P32
P33
A1
A2
A11
A12
A21
A22
θy
Wy
1
−4deg
−6deg
θy
Wy
1
+1deg
−1deg
θy
Wy
1
+5deg
+3deg

FIG.22

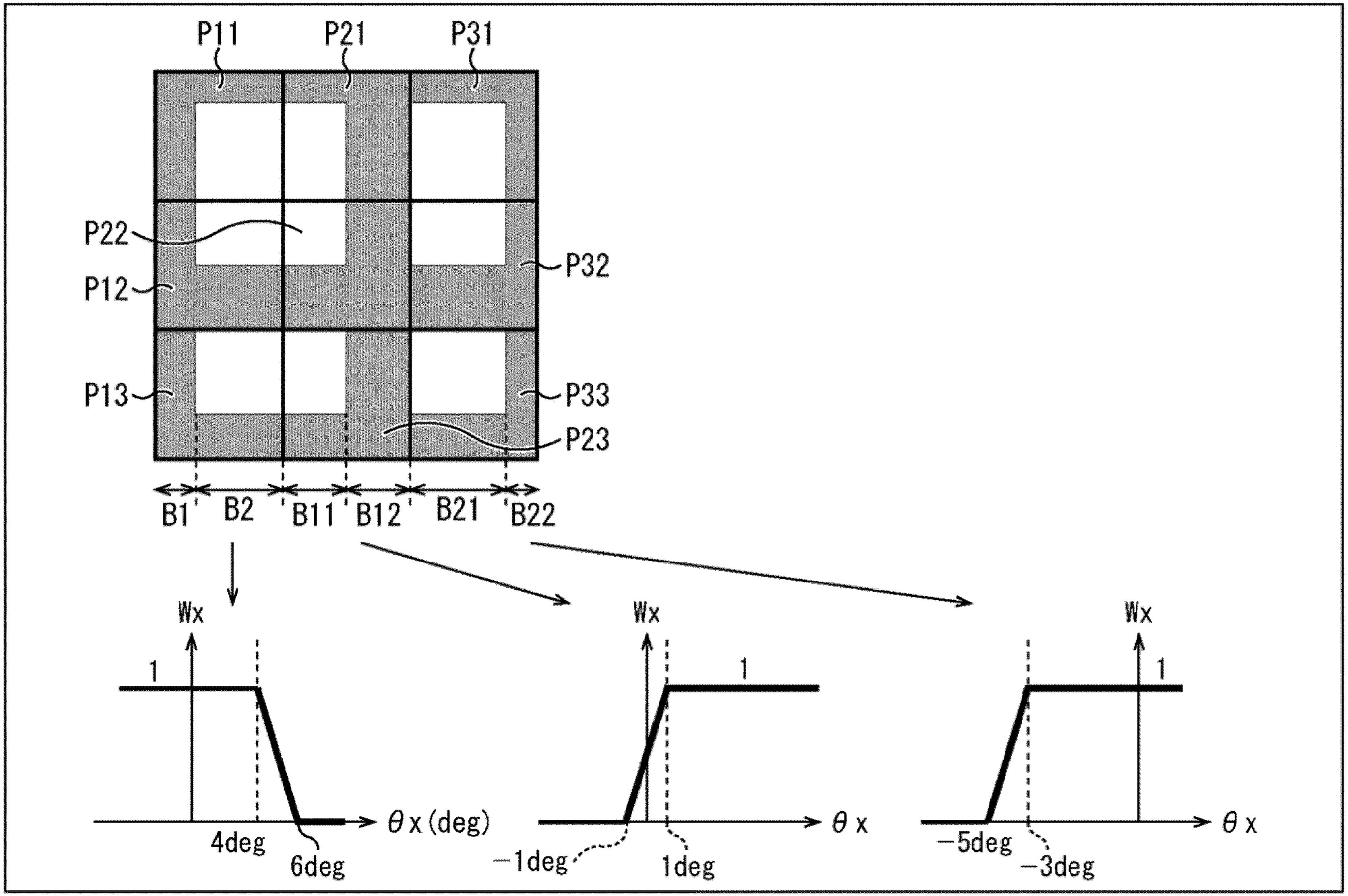

P11
P21
P31
P22
P12
P32
P13
P33
P23
B1
B2
B11
B12
B21
B22
Wx
1
4deg
6deg
θx(deg)
Wx
1
−1deg
1deg
θx
Wx
1
−5deg
−3deg
θx

FIG. 23

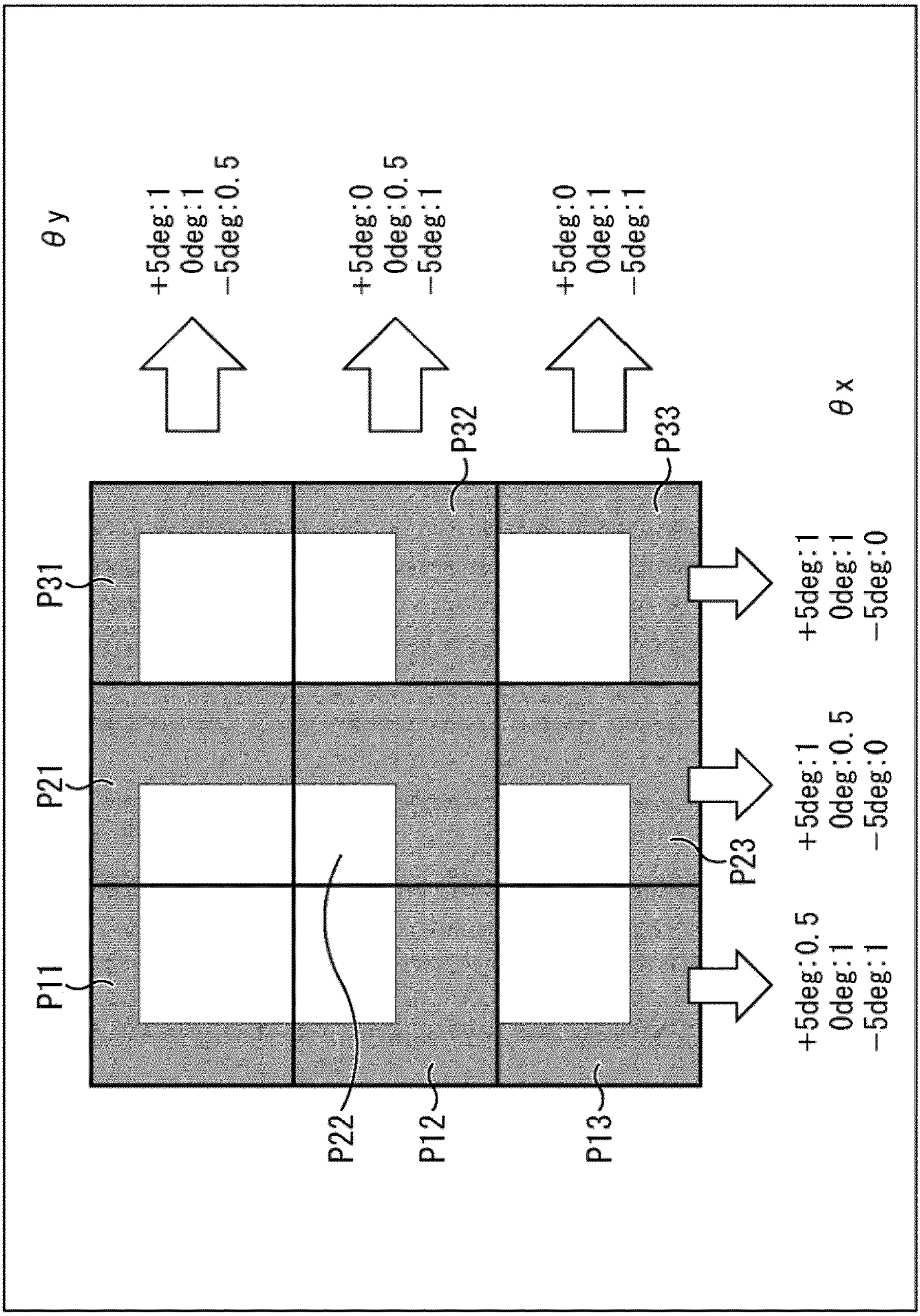
θy
+5deg:1
0deg:1
−5deg:0.5
+5deg:0
0deg:0.5
−5deg:1
+5deg:0
0deg:1
−5deg:1
θx
P31
P21
P11
P32
P33
P22
P12
P13
P23
+5deg:1
0deg:1
−5deg:0
+5deg:1
0deg:0.5
−5deg:0
+5deg:0.5
0deg:1
−5deg:1

FIG.24

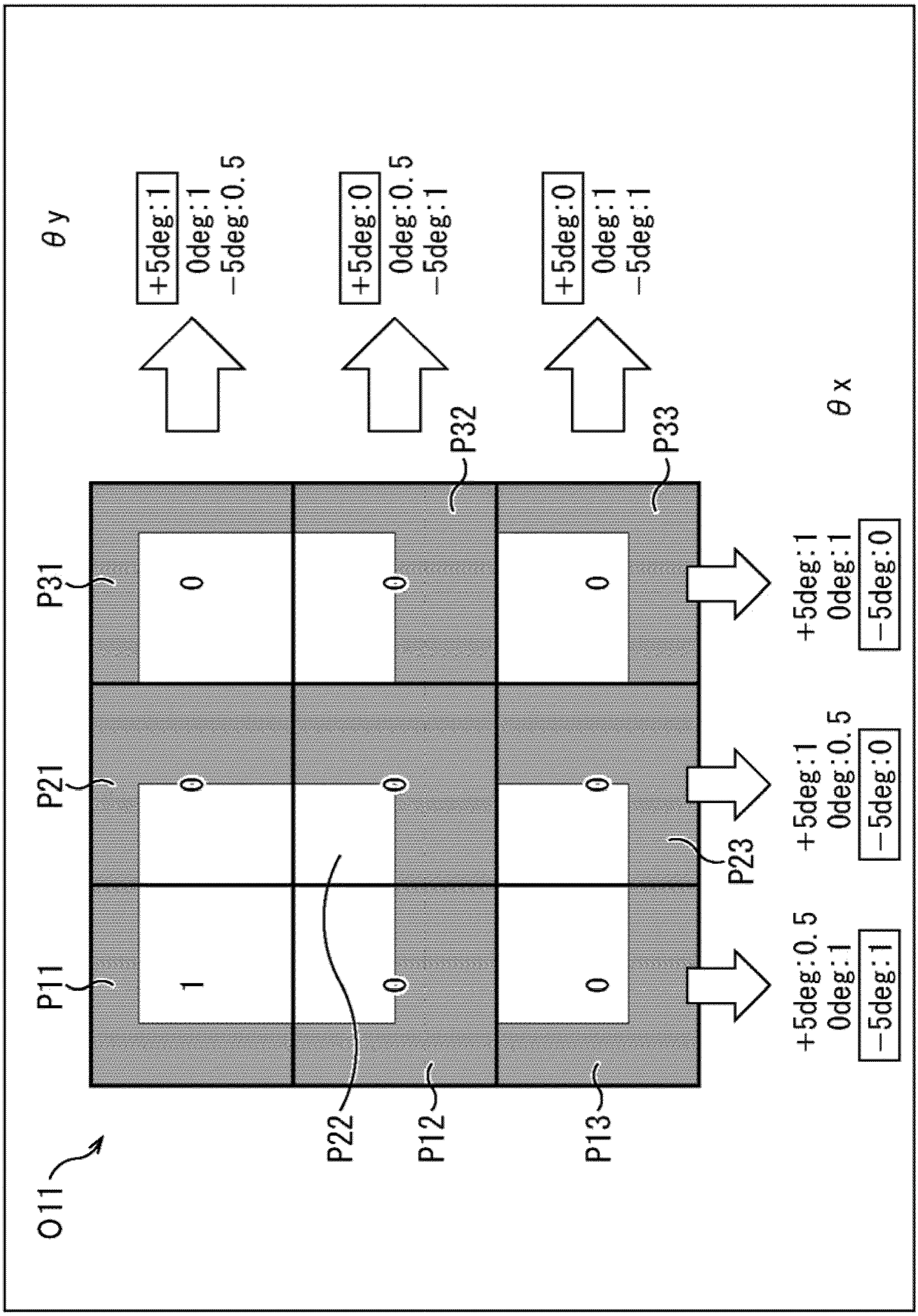

O11
P11
P21
P31
P22
P12
P13
P23
P32
P33
1
0
θy
+5deg:1
0deg:1
-5deg:0.5
+5deg:0
0deg:0.5
-5deg:1
+5deg:0
0deg:1
-5deg:1
θx
+5deg:0.5
0deg:1
-5deg:1
+5deg:1
0deg:0.5
-5deg:0
+5deg:1
0deg:1
-5deg:0

FIG.25

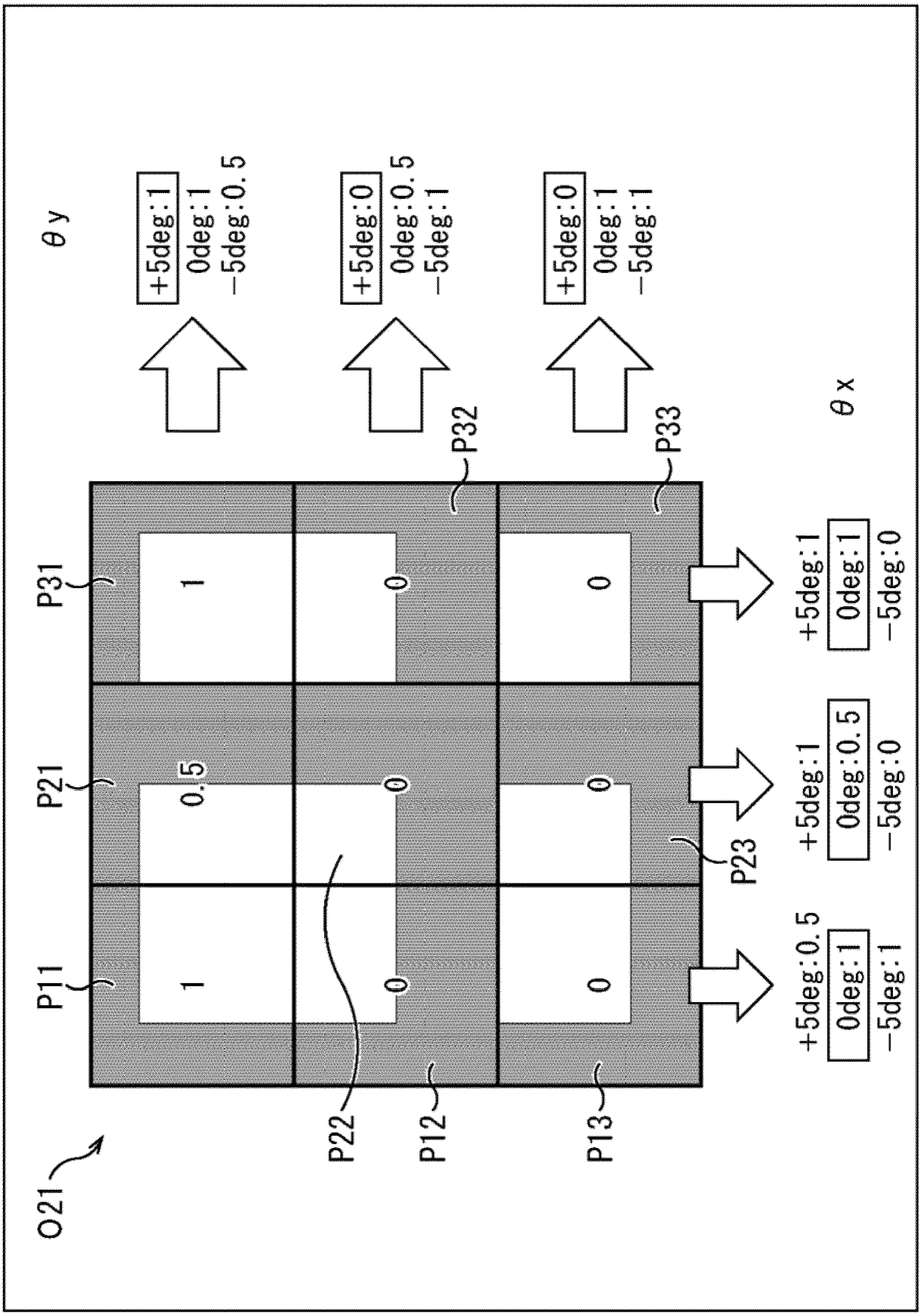
O21
P11
P21
P31
P22
P12
P32
P13
P23
P33
1
0.5
1
0
0
0
0
0
0
θy
+5deg:1
0deg:1
-5deg:0.5
+5deg:0
0deg:0.5
-5deg:1
+5deg:0
0deg:1
-5deg:1
θx
+5deg:0.5
0deg:1
-5deg:1
+5deg:1
0deg:0.5
-5deg:0
+5deg:1
0deg:1
-5deg:0

FIG.26

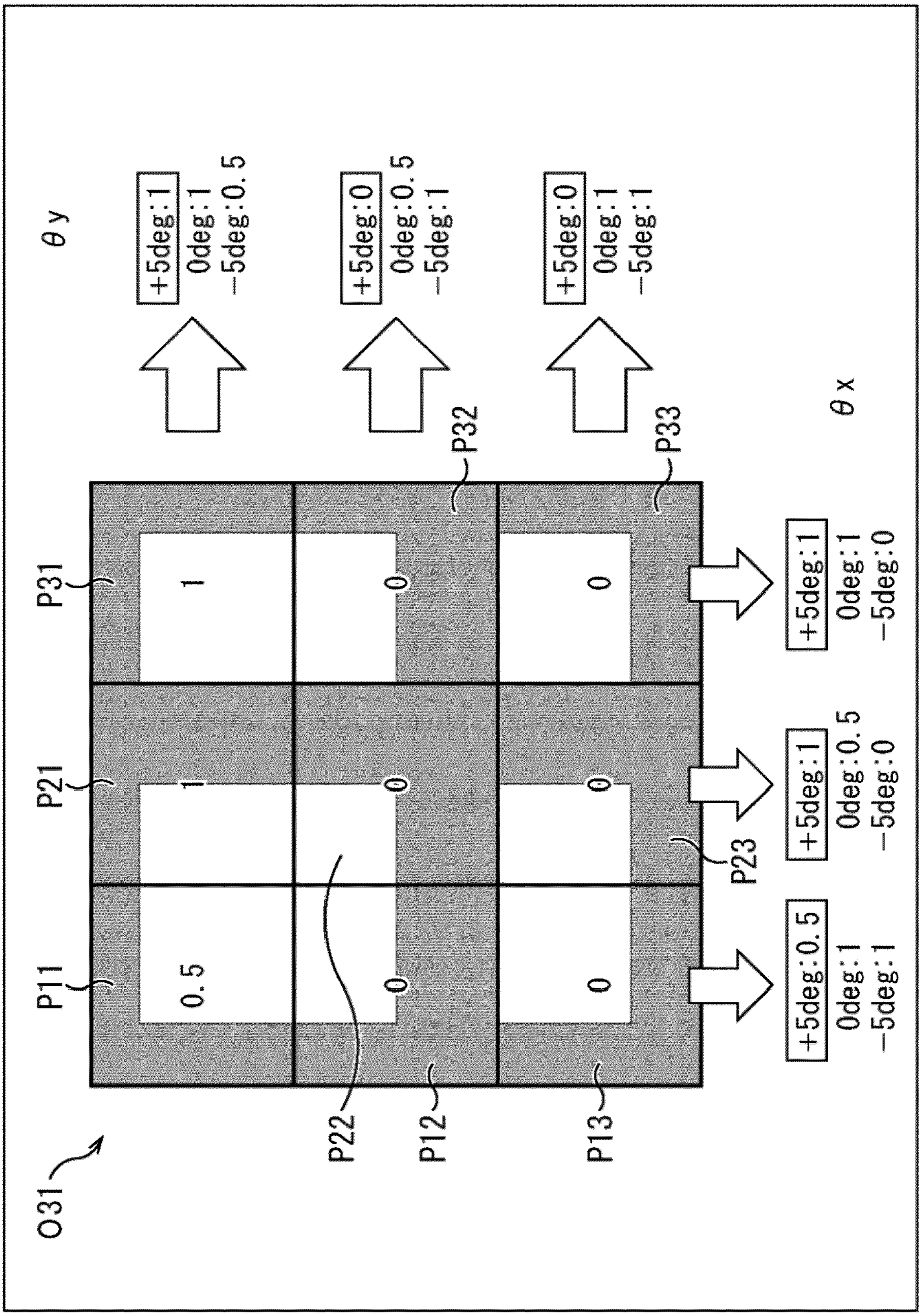
θy
+5deg:1
0deg:1
-5deg:0.5
+5deg:0
0deg:0.5
-5deg:1
+5deg:0
0deg:1
-5deg:1
θx
O31
P11
P21
P31
P12
P22
P32
P13
P23
P33
0.5
1
1
0
0
0
0
0
0
+5deg:0.5
0deg:1
-5deg:1
+5deg:1
0deg:0.5
-5deg:0
+5deg:1
0deg:1
-5deg:0

FIG. 27

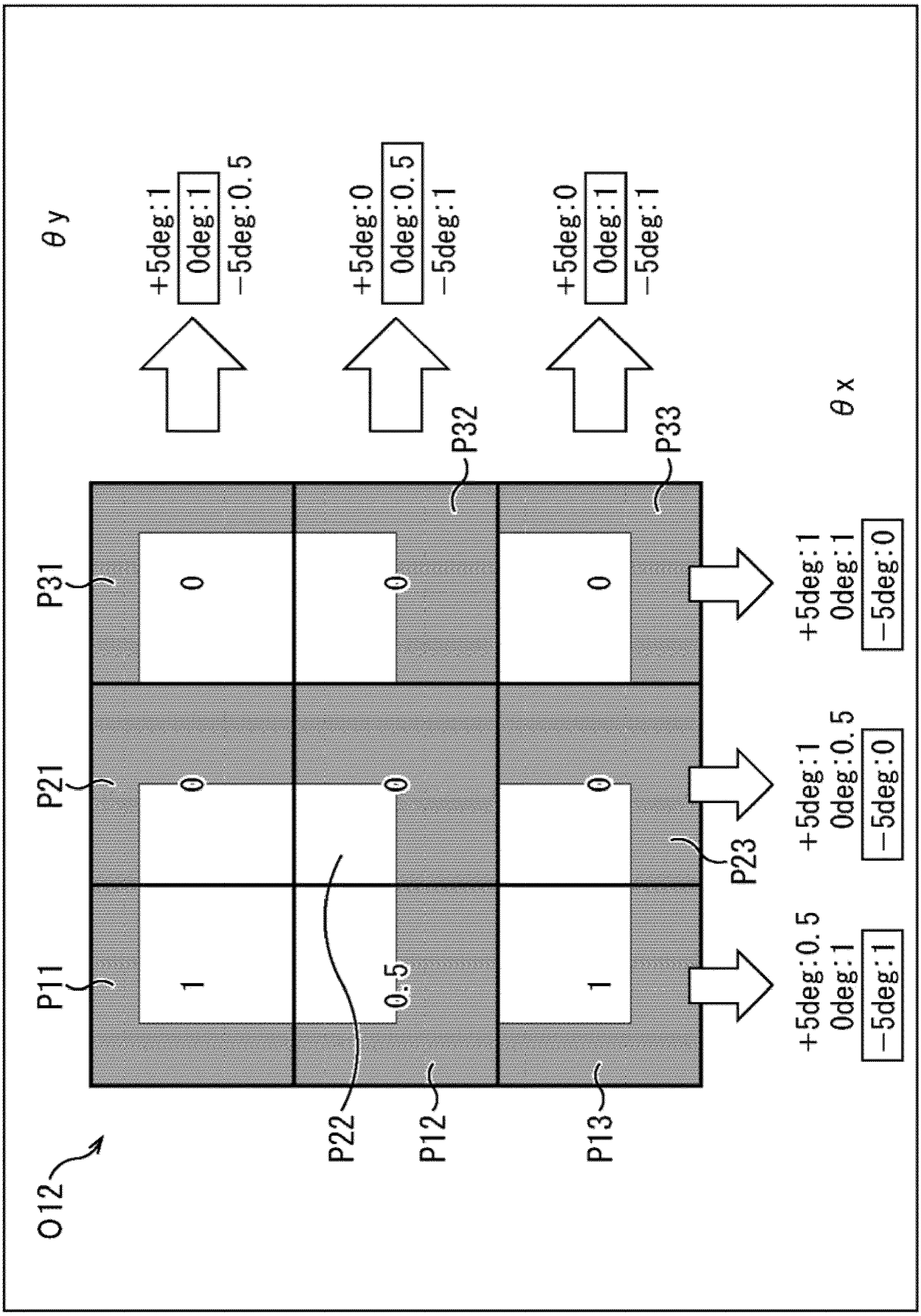
O12
P11
P21
P31
P12
P22
P32
P13
P23
P33
1
0
0
0.5
0
0
1
0
0
θy
+5deg:1
0deg:1
−5deg:0.5
+5deg:0
0deg:0.5
−5deg:1
+5deg:0
0deg:1
−5deg:1
θx
+5deg:0.5
0deg:1
−5deg:1
+5deg:1
0deg:0.5
−5deg:0
+5deg:1
0deg:1
−5deg:0

FIG.28

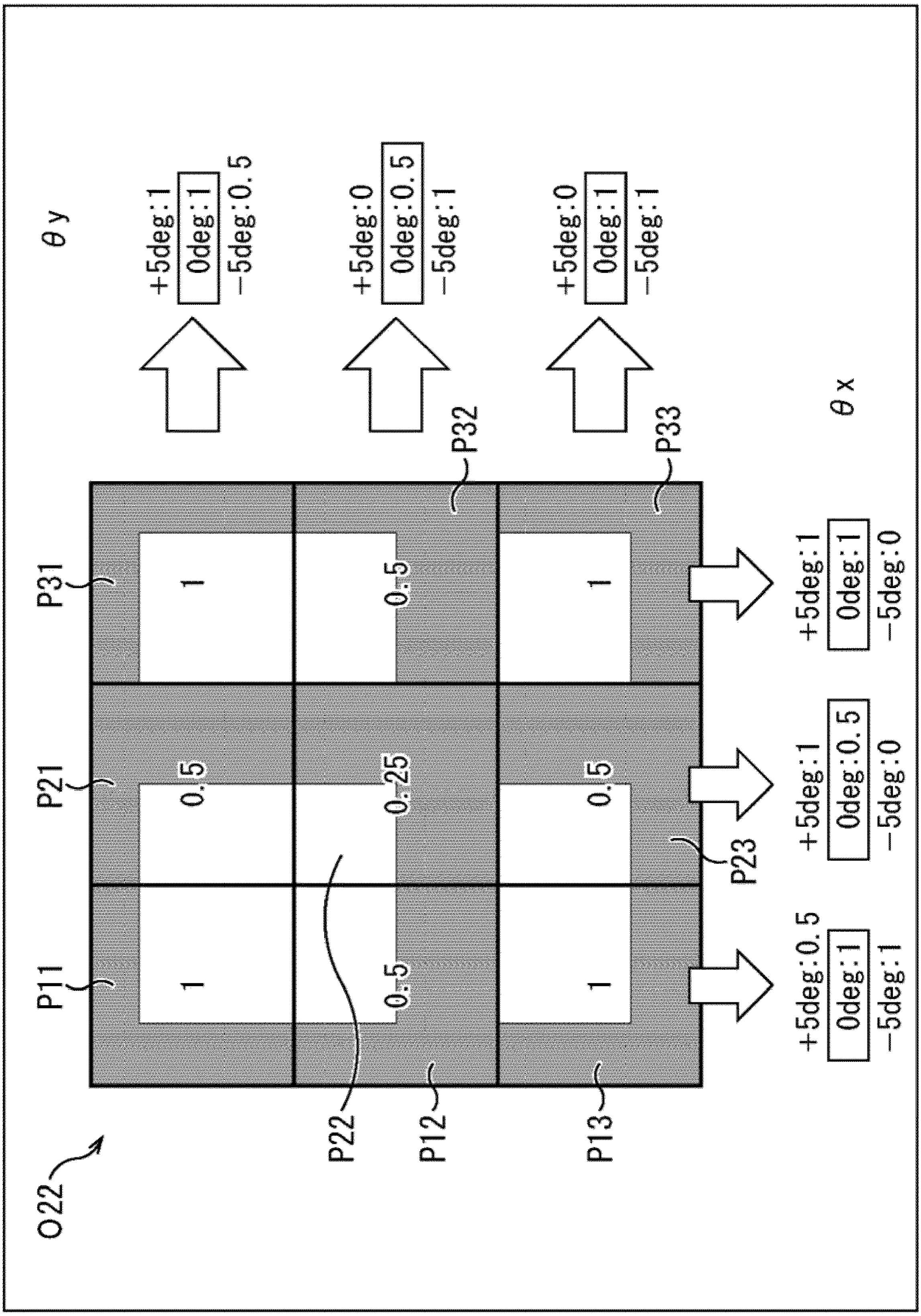
O22
P11
P21
P31
P22
P12
P13
P23
P32
P33
1
0.5
1
0.5
0.25
0.5
1
0.5
1
θy
+5deg:1
0deg:1
−5deg:0.5
+5deg:0
0deg:0.5
−5deg:1
+5deg:0
0deg:1
−5deg:1
θx
+5deg:0.5
0deg:1
−5deg:1
+5deg:1
0deg:0.5
−5deg:0
+5deg:1
0deg:1
−5deg:0

FIG.29

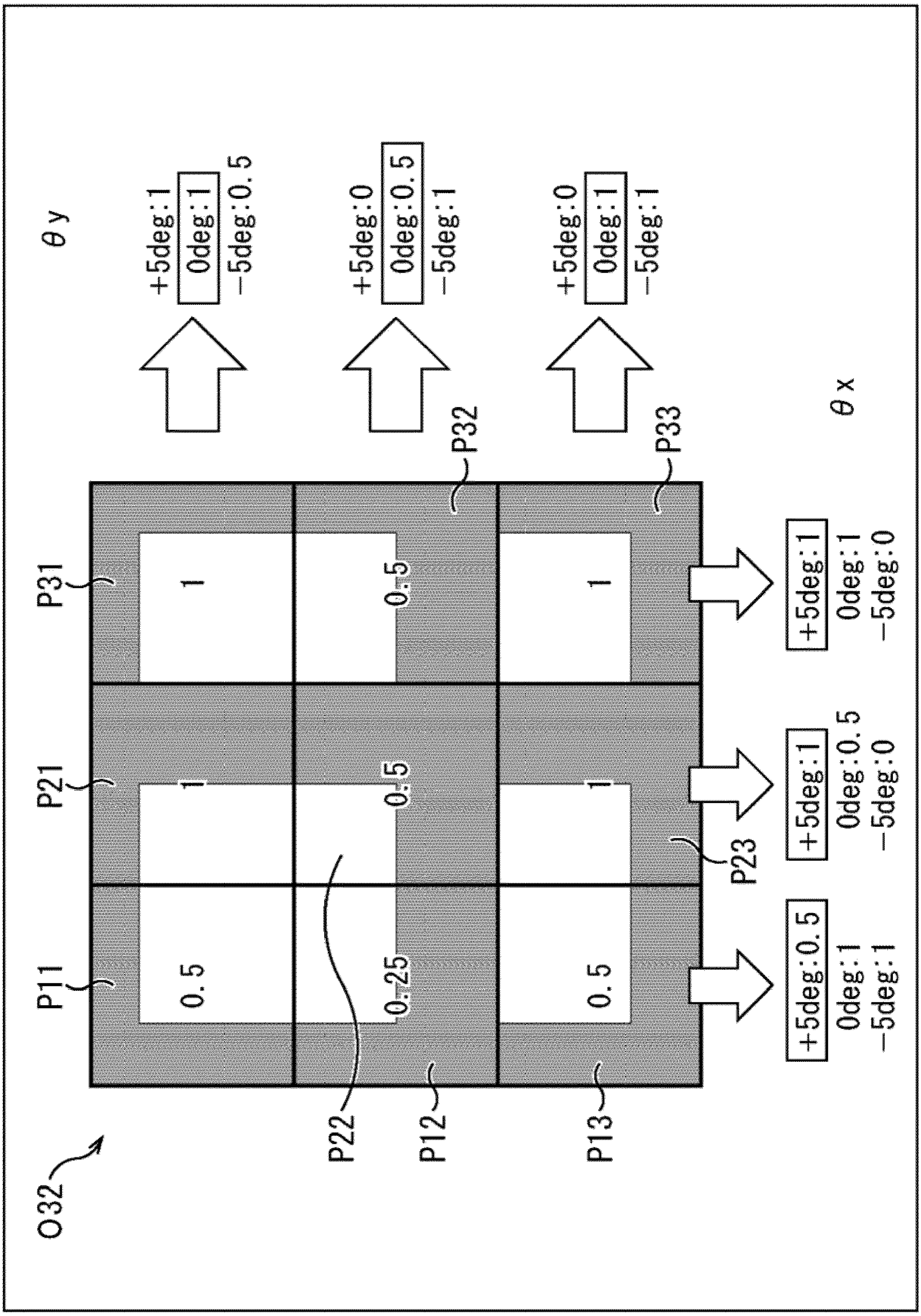
O32
P11
P21
P31
P12
P22
P32
P13
P23
P33
0.5
1
1
0.25
0.5
0.5
0.5
1
1
θy
+5deg:1
0deg:1
−5deg:0.5
+5deg:0
0deg:0.5
−5deg:1
+5deg:0
0deg:1
−5deg:1
θx
+5deg:0.5
0deg:1
−5deg:1
+5deg:1
0deg:0.5
−5deg:0
+5deg:1
0deg:1
−5deg:0

FIG. 30

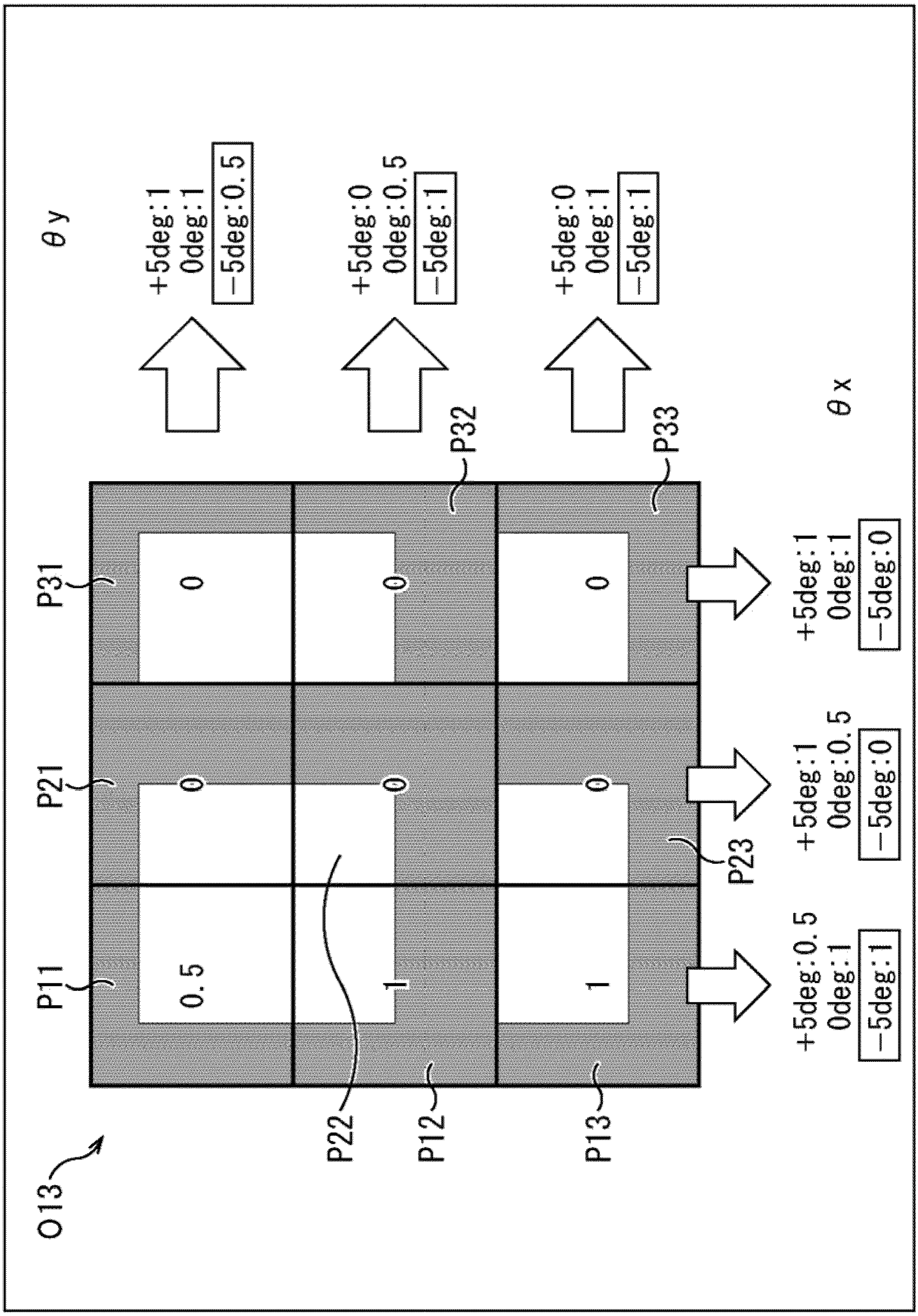
O13
P11
P21
P31
P22
P12
P13
P23
P32
P33
0.5
0
0
1
0
0
1
0
0
θy
+5deg:1
0deg:1
−5deg:0.5
+5deg:0
0deg:0.5
−5deg:1
+5deg:0
0deg:1
−5deg:1
θx
+5deg:0.5
0deg:1
−5deg:1
+5deg:1
0deg:0.5
−5deg:0
+5deg:1
0deg:1
−5deg:0

FIG. 31

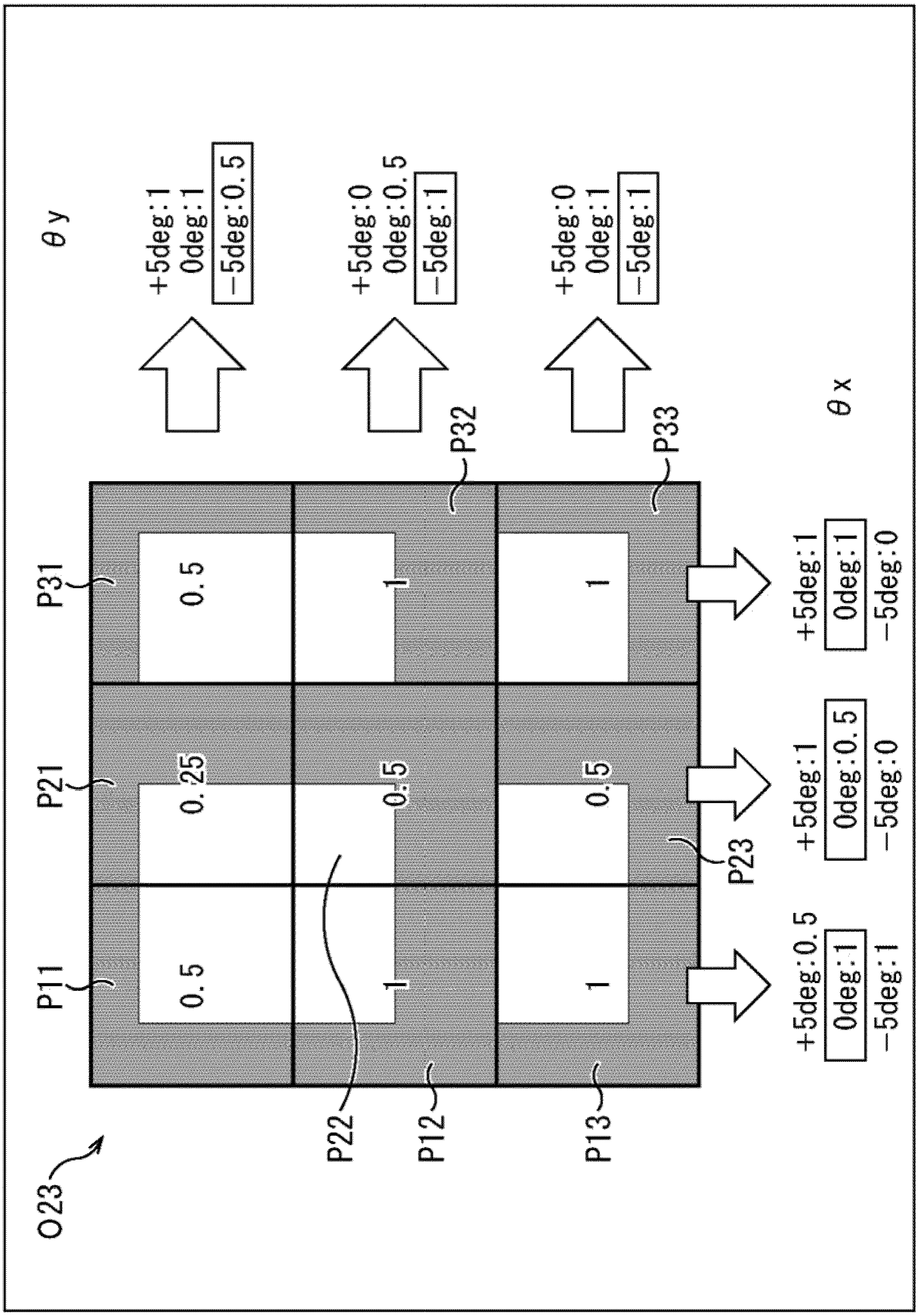
O23
P11
P21
P31
P22
P12
P13
P23
P32
P33
0.5
0.25
0.5
1
0.5
1
1
0.5
1
θy
+5deg:1
0deg:1
−5deg:0.5
+5deg:0
0deg:0.5
−5deg:1
+5deg:0
0deg:1
−5deg:1
θx
+5deg:0.5
0deg:1
−5deg:1
+5deg:1
0deg:0.5
−5deg:0
+5deg:1
0deg:1
−5deg:0

FIG. 32

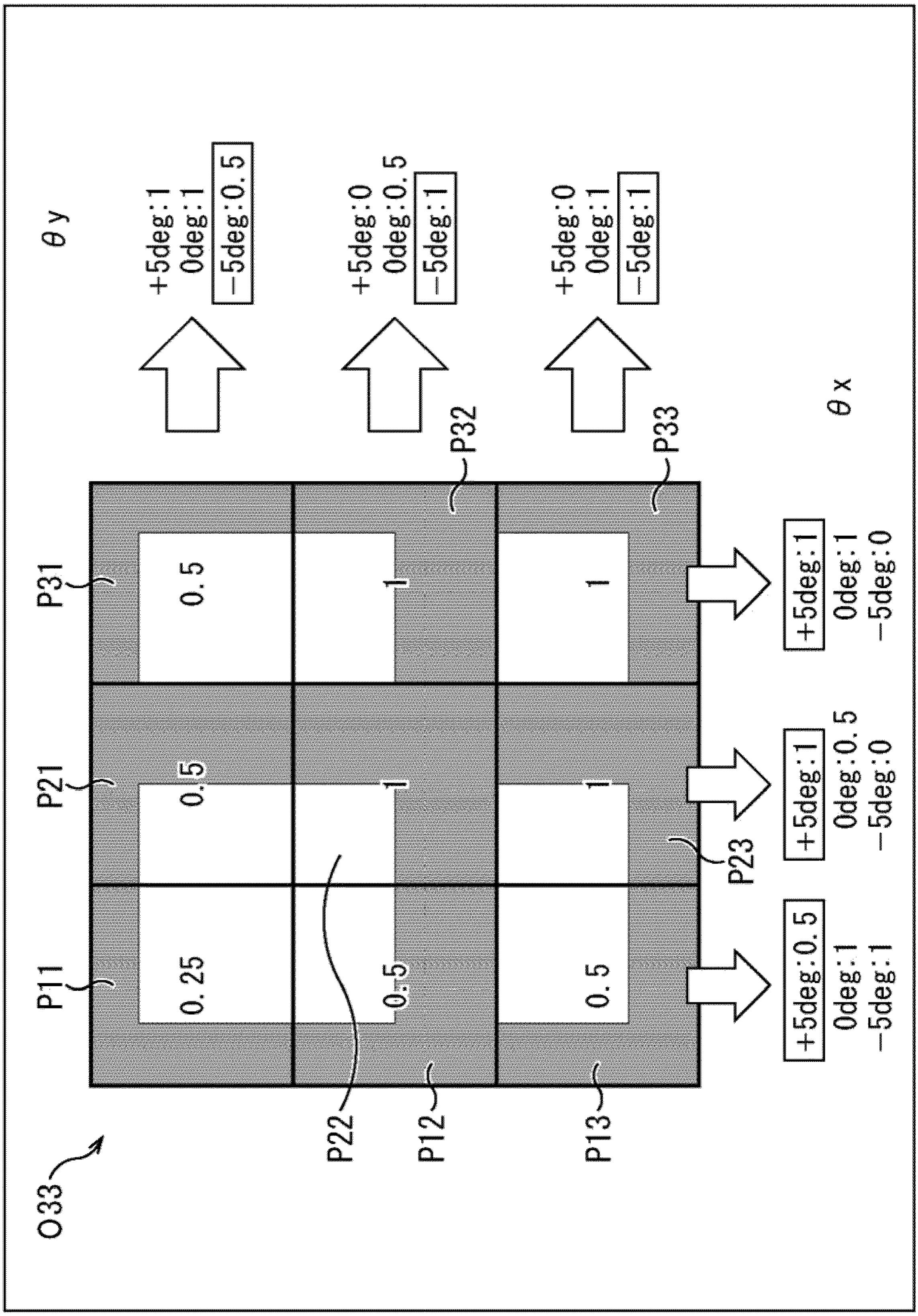
O33
P11
P21
P31
P22
P12
P13
P23
P32
P33
0.25
0.5
0.5
0.5
1
1
0.5
1
1
θy
+5deg:1
0deg:1
−5deg:0.5
+5deg:0
0deg:0.5
−5deg:1
+5deg:0
0deg:1
−5deg:1
θx
+5deg:0.5
0deg:1
−5deg:1
+5deg:1
0deg:0.5
−5deg:0
+5deg:1
0deg:1
−5deg:0

FIG. 33

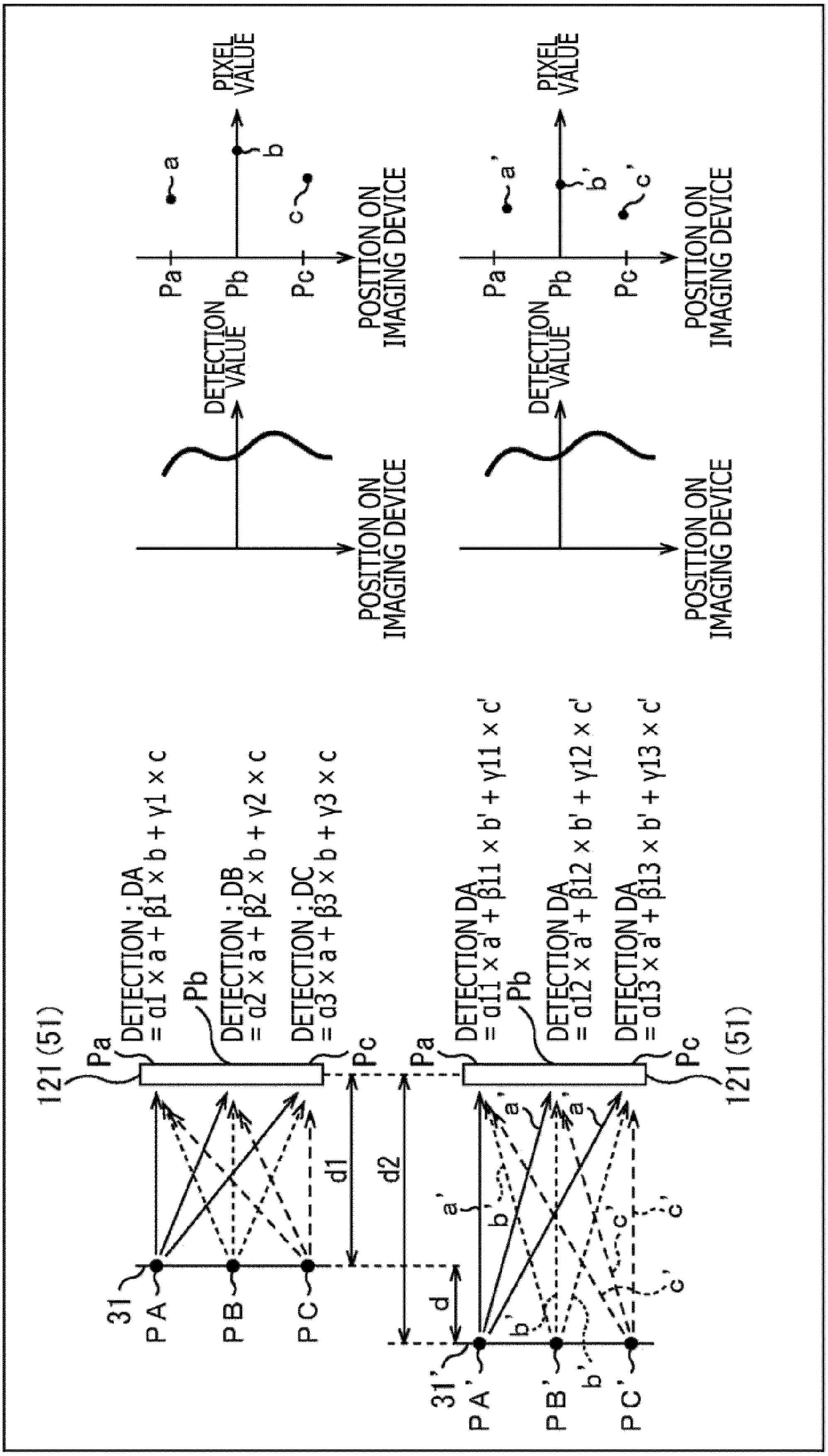
121 (51)
Pa
Pb
Pc
31
PA
PB
PC
d1
d2
d
DETECTION : DA
= α1 × a + β1 × b + γ1 × c
DETECTION : DB
= α2 × a + β2 × b + γ2 × c
DETECTION : DC
= α3 × a + β3 × b + γ3 × c
31'
PA'
PB'
PC'
a'
b'
c'
DETECTION DA
= α11 × a' + β11 × b' + γ11 × c'
DETECTION DA
= α12 × a' + β12 × b' + γ12 × c'
DETECTION DA
= α13 × a' + β13 × b' + γ13 × c'
DETECTION VALUE
POSITION ON IMAGING DEVICE
PIXEL VALUE
a
b
c

FIG.34

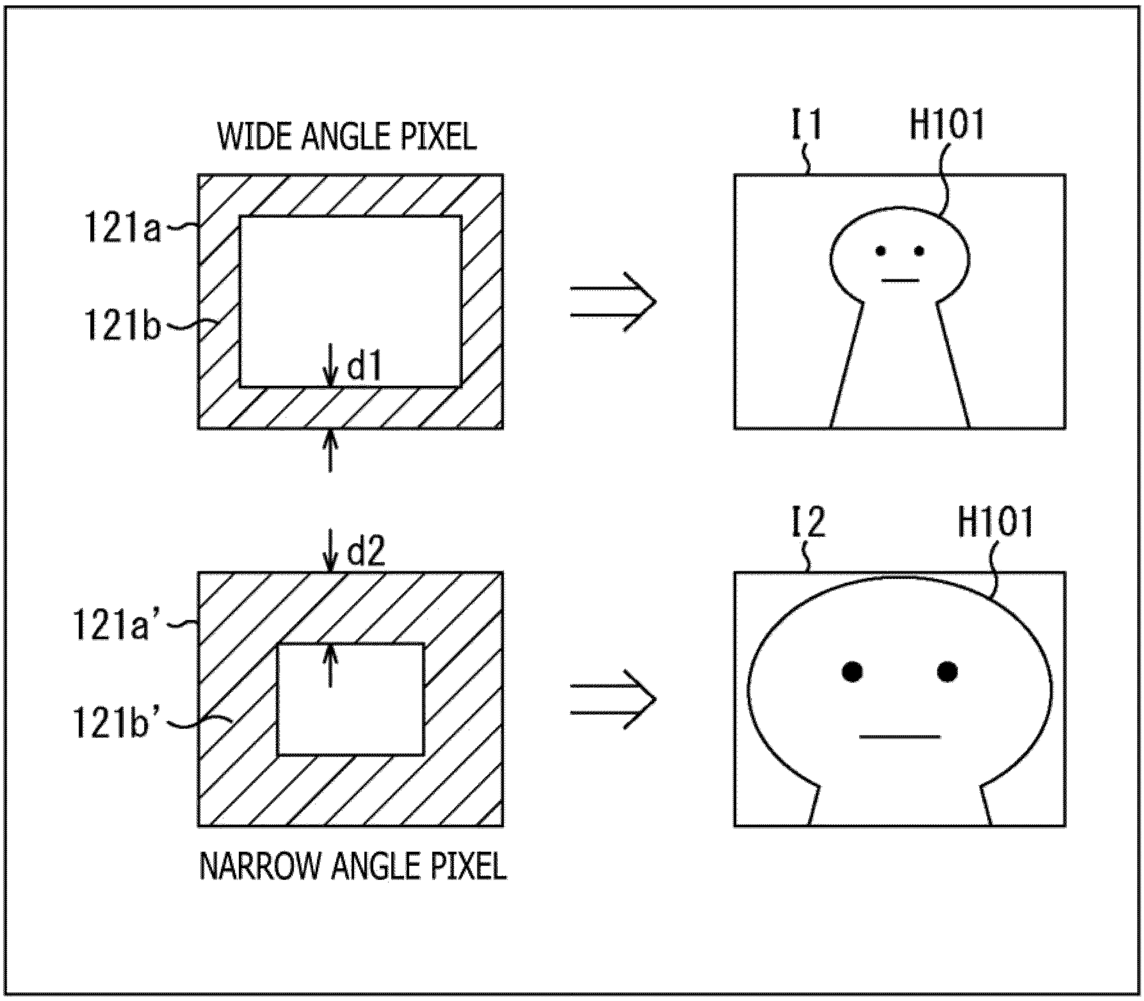
WIDE ANGLE PIXEL
121a
121b
d1
I1
H101
d2
121a'
121b'
NARROW ANGLE PIXEL
I2
H101

FIG.35

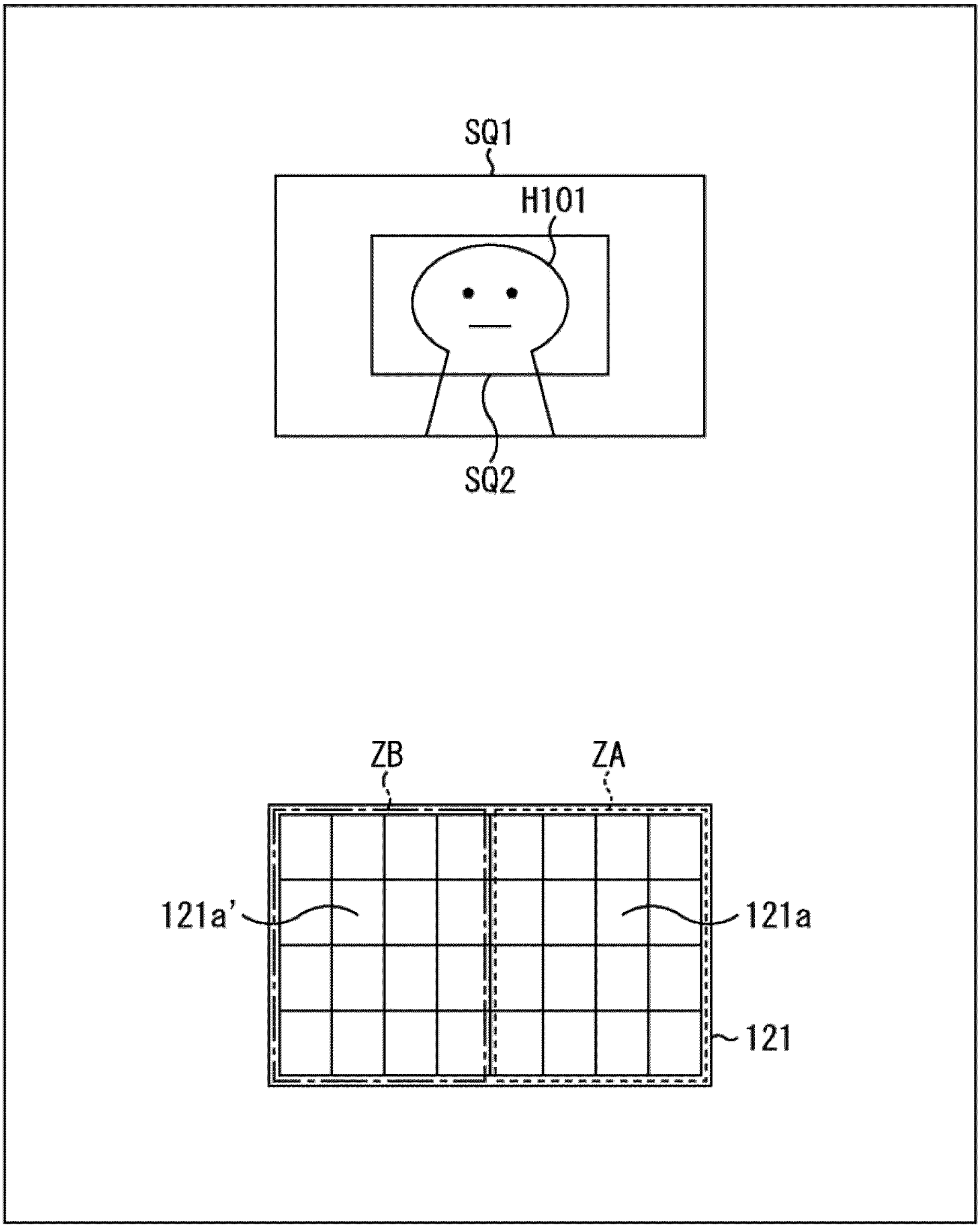

FIG. 36

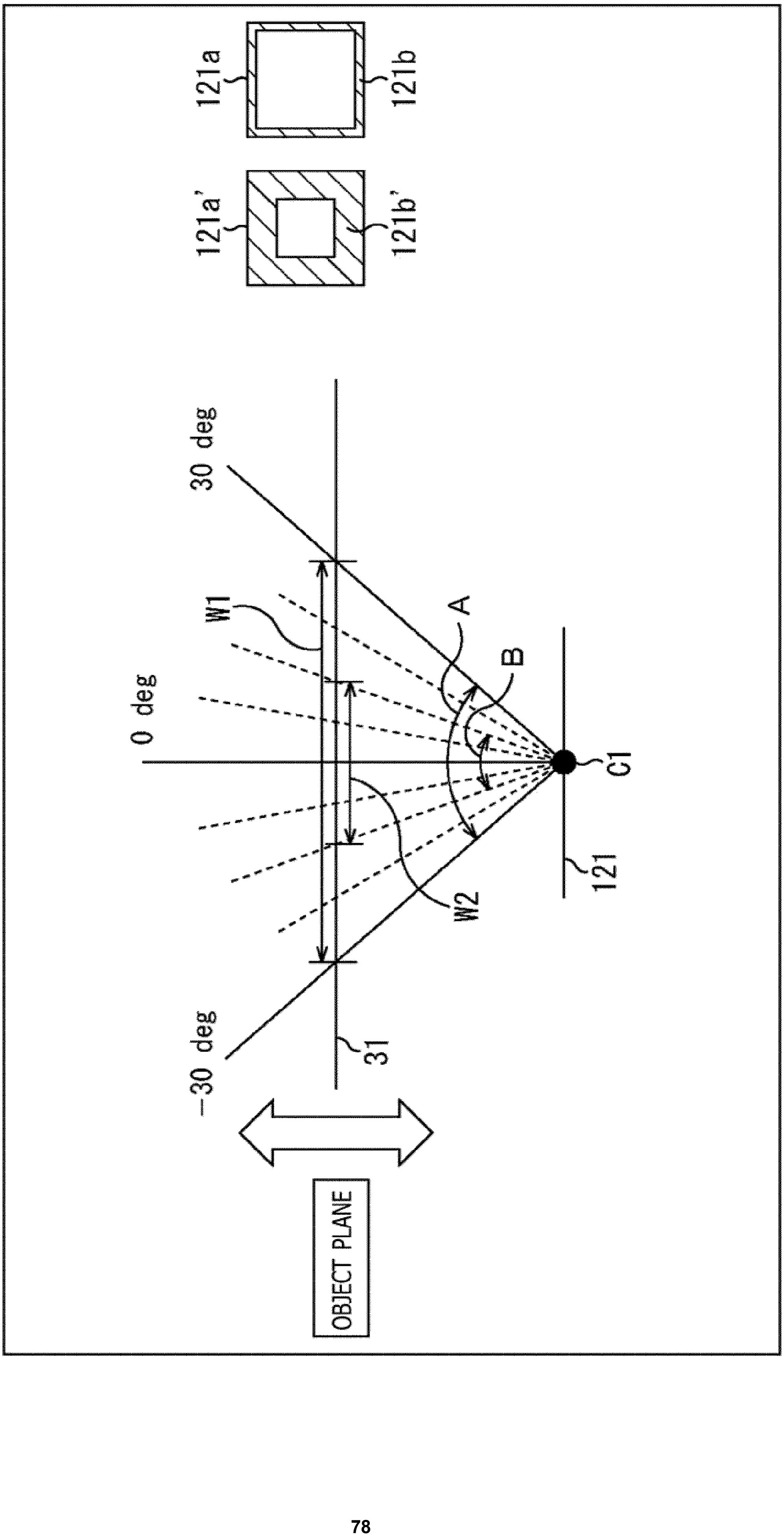
121a
121b
121a'
121b'
30 deg
0 deg
-30 deg
W1
W2
A
B
C1
121
31
OBJECT PLANE

FIG.37

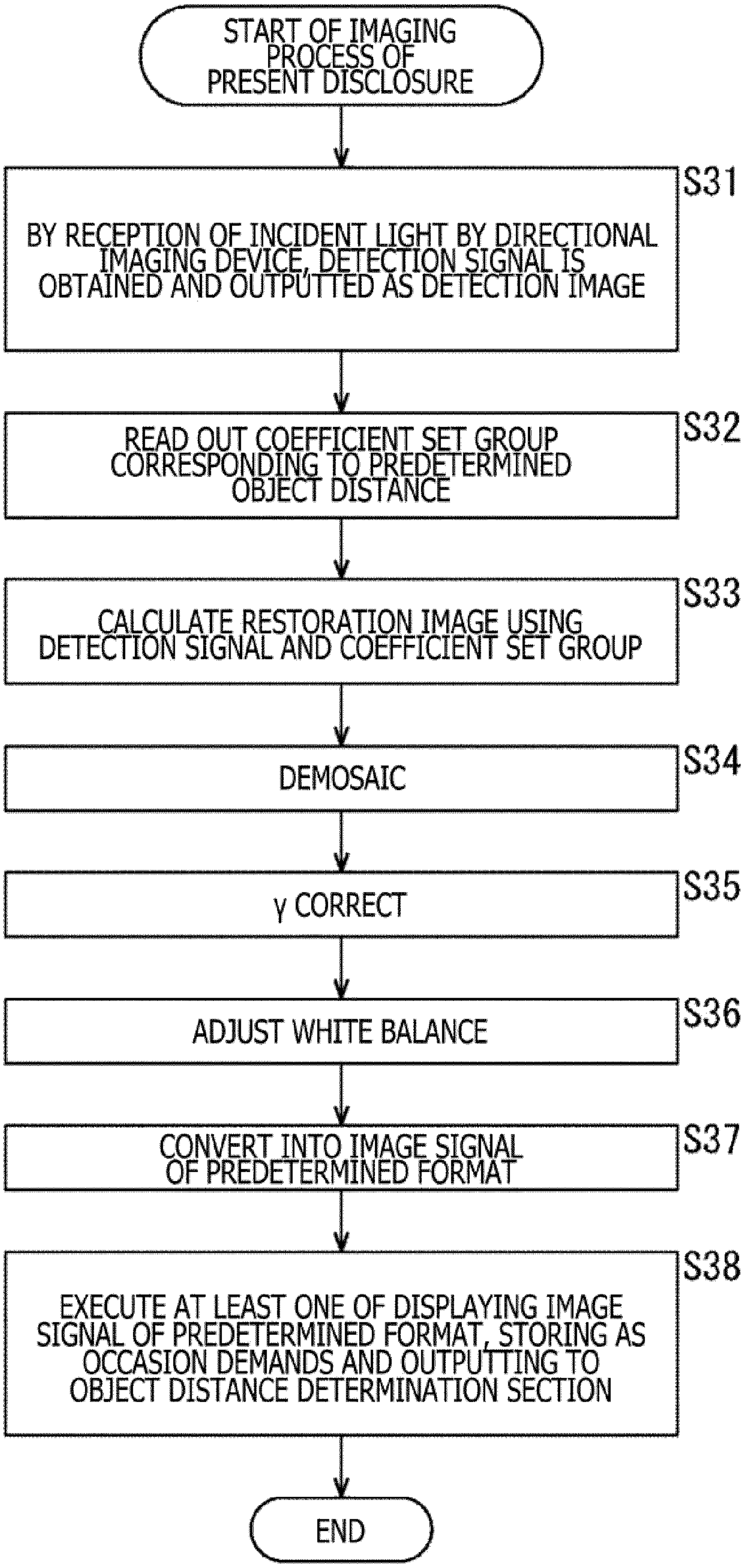
START OF IMAGING PROCESS OF PRESENT DISCLOSURE
S31
BY RECEPTION OF INCIDENT LIGHT BY DIRECTIONAL IMAGING DEVICE, DETECTION SIGNAL IS OBTAINED AND OUTPUTTED AS DETECTION IMAGE
S32
READ OUT COEFFICIENT SET GROUP CORRESPONDING TO PREDETERMINED OBJECT DISTANCE
S33
CALCULATE RESTORATION IMAGE USING DETECTION SIGNAL AND COEFFICIENT SET GROUP
S34
DEMOSAIC
S35
γ CORRECT
S36
ADJUST WHITE BALANCE
S37
CONVERT INTO IMAGE SIGNAL OF PREDETERMINED FORMAT
S38
EXECUTE AT LEAST ONE OF DISPLAYING IMAGE SIGNAL OF PREDETERMINED FORMAT, STORING AS OCCASION DEMANDS AND OUTPUTTING TO OBJECT DISTANCE DETERMINATION SECTION
END

FIG.38

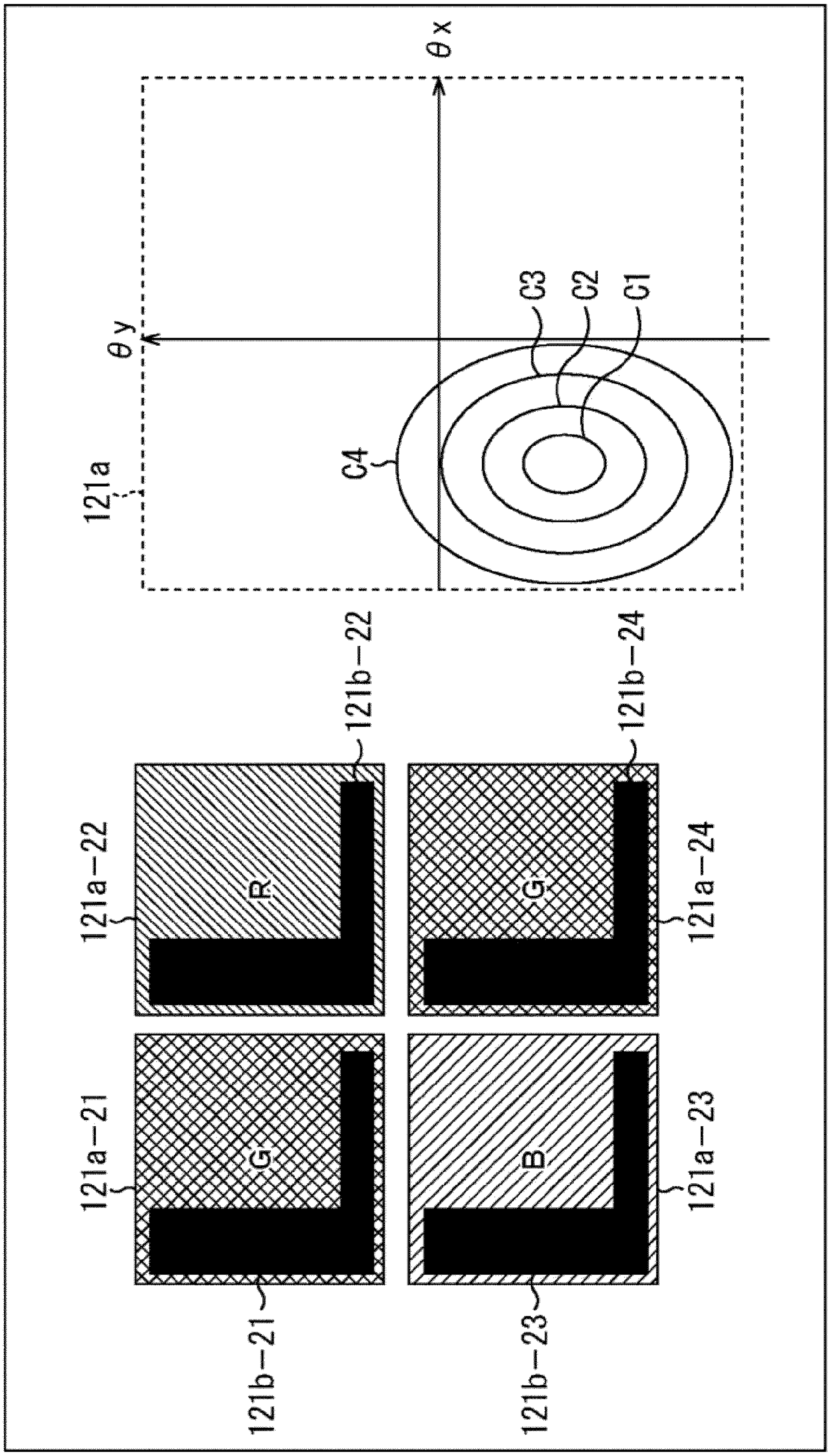
121a
θy
θx
C1
C2
C3
C4
121a−21
121a−22
121a−23
121a−24
121b−21
121b−22
121b−23
121b−24
G
R
B
G

FIG. 39

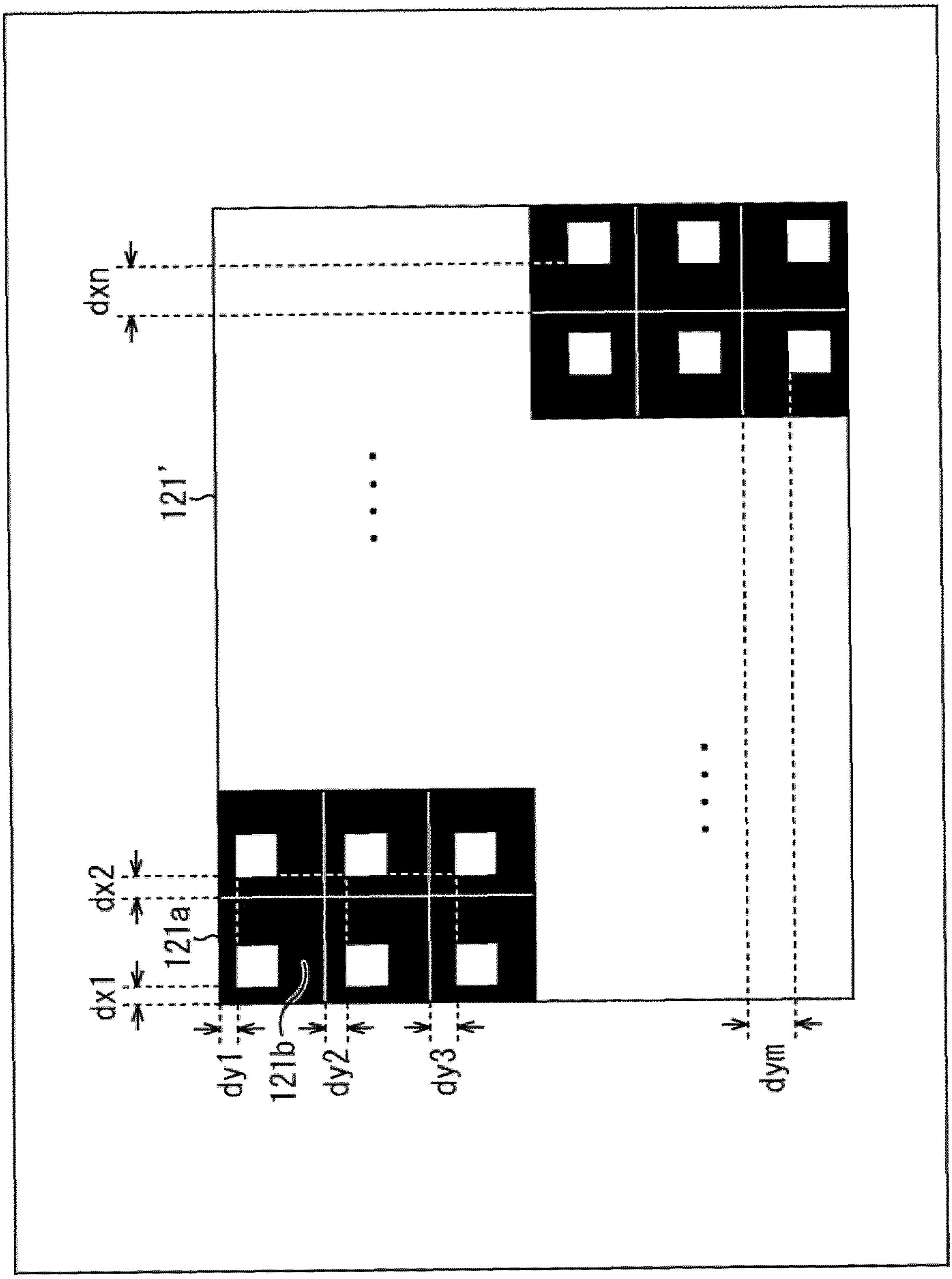

FIG. 40

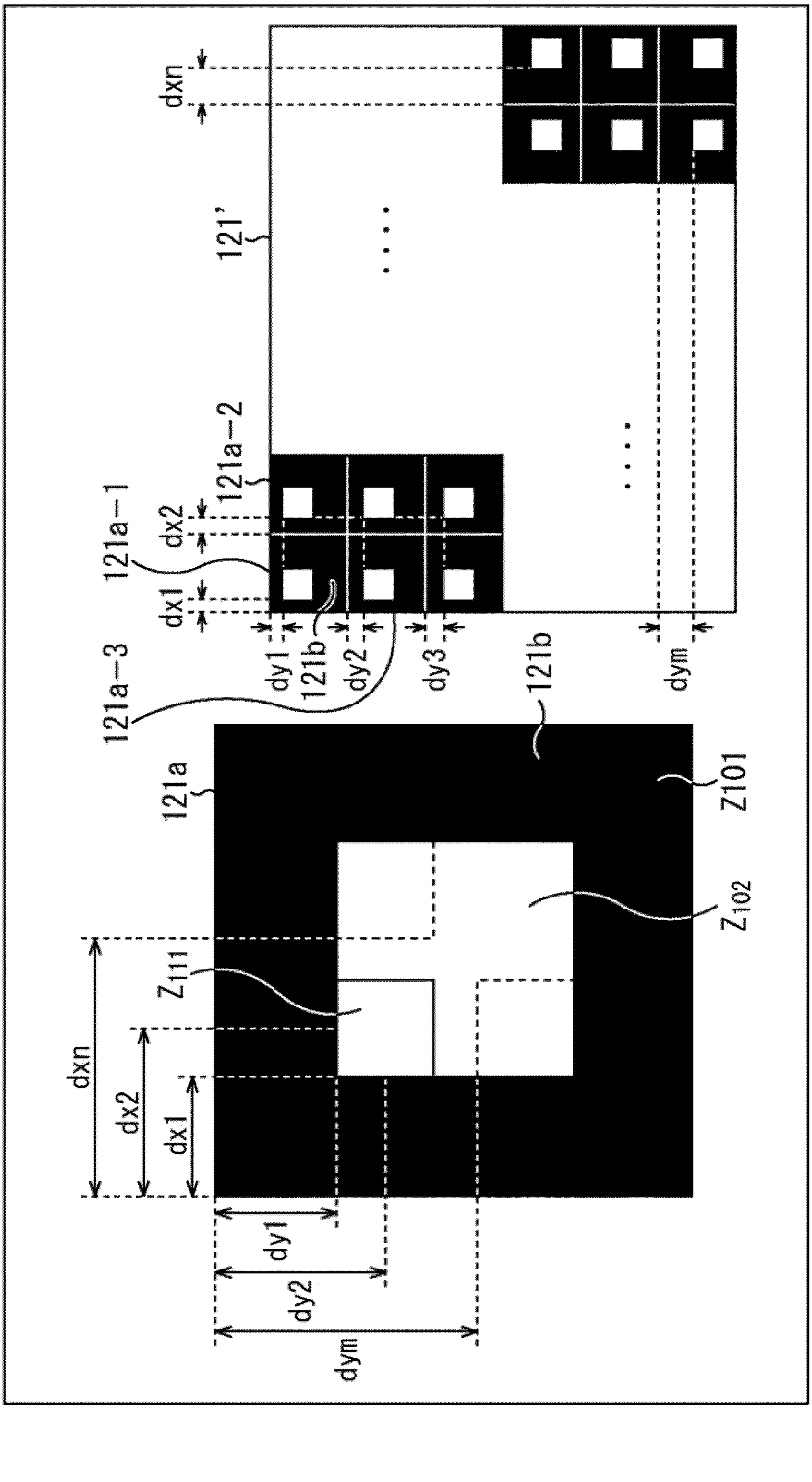
121'
121a-1
121a-2
121a-3
121b
dx1
dx2
dxn
dy1
dy2
dy3
dym
121a
Z101
$Z_{102}$
$Z_{111}$

FIG. 41

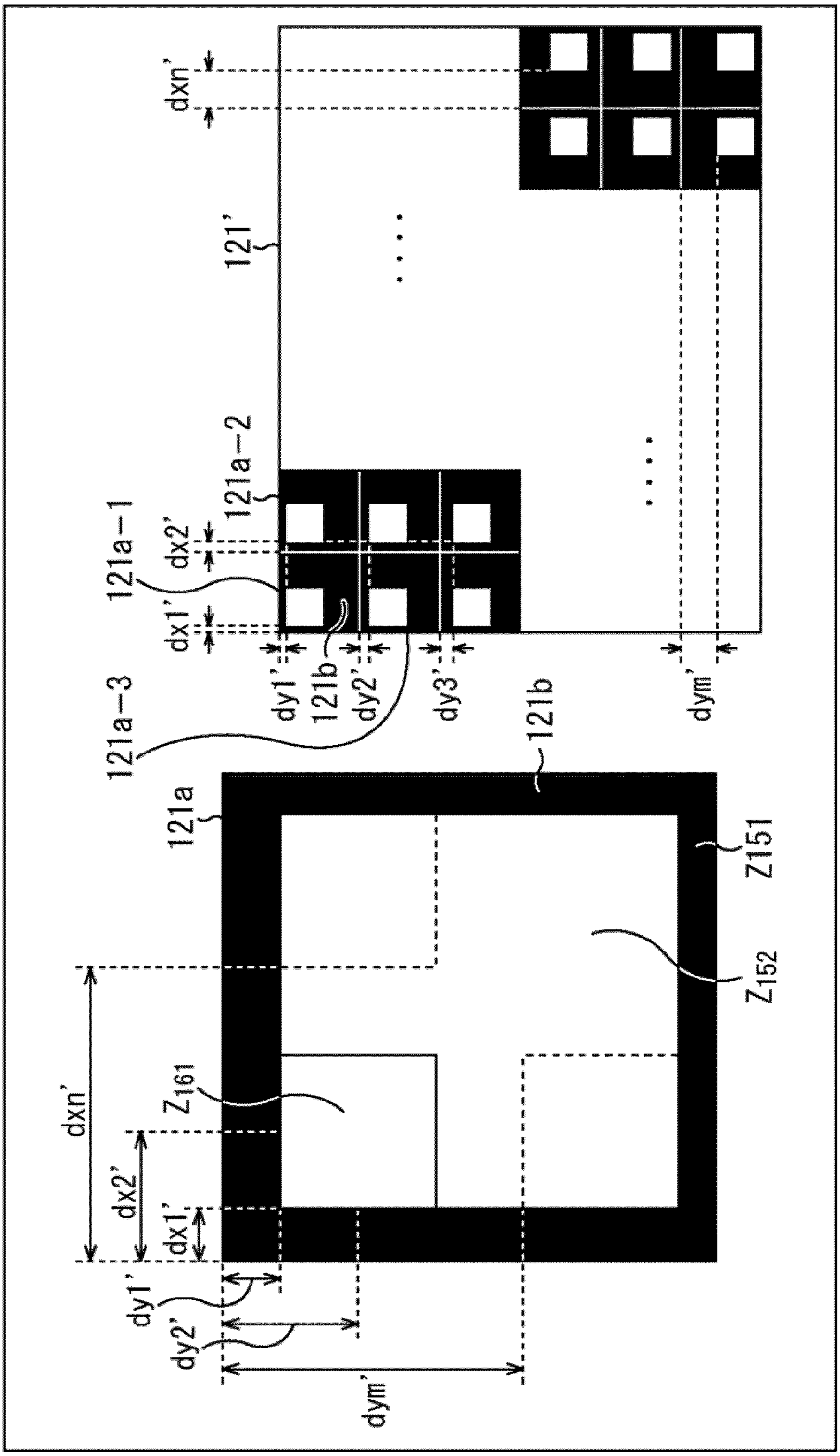
dxn'
121'
121a−2
121a−1
dx2'
dx1'
dy1'
121b
dy2'
dy3'
dym'
121a−3
121b
121a
Z151
Z152
Z161
dxn'
dx2'
dx1'
dy1'
dy2'
dym'

FIG.42

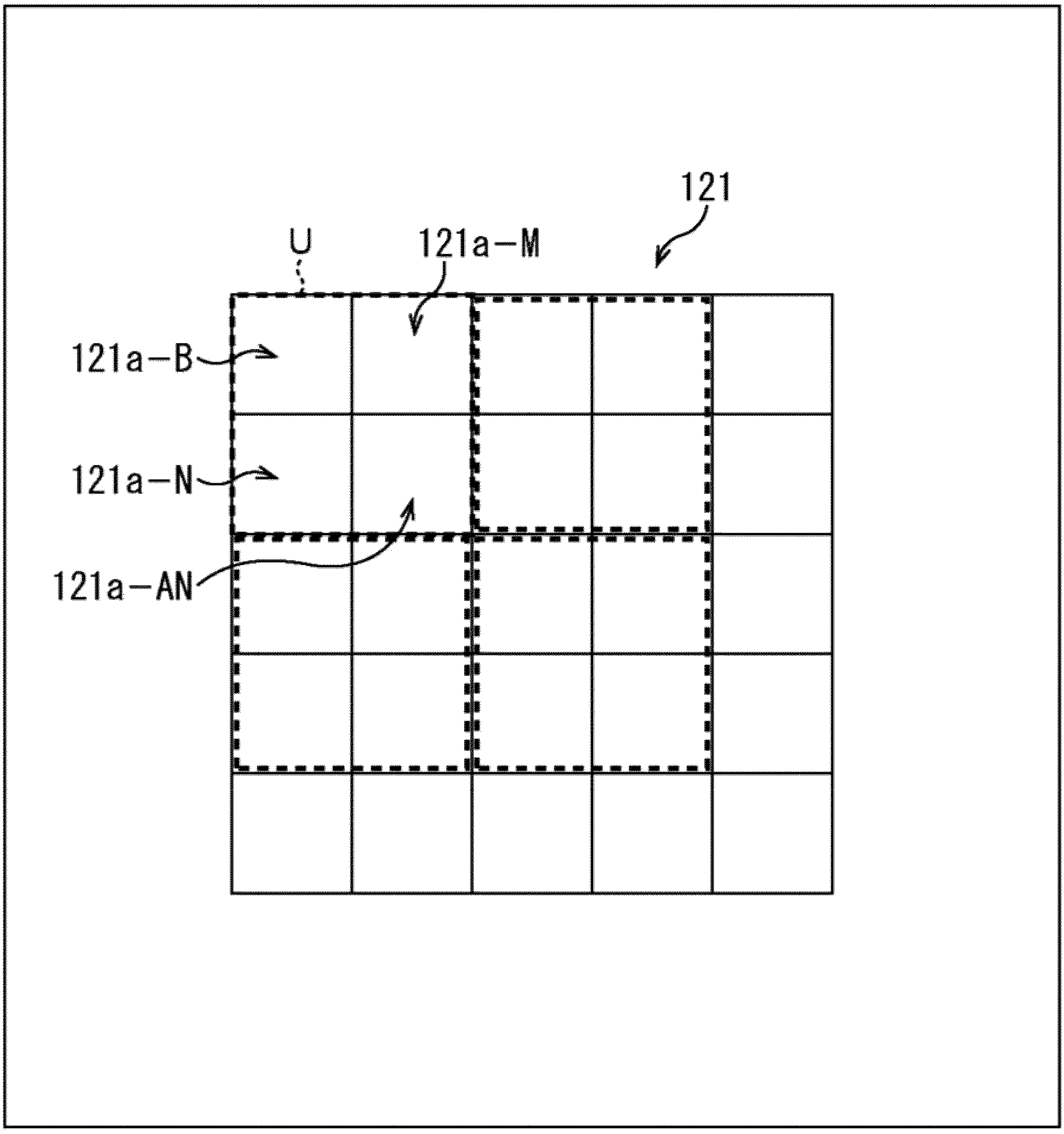

FIG. 43

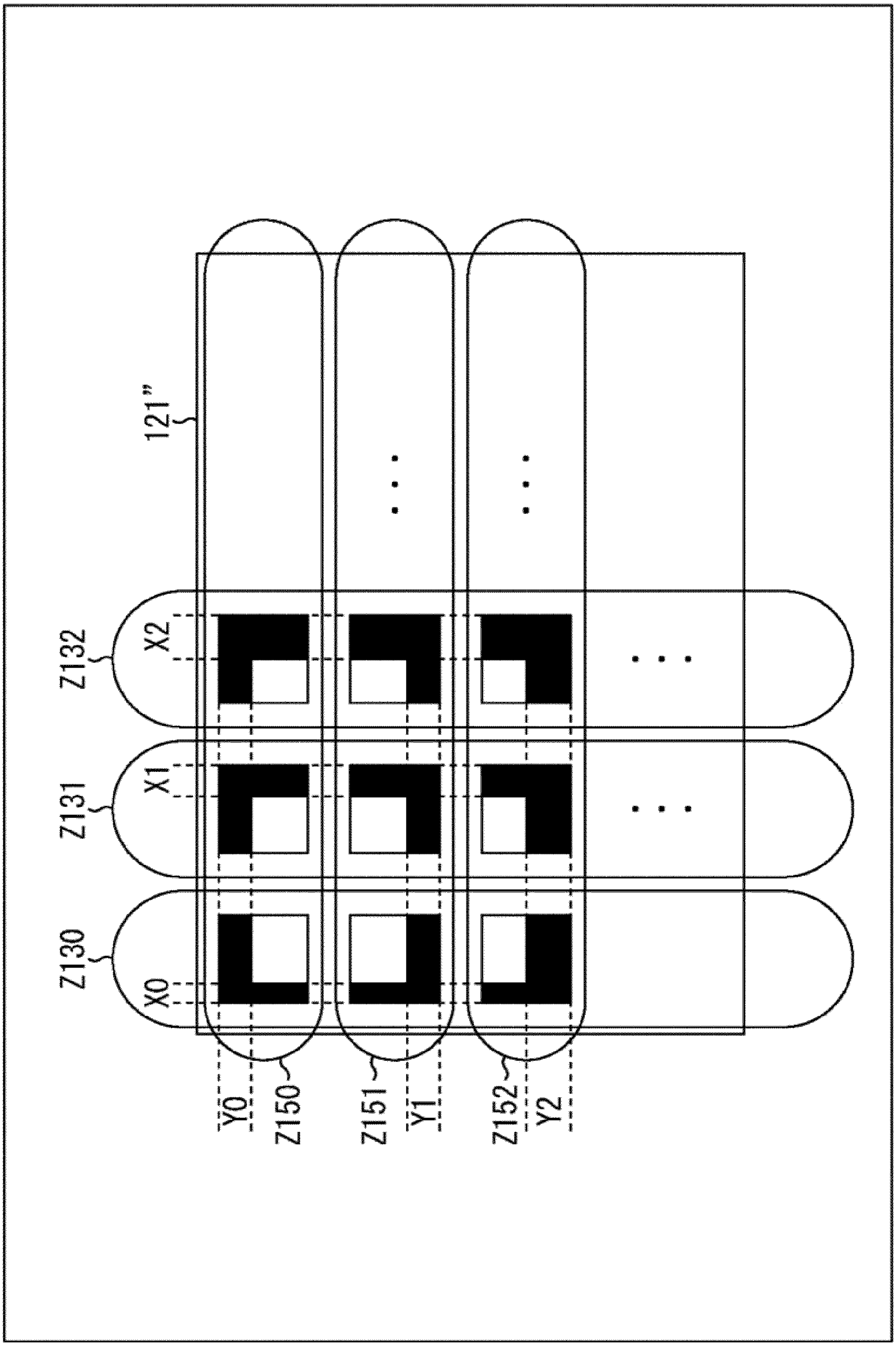

FIG. 44

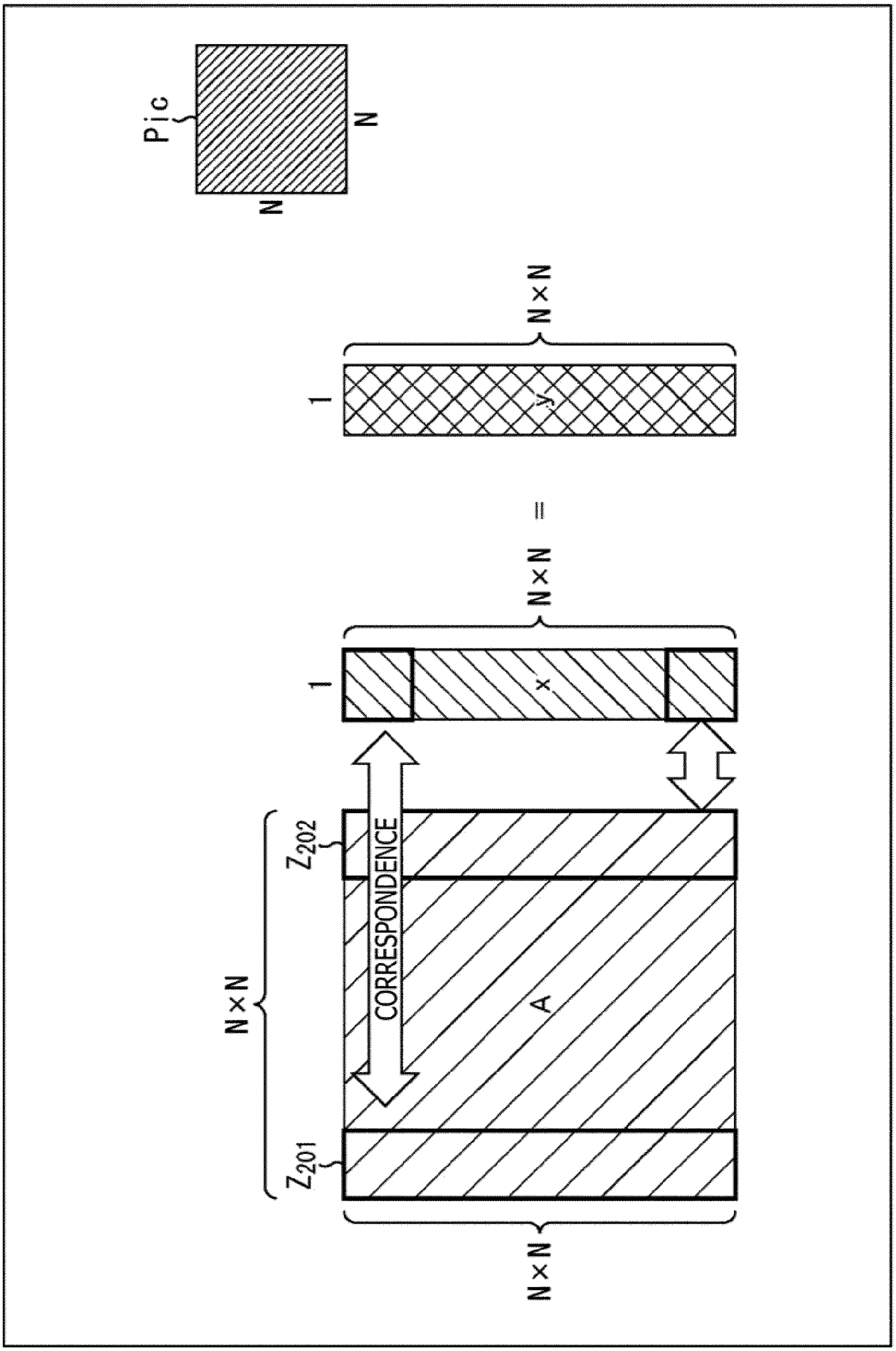

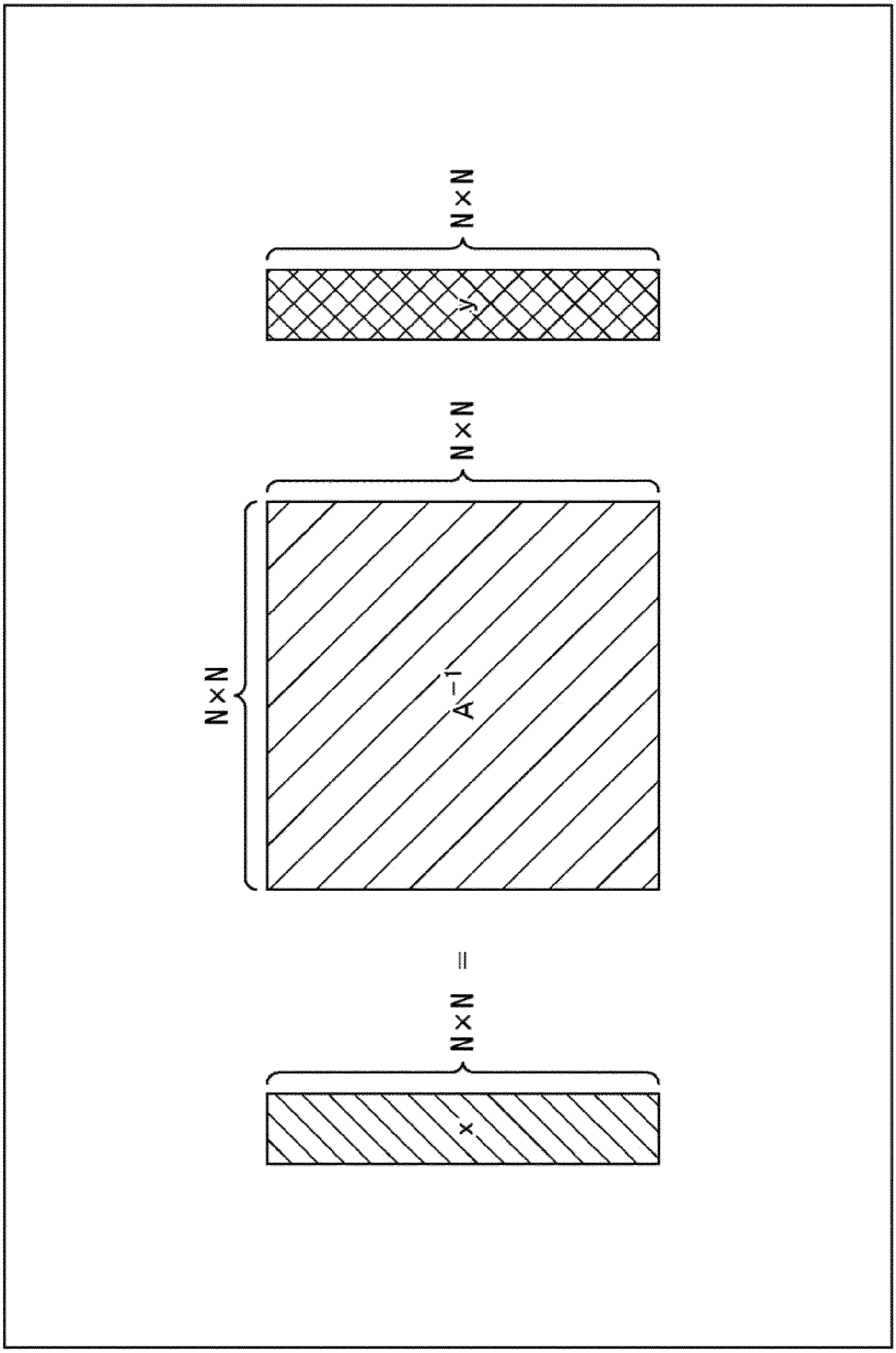


FIG. 45

FIG. 46

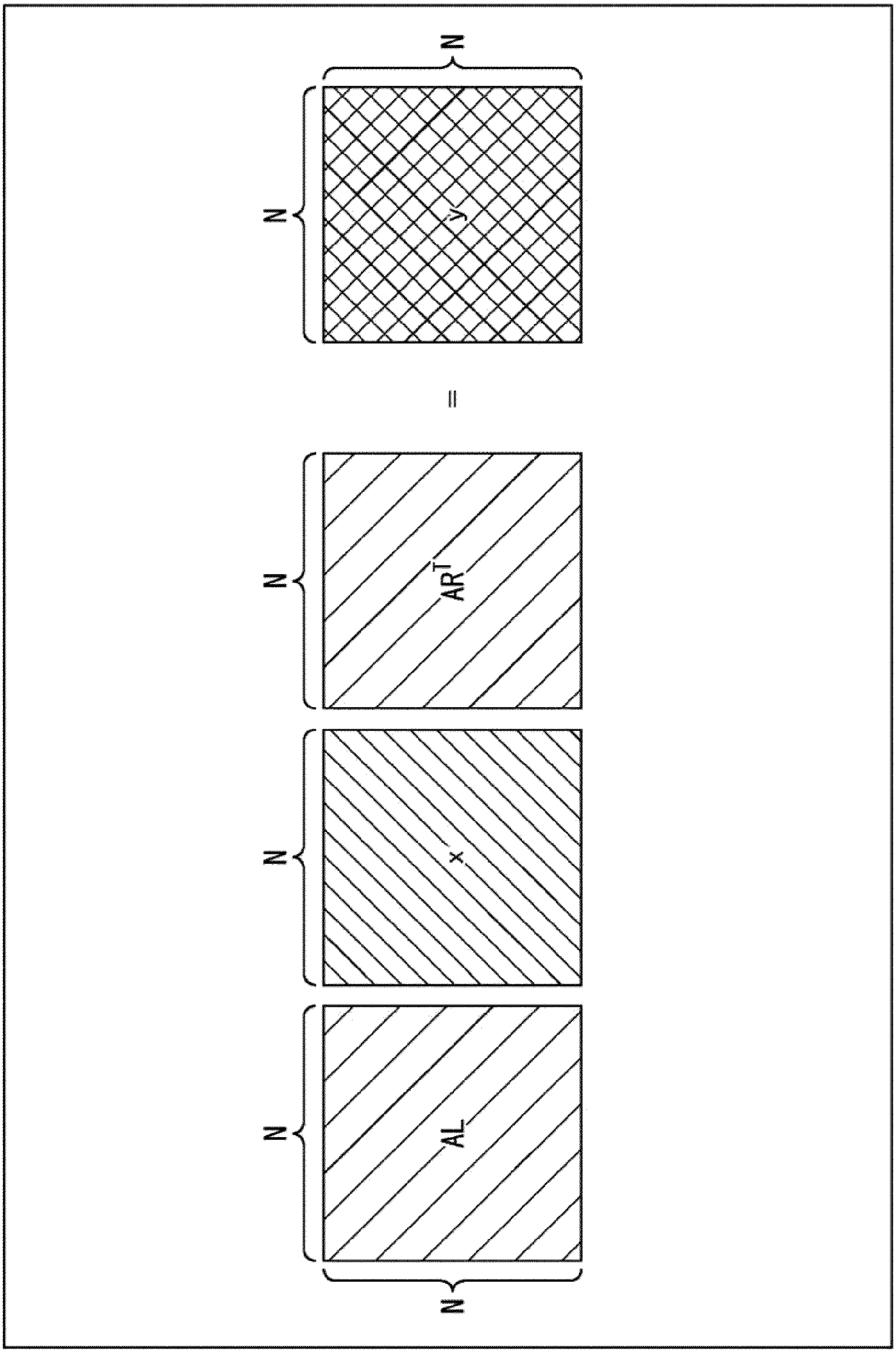

FIG. 47

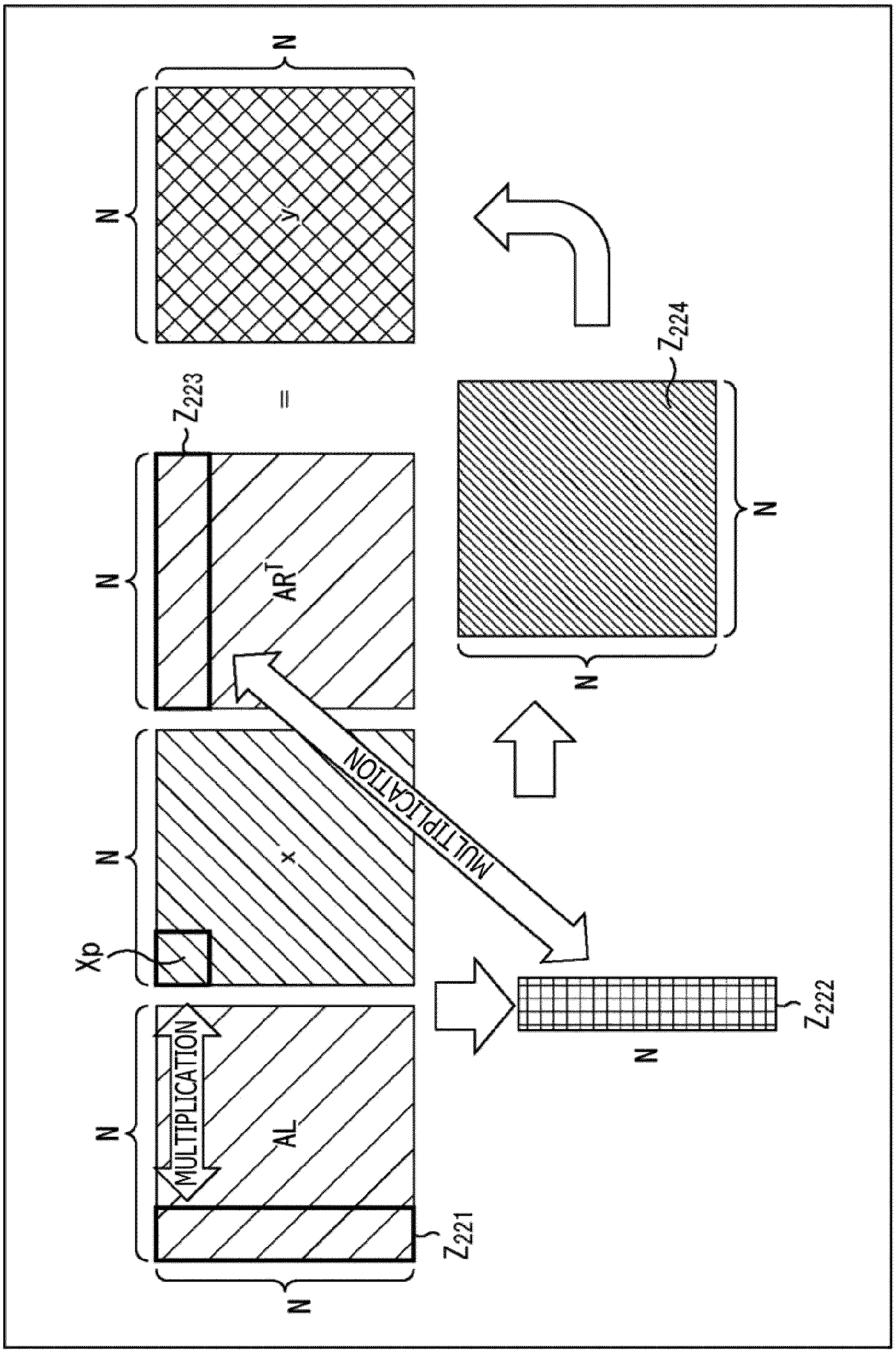
N
N
AL
MULTIPLICATION
Z221
N
Xp
x
N
AR^T
Z223
=
N
N
y
MULTIPLICATION
N
Z222
N
N
Z224

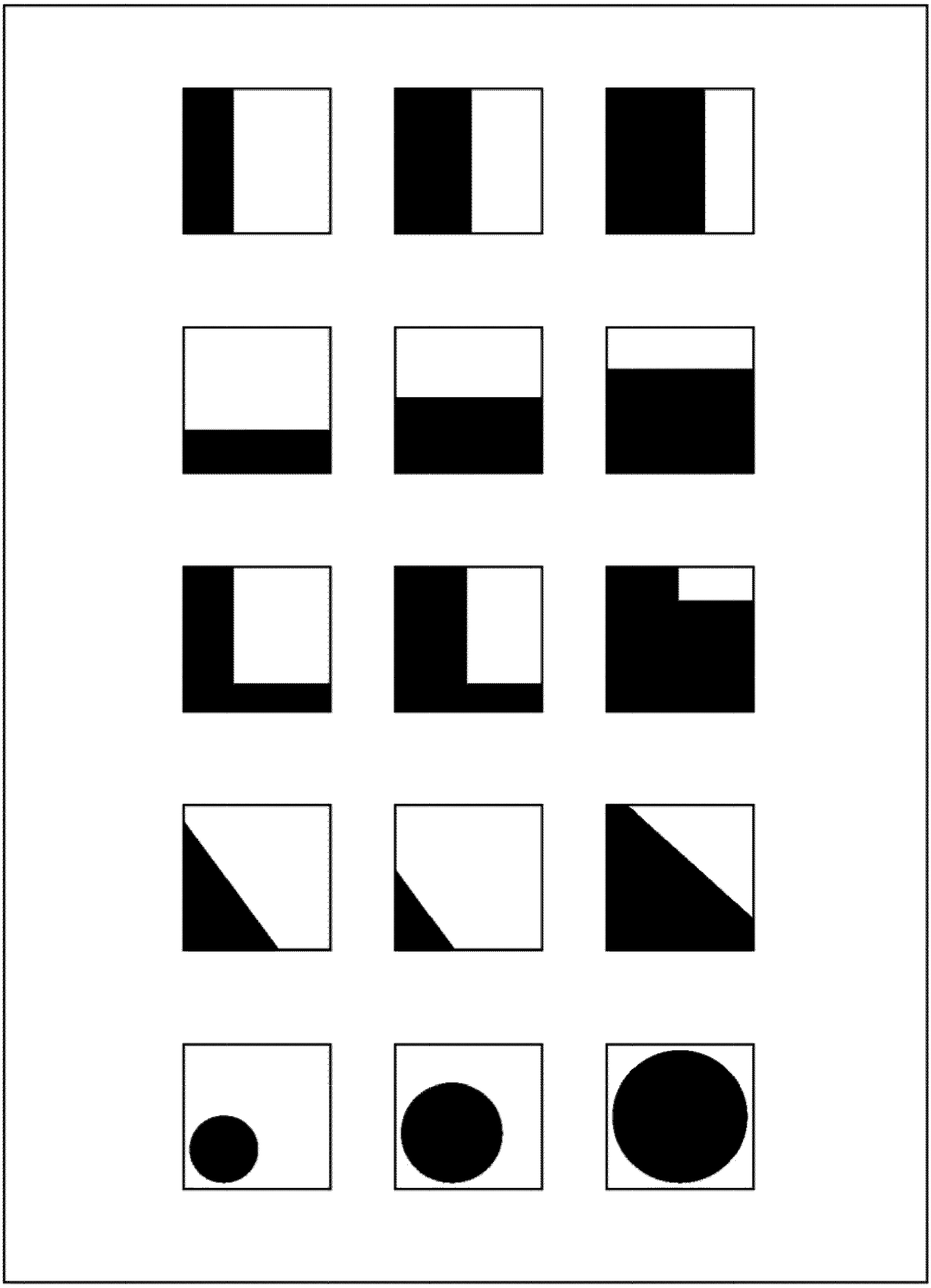

FIG.48

FIG. 49

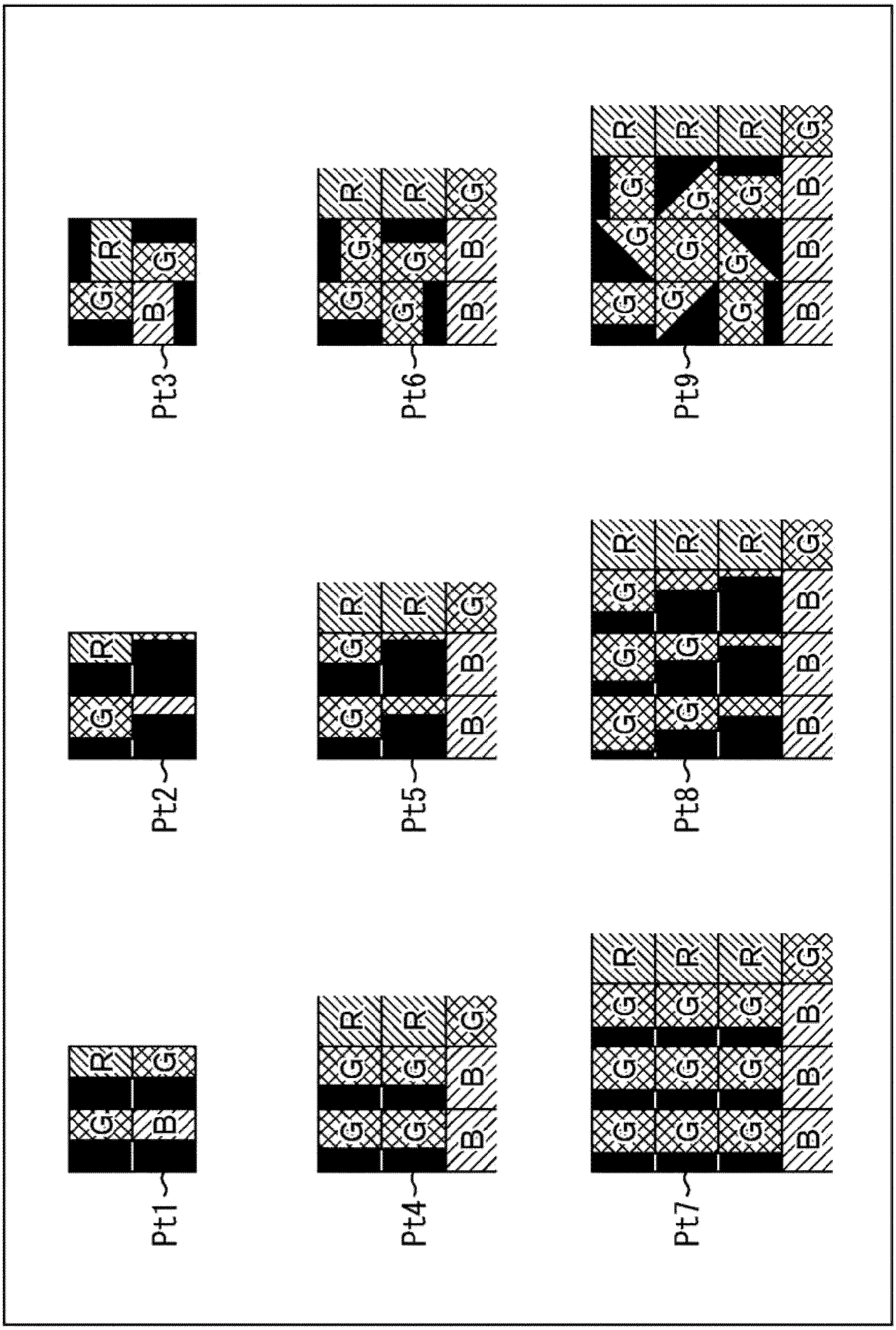

FIG. 50

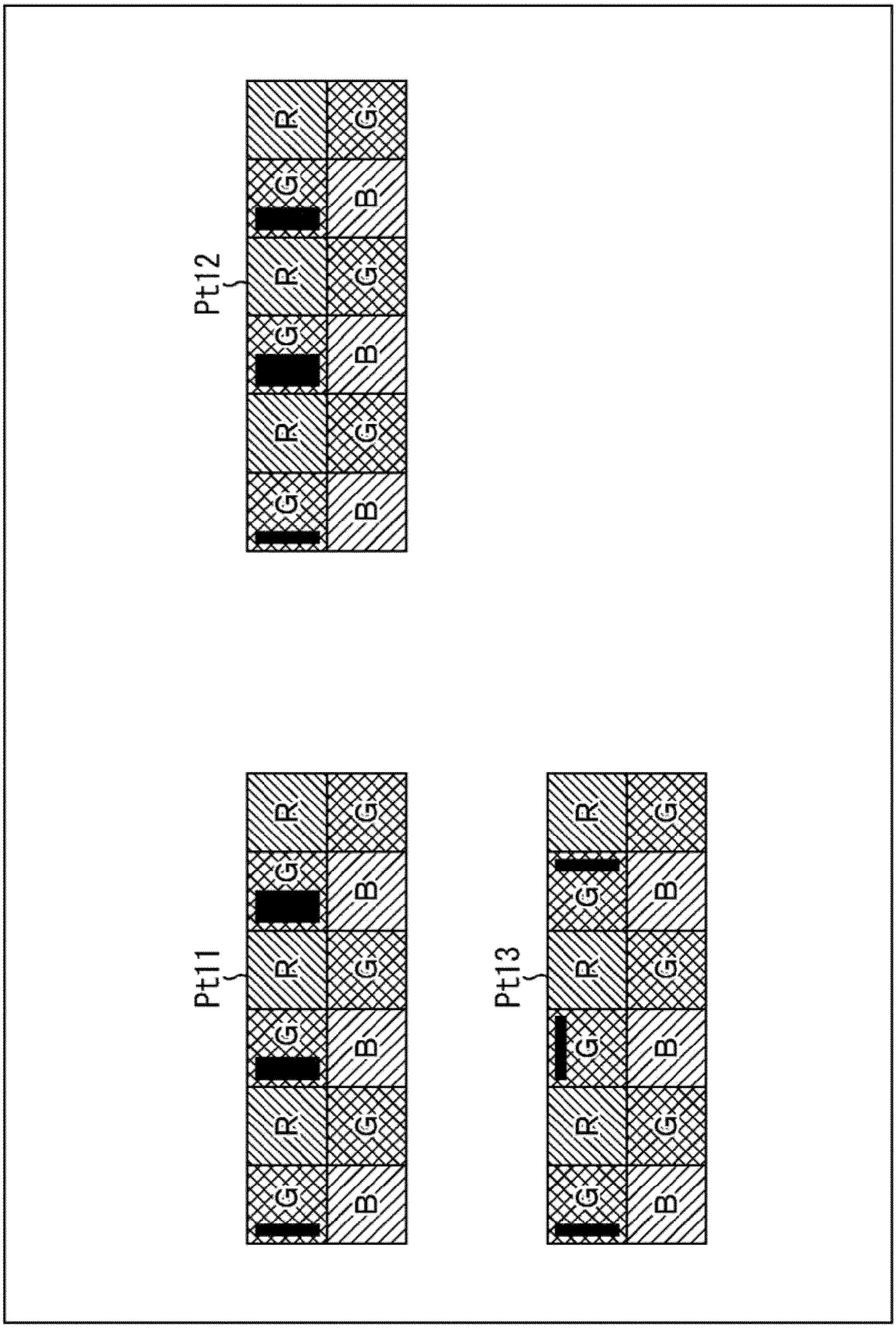

FIG.51

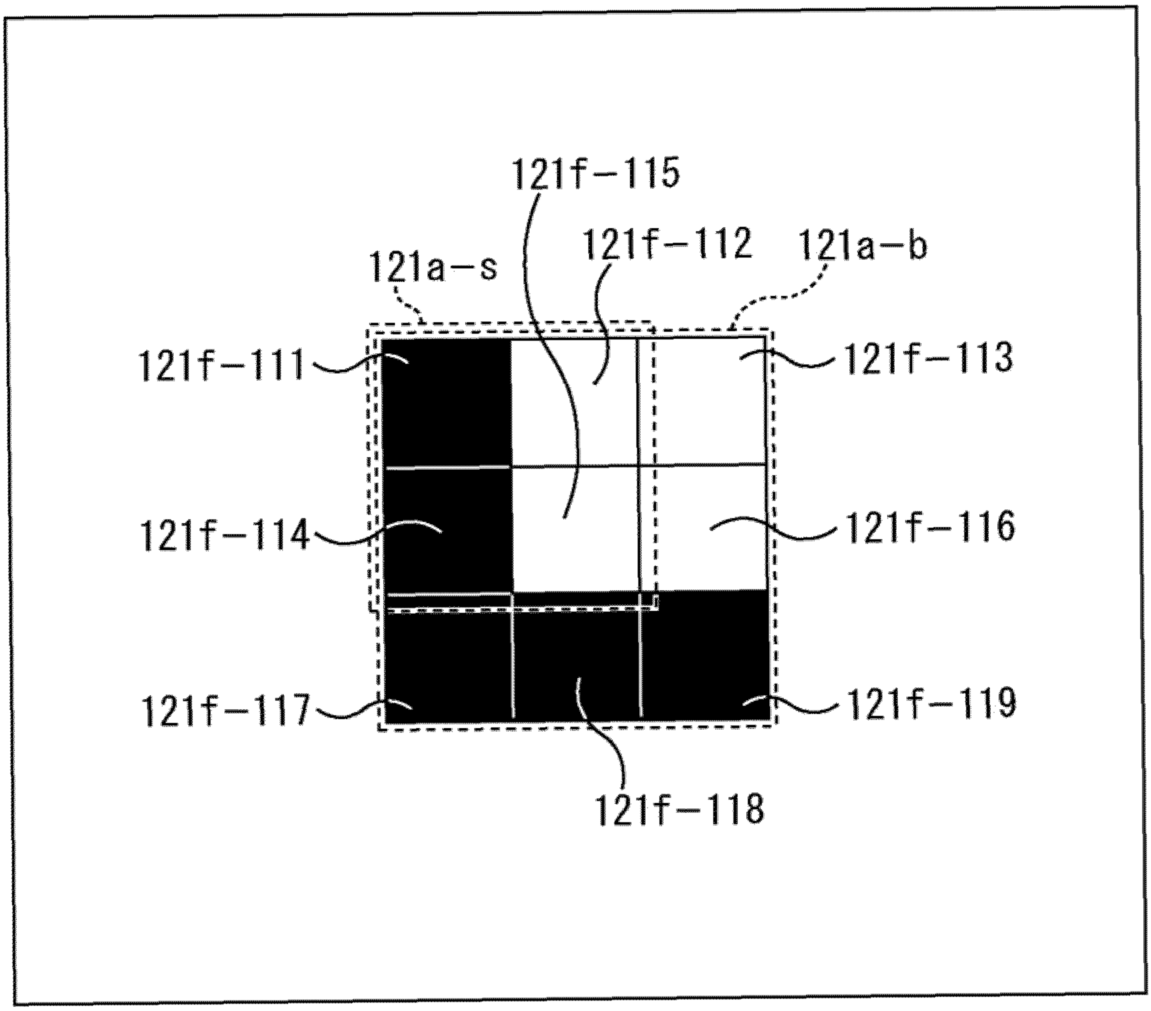
121f-115
121a-s
121f-112
121a-b
121f-111
121f-113
121f-114
121f-116
121f-117
121f-119
121f-118

FIG.52

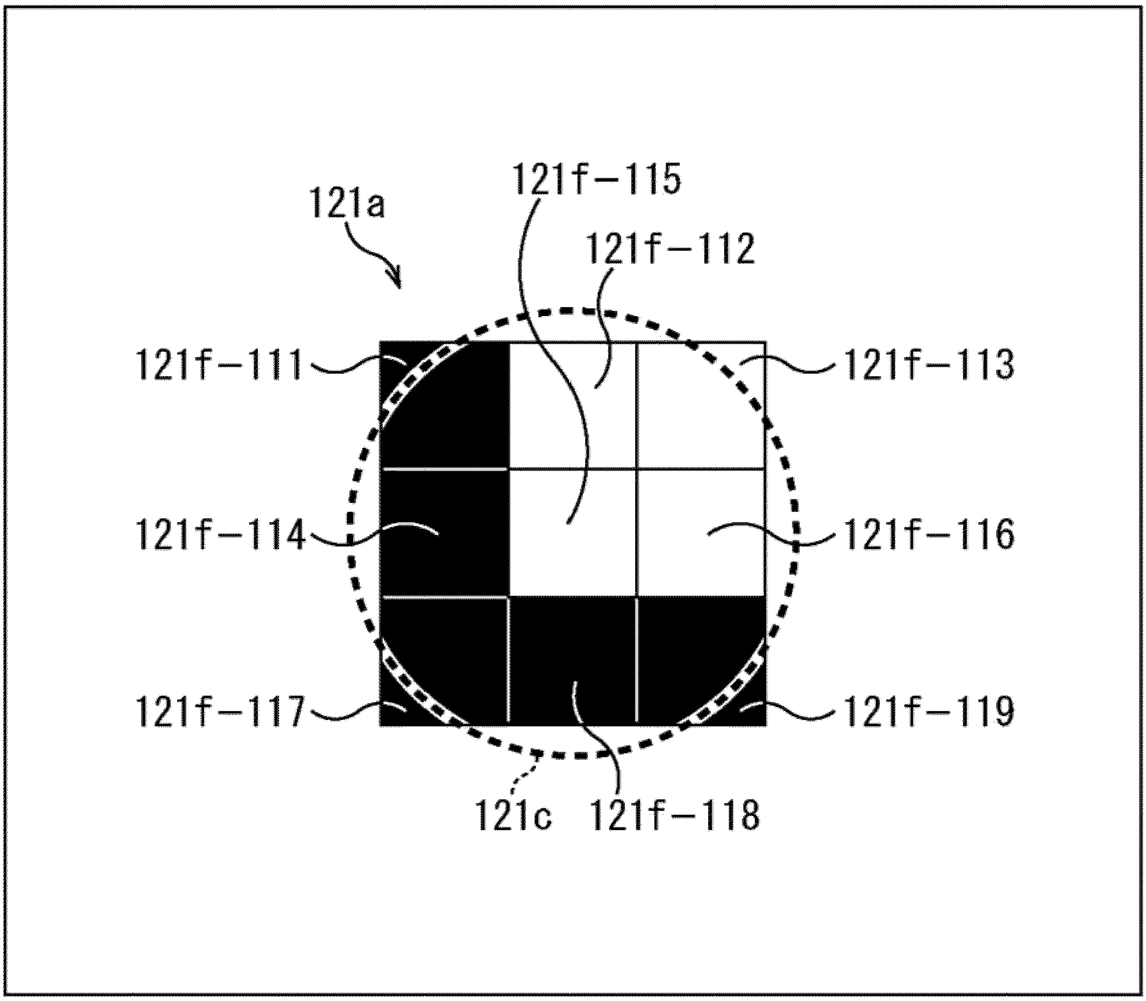
121a
121f-115
121f-112
121f-111
121f-113
121f-114
121f-116
121f-117
121f-119
121c
121f-118

FIG. 53

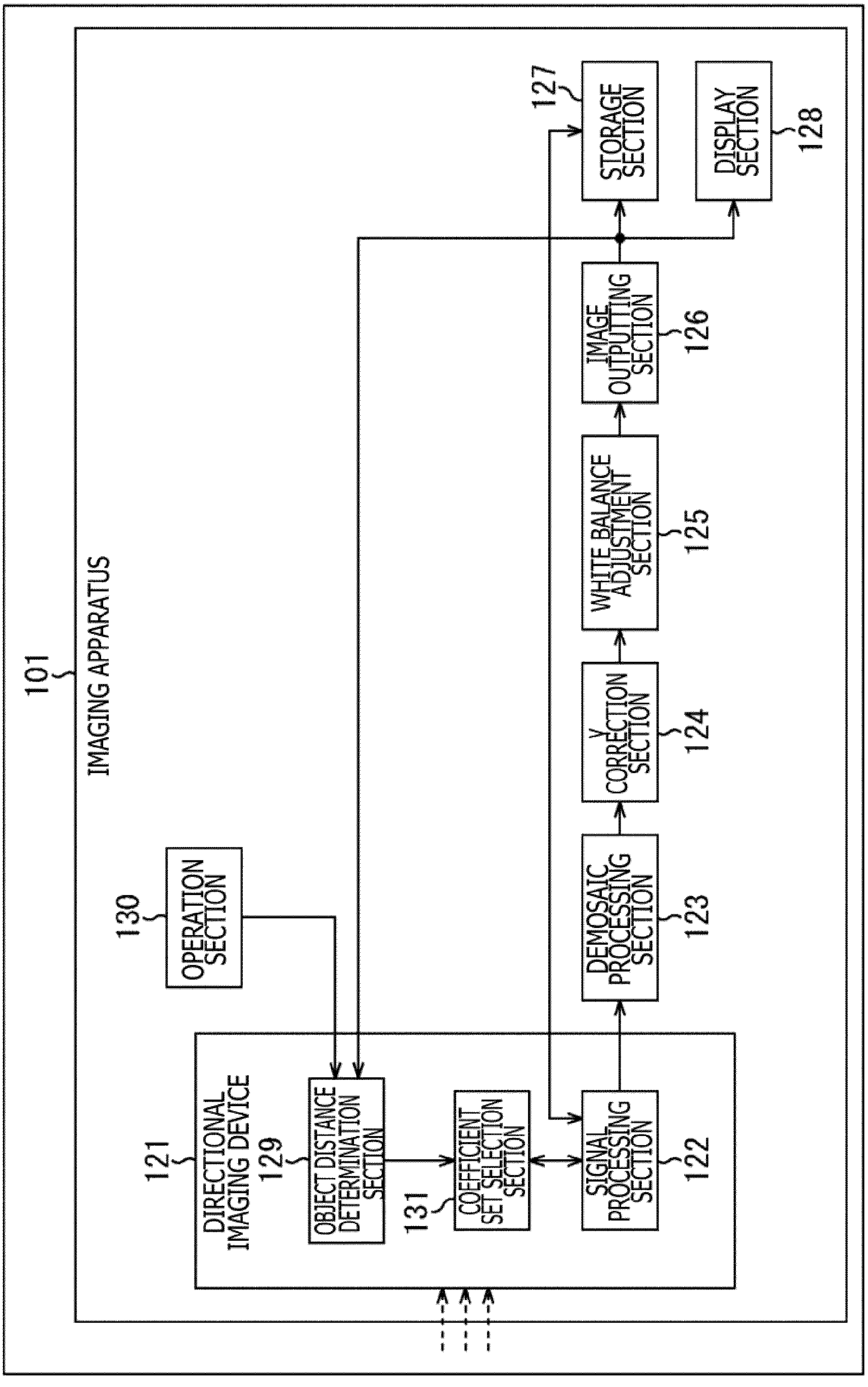
101
IMAGING APPARATUS
121
DIRECTIONAL IMAGING DEVICE
129
OBJECT DISTANCE DETERMINATION SECTION
131
COEFFICIENT SET SELECTION SECTION
SIGNAL PROCESSING SECTION
122
130
OPERATION SECTION
DEMOSAIC PROCESSING SECTION
123
γ CORRECTION SECTION
124
WHITE BALANCE ADJUSTMENT SECTION
125
IMAGE OUTPUTTING SECTION
126
127
STORAGE SECTION
DISPLAY SECTION
128

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 2016123529 A

### Non-patent literature cited in the description


- **M. SALMON ASIF ; ALI AYREMLOUY ; ASWIN SANKARANARAYANAN ; ASHOK VEERARAGHAVAN ; RICHARD BARANIUK.** FlatCam: Replacing Lenses with Masks and Computation. ECE Department, Rice University, Houston, TX ECE Department, Carnegie Mellon University